(19) Europäisches Patentamt
European Patent Office
Office européen des brevets

(11) EP 3 949 017 B1

(12) **EUROPÄISCHE PATENTSCHRIFT**

(45) Veröffentlichungstag und Bekanntmachung des Hinweises auf die Patenterteilung:
**07.06.2023 Patentblatt 2023/23**

(21) Anmeldenummer: **19748730.9**

(22) Anmeldetag: **11.07.2019**

(51) Internationale Patentklassifikation (IPC):
***H01Q 7/00*** *(2006.01)*

(52) Gemeinsame Patentklassifikation (CPC):
**H01Q 7/005**

(86) Internationale Anmeldenummer:
**PCT/EP2019/068744**

(87) Internationale Veröffentlichungsnummer:
**WO 2020/192947 (01.10.2020 Gazette 2020/40)**

(54) **ABSTIMMUNG EINER MAGNETISCHEN ANTENNE**

TUNING A MAGNETIC ANTENNA

ACCORD D'UNE ANTENNE MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.03.2019 DE 102019204163**

(43) Veröffentlichungstag der Anmeldung:
**09.02.2022 Patentblatt 2022/06**

(73) Patentinhaber: **Fraunhofer-Gesellschaft zur Förderung der angewandten Forschung e.V.
80686 München (DE)**

(72) Erfinder:
- **KILIAN, Gerd
91058 Erlangen (DE)**
- **BERNHARD, Josef
91058 Erlangen (DE)**
- **OPPELT, Ralph
91058 Erlangen (DE)**
- **ULBRICHT, Gerald
91058 Erlangen (DE)**

(74) Vertreter: **Schlenker, Julian et al
Schoppe, Zimmermann, Stöckeler
Zinkler, Schenk & Partner mbB
Patentanwälte
Radlkoferstraße 2
81373 München (DE)**

(56) Entgegenhaltungen:
**WO-A1-91/15878 DE-A1- 4 327 917
US-A- 5 225 847 US-A1- 2013 016 018**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 949 017 B1

## Beschreibung

Ausführungsbeispiele der vorliegenden Erfindung beziehen sich auf eine Abstimmung einer magnetischen Antenne, und im speziellen, auf ein Abstimmelement zur Abstimmung der magnetischen Antenne. Weitere Ausführungsbeispiele beziehen sich auf einen Teilnehmer eines Kommunikationssystems mit der magnetischen Antenne mit dem Abstimmelement.

Herkömmlicherweise werden, vor allem im Bereich der Sensorknoten, elektrische Antennen bzw. elektrisch kurze Antennen eingesetzt. Wird z.B. bei 868 MHz eine heute übliche elektrische Antenne verwendet, wird als ½ Lambda Strahler eine Länge von etwa 15 cm benötigt. Werden kürzere Antennen eingesetzt, sinkt der Gewinn der Antenne. Weiterhin wird die Handhabbarkeit der Geräte mit Antennen eingeschränkt, da die verwendeten Antennen sich bei Annäherung an elektrisch leitende oder dielektrisch wirkende Gegenstände verstimmen und somit ihr Gewinn weiter sinkt. Damit gibt es Anforderungen an die Umgebung von z.B. Sensorknoten. Mit elektrischen Antennen ist es weiterhin nicht möglich, aus elektrisch abgeschirmten Umgebungen (Faraday'scher Käfig) heraus zu senden.

Ferner sind magnetische Antennen bekannt. Durch die hohe Güte sind magnetische Antennen aber sehr schmalbandig. Deshalb müssen magnetische Antennen z.B. bei Annäherung an metallische oder dielektrische Gegenstände auf die gewünschte Frequenz abgestimmt werden.

Wird eine magnetische Antenne in unmittelbarer Nähe zu Materialien betrieben, so können diese, je nach Materialeigenschaft (z.B. leitfähig, dielektrisch, isolierend), die Eigenschaften der Antenne positiv oder negativ beeinflussen. In der Regel werden die magnetischen Antennen durch die umgebenden Materialien verstimmt. D.h. die Resonanzabstimmung ist nicht mehr optimal auf der Betriebsfrequenz oder aber die Anpassung an den Speisewiderstand ist nicht mehr optimal. In der Regel wird beides beeinträchtigt, kann aber durch ein Nachstimmen der Antenne (z.B. durch Änderung des Resonanzkondensators oder Änderung der Ankopplung) korrigiert werden. Dazu ist jedoch ein Nutzereingriff notwendig sowie eine Messgröße mit der eine optimale Einstellung ermittelt werden kann.

Es gibt mehrere Arten, Energie in die Schleife (engl. loop) einer magnetischen Antenne einzukoppeln. Bei einer kapazitiven Kopplung werden nur Kondensatoren benötigt: ein Koppelkondensator und ein Abstimmkondensator (siehe [11]). Hierbei dient der Koppelkondensator zur Einstellung der Koppelung zur Lastanpassung (üblicherweise auf 50 Ohm Eingangswiderstand), während der Abstimmkondensator zur Einstellung der Resonanzfrequenz dient (siehe [12]).

Herkömmlicherweise sitzen diese beiden variablen Elemente am Einspeisepunkt, wie dies in Fig. 33 für eine magnetische Antenne, wie sie in der Magnetresonanz (MR) üblich ist, gezeigt ist.

Im Detail zeigt Fig. 33 ein Blockschaltbild einer in der Magnetresonanz (MR) üblichen magnetischen Antenne. Mit anderen Worten, Fig. 33 zeigt eine bei MR-Schleifen übliche Einkopplung: Mit dem Abstimmkondensator $C_{ts}$ wird die Frequenz korrigiert, mit dem Koppelkondensator $C_{ms}$ die Lastanpassung (Impedanzanpassung) erreicht. Beides ist ein iterativer Prozess.

Die in Fig. 33 gezeigte Schleife ist zweifach kapazitiv verkürzt. Unabhängig vom Verkürzungsgrad stellt die rechts vom Abstimmkondensator $C_{ts}$ befindliche Anordnung (das kann nun nur eine Drahtschleife sein oder eben *n*-Schleifen-Äste mit *n* - 1 Verkürzungs-Kondensatoren) insgesamt eine Induktivität dar, die z.B. als Ersatzinduktivität $L_{ers}$ bezeichnet werden kann. Wird, wie in der Magnetresonanz (MR) üblich, die Schleife auf Körpergewebe gelegt, so entstehen darin verlustbehaftete Wirbelströme sowie dielektrische Rückwirkungen auf die Schleife ($\varepsilon_r$ von Körpergewebe ist ca. 80). Somit werden immer die Frequenz der Schleife und dessen Resonanzgüte verändert. Herkömmlicherweise ist somit eine Korrektur der beiden Kondensatoren (Abstimmkondensator $C_{ts}$ und Koppelkondensator $C_{ms}$) in jedem Fall nötig.

Die WO 91/15878 A1 beschreibt ein magnetisches Antennensystem zum Senden und/oder Empfangen mit einer Schleifenantenne mit einer oder mehreren Wicklungen und kapazitiven Abstimmelementen für diese Antenne, die einen Resonanzkreis für bestimmte Wellenlängenbänder bilden.

Die DE 43 27 917 A1 beschreibt eine magnetische Antenne, mit einem Antennenleiter in Gestalt eines Ringes, dessen Umfangslänge vorzugsweise kleiner als $\lambda/2$ ist, wobei der Antennenleiter zur Bildung von zwei Strahlungsquellen an zwei einander diametral gegenüberliegenden Stellen aufgetrennt ist und in die beiden Trennstellen je eine die anliegenden Enden der beiden Ringhälften elektrisch miteinander verbindende Kapazität eingefügt ist, wobei die beiden, die Strahlungsquellen bildenden Ringhälften jeweils kleiner als $\lambda/4$ sind und wobei die beiden Kapazitäten abstimmbar sind und eine der beiden Trennstellen als Energie-Einspeise- bzw. -Auskoppelstelle dient.

Die US 2013/016018 A1 beschreibt ein automatisches Abstimmsystem für eine Schleifenantenne mit einem einzigen elektronisch variablen Reaktanzelement. Das elektronisch variable Reaktanzelement der Antenne wird automatisch durch eine Rückkopplungsschleife minimiert, die eine spannungsvariable Kapazität antreibt, bis die reaktive Komponente der Antennenimpedanz praktisch null ist und die Antennenimpedanz daher resistiv ist. Die Einstellung der elektronisch variablen Kapazität erfolgt durch eine variable Hochspannungsversorgung, die durch einen Rückkopplungsverstärker oder durch einen Hochspannungsrückkopplungsverstärker gesteuert wird.

Die US 5 225 847 A beschreibt ein automatisches Abstimmsystem für eine Antenne mit einem einzelnen variablen Reaktanzelement, bei dem die an die Antenne übertragene Leistung und die von der Antenne auf der Speiseleitung reflektierte Leistung erfasst wird. Das variable Reaktanzelement der Antenne wird eingestellt, bis das Verhältnis zwischen der gesendeten und der reflektierten Leistung auf der Speiseleitung anzeigt, dass das Stehwellenverhältnis auf der Speiseleitung minimal ist, woraufhin die Antenne abgestimmt wird. Die Einstellung es variablen Reaktanzelements erfolgt durch einen Schrittmotor, der von einem Mikroprozessor gesteuert wird, der so programmiert ist, dass er Berechnungen durchführt, um zu bestimmen, wann das Stehwellenverhältnis ein Minimum erreicht.

Der vorliegenden Erfindung liegt die Aufgabe zugrunde, eine Abstimmung einer magnetischen Antenne für einen Teilnehmer eines Kommunikationssystems zu verbessern.

Diese Aufgabe wird durch die unabhängigen Patentansprüche gelöst.

Vorteilhafte Weiterbildungen finden sich in den abhängigen Patentansprüchen.

Ausführungsbeispiele schaffen eine Antennenanordnung mit einer magnetischen Antenne mit einer einfach oder mehrfach [z.B. zumindest zweifach] unterbrochenen Schleife und zumindest einem Abstimmelement zur Abstimmung der magnetischen Antenne, wobei die Schleife der magnetischen Antenne durch ein oder mehrere Kapazitätselemente unterbrochen ist, wobei ein Signal an einem ersten Punkt [z.B. ersten Abschnitt oder Bereich] der einfach oder mehrfach unterbrochenen Schleife [z.B. an dem die Schleife unterbrochen ist] in die magnetische Antenne eingekoppelt und/oder aus der magnetischen Antenne ausgekoppelt wird, wobei das zumindest eine Abstimmelement an die magnetische Antenne an zumindest einem zweiten Punkt [z.B. einen zweiten Punkt, oder einem zweiten Punkt und einem dritten Punkt; z.B. zumindest einen zweiten Abschnitt oder Bereich] der einfach oder mehrfach unterbrochenen Schleife [an dem die Schleife unterbrochen ist] angekoppelt ist, wobei der erste Punkt und der zumindest eine zweite Punkt unterschiedlich sind.

Bei Ausführungsbeispielen können der erste Punkt und der zumindest eine zweite Punkt voneinander beabstandet sein.

Beispielsweise kann ein Abstand zwischen dem ersten Punkt und dem zumindest einen zweiten Punkt größer gleich 1/8 oder 1/12 oder 1/16 eines Umfangs der Schleife sein.

Bei Ausführungsbeispielen kann das Signal über eine Koppelschleife in die magnetische Antenne eingekoppelt und/oder aus der magnetischen Antenne ausgekoppelt werden.

Bei Ausführungsbeispielen kann das Signal kapazitiv in die magnetische Antenne eingekoppelt und/oder aus der magnetischen Antenne ausgekoppelt werden.

Bei Ausführungsbeispielen kann die Schleife der magnetischen Antenne durch mehrere Kapazitätselemente mehrfach unterbrochen sein, wobei das Signal über ein erstes Kapazitätselement der mehreren Kapazitätselemente in die magnetische Antenne eingekoppelt und/oder aus der magnetischen Antenne ausgekoppelt werden kann, wobei das zumindest eine Abstimmelement über zumindest ein zweites Kapazitätselement der mehreren Kapazitätselemente mit der magnetischen Antenne verbunden sein kann oder wobei zumindest ein zweites Kapazitätselement der mehreren Kapazitätselemente das zumindest eine Abstimmelement sein kann.

Beispielsweise können das erste und das zumindest eine zweite Kapazitätselement unterschiedliche Kapazitätselemente sein.

Bei Ausführungsbeispielen kann der Antennenanschluss der Antennenanordnung mit der magnetischen Antenne über zumindest einen Anpassungskondensator kapazitiv gekoppelt sein.

Bei Ausführungsbeispielen kann der Anpassungskondensator einen festen Kapazitätswert aufweisen.

Bei Ausführungsbeispielen kann die Schleife der magnetischen Antenne durch mehrere Kapazitätselemente mehrfach unterbrochen sein, wobei das Signal über eine Koppelschleife in die magnetische Antenne eingekoppelt und/oder aus der magnetischen Antenne ausgekoppelt werden kann, wobei das zumindest eine Abstimmelement über zumindest ein zweites Kapazitätselement der mehreren Kapazitätselemente mit der magnetischen Antenne verbunden sein kann oder wobei zumindest ein zweites Kapazitätselement der mehreren Kapazitätselemente das zumindest eine Abstimmelement sein kann, wobei die Koppelschleife im Wesentlichen benachbart zu einem Abschnitt der Schleife angeordnet ist, der zumindest um 1/8 eines Umfangs der Schleife von dem zumindest einen zweiten Kapazitätselement entfernt ist.

Bei Ausführungsbeispielen können, in einer Draufsicht auf die mehrfach unterbrochene Schleife, das erste Kapazitätselement und das zweite Kapazitätselement gegenüberliegende Kapazitätselemente sein.

Bei Ausführungsbeispielen kann, in einer Draufsicht auf die mehrfach unterbrochene Schleife, das zweite Kapazitätselement unsymmetrisch in Bezug auf das erste Kapazitätselement angeordnet sein.

Beispielsweise kann, in einer Draufsicht auf die mehrfach unterbrochene Schleife, das zweite Kapazitätselement unsymmetrisch in Bezug auf eine Achse angeordnet sein, die durch das erste Kapazitätselement und einem Zentrum der Schleife verläuft.

Bei Ausführungsbeispielen können, in einer Draufsicht auf die mehrfach unterbrochene Schleife (108), das erste Kapazitätselement und das zweite Kapazitätselement unmittelbar benachbarte Kapazitätselemente sein.

Bei Ausführungsbeispielen kann das zumindest eine Abstimmelement einen einstellbaren Kapazitätswert oder Induktivitätswert aufweisen.

Bei Ausführungsbeispielen kann das zumindest eine Abstimmelement eine variable Kapazität aufweisen.

Bei Ausführungsbeispielen kann die variable Kapazität

- eine Kapazitätsdiode,
- ein anti-seriell geschaltetes Kapazitätsdiodenpaar,
- kaskadierte Kapazitäsdiodenpaare,
- ein Kondensator, dessen Dielektrikum von einer Feldstärke im Dielektrikum abhängig ist [z.B. BST-Varaktor], oder
- ein Kondensator mit veränderlichem Plattenabstand [z.B. RF-MEMS-Kondensator] sein.

Bei Ausführungsbeispielen kann das zumindest eine Abstimmelement schaltbare Kondensatoren aufweisen.
Bei Ausführungsbeispielen können die schaltbaren Kondensatoren

- eine integrierte Schaltung [z.B. IC] mit einer Kondensatorbank, oder
- digital steuerbare Kondensatoren [z.B. DTC, digitally tuneable capacitors] sein.

Bei Ausführungsbeispielen kann die magnetische Antenne zumindest zwei Abstimmelemente aufweisen, wobei ein erstes Abstimmelement der zumindest zwei Abstimmelemente die schaltbaren Kondensatoren aufweist und wobei ein zweites Abstimmelement der zumindest zwei Abstimmelemente die variable Kapazität aufweist, wobei das erste Abstimmelement zur Grobabstimmung und das zweite Abstimmelement zur Feinabstimmung verwenden werden.
Bei Ausführungsbeispielen kann die variable Kapazität über das zweite Kapazitätselement der mehreren Kapazitätselemente mit der magnetischen Antenne verbunden sein, wobei die schaltbaren Kondensatoren über ein drittes Kapazitätselement der mehreren Kapazitätselemente mit der magnetischen Antenne verbunden sein können.
Beispielsweise können das erste, das zweite und das dritte Kapazitätselement unterschiedliche Kapazitätselemente sein.
Bei Ausführungsbeispielen kann, in einer Draufsicht auf die mehrfach unterbrochene Schleife, das dritte Kapazitätselement unsymmetrisch in Bezug auf das erste Kapazitätselement angeordnet sein.
Beispielsweise kann, in einer Draufsicht auf die mehrfach unterbrochene Schleife, das dritte Kapazitätselement unsymmetrisch in Bezug auf eine Achse angeordnet sein, die durch das erste Kapazitätselement und einem Zentrum der Schleife verläuft.
Bei Ausführungsbeispielen können, in einer Draufsicht auf die mehrfach unterbrochene Schleife, das erste Kapazitätselement und das dritte Kapazitätselement unmittelbar benachbarte Kapazitätselemente sein.
Bei Ausführungsbeispielen können die Kondensatoren der schaltbaren Kondensatoren zumindest zwei unterschiedliche Kapazitätswerte aufweisen.
Bei Ausführungsbeispielen kann das zumindest eine Abstimmelement schaltbare Induktivitäten aufweisen.
Bei Ausführungsbeispielen kann die magnetische Antenne zumindest zwei Abstimmelemente aufweisen, wobei ein erstes Abstimmelement der zumindest zwei Abstimmelemente die schaltbaren Induktivitäten aufweisen kann und wobei ein zweites Abstimmelement der zumindest zwei Abstimmelemente die variable Kapazität aufweisen kann, wobei das erste Abstimmelement zur Grobabstimmung und das zweite Abstimmelement zur Feinabstimmung verwendet werden können.
Bei Ausführungsbeispielen kann die variable Kapazität über das zweite Kapazitätselement der mehreren Kapazitätselemente. mit der magnetischen Antenne verbunden sein, wobei die schaltbaren Induktivitäten über ein drittes Kapazitätselement der mehreren Kapazitätselemente mit der magnetischen Antenne verbunden sein können.
Beispielsweise können das erste, das zweite und das dritte Kapazitätselement unterschiedliche Kapazitätselemente sein.
Bei Ausführungsbeispielen kann die Antennenanordnung eine Abstimmeinrichtung aufweisen, die mit dem zumindest einen Abstimmelement verbunden ist.
Bei Ausführungsbeispielen kann die Abstimmeinrichtung ausgebildet sein, um ein Abstimmsignal zur Abstimmung der magnetischen Antenne bereitzustellen, und um das zumindest eine Abstimmelement mit dem Steuersignal anzusteuern, um die magnetische Antenne abzustimmen.
Bei Ausführungsbeispielen kann die Abstimmeinrichtung über zumindest eine Leiterbahn mit dem zumindest einen Abstimmelement verbunden sein, wobei die Leiterbahn einfach oder mehrfach durch HF hochohmige Bauteile unterbrochen ist.
Bei Ausführungsbeispielen können die HF hochohmigen Bauteile Widerstände und/oder Drosseln und/oder Ferritperlen sein.
Bei Ausführungsbeispielen können die Leiterbahnen eine Breite von höchstens 300 $\mu$m [oder 200 $\mu$m oder 150 $\mu$m oder 100 $\mu$m oder 75 $\mu$m] aufweisen.
Bei Ausführungsbeispielen kann die Abstimmeinrichtung über die einfach oder mehrfach unterbrochene Schleife mit dem Abstimmelement verbunden sein.
Bei Ausführungsbeispielen kann das eine Kapazitätselement oder zumindest ein Teil der mehreren Kapazitätselemente [z.B. alle bis auf das erste Kapazitätselement] jeweils durch einen Widerstand, eine Drossel, oder eine Ferritperle oder eine Serienschaltung aus einem Widerstand und einer Drossel überbrückt sein.

Bei Ausführungsbeispielen kann die Schleife durch mehrere Kapazitätselemente mehrfach unterbrochen sein, wobei die magnetische Antenne zumindest zwei Abstimmelemente aufweisen kann, wobei ein erstes Abstimmelement der zumindest zwei Abstimmelemente über ein zweites Kapazitätselement der mehreren Kapazitätselemente mit dem zweiten Kapazitätselement verbunden ist [z.B. parallel oder seriell zu dem zweiten Kapazitätselement geschaltet ist] oder wobei das erste Abstimmelement das zweite Kapazitätselement ist, wobei ein zweites Abstimmelement der zumindest zwei Abstimmelemente über ein drittes Kapazitätselement der mehreren Kapazitätselemente mit dem dritten Kapazitätselement verbunden ist [z.B. parallel oder seriell zu dem dritten Kapazitätselement geschaltet ist] oder wobei das zweite Abstimmelement das dritte Kapazitätselement ist, wobei die Abstimmeinrichtung über die mehrfach unterbrochene Schleife mit dem ersten Abstimmelement und dem zweiten Abstimmelement verbunden ist, wobei zumindest ein Teil der mehreren Kapazitätselemente [z.B. alle bis auf das erste Kapazitätselement] jeweils durch einen Widerstand überbrückt werden, über den ein jeweiliger Teil des Abstimmsignals zur Abstimmung des jeweiligen Abstimmelements abfällt.

Bei Ausführungsbeispielen kann die Schleife eine erste Schleife sein, wobei die erste Schleife durch mehrere Kapazitätselemente mehrfach unterbrochen sein kann, wobei die Antennenanordnung eine zweite Schleife aufweisen kann, wobei die erste Schleife und die zweite Schleife mehrfach [z.B. im Wesentlichen äquidistant] kapazitiv gekoppelt sein können, wobei ein erstes Abstimmelement des zumindest einen Abstimmelements über ein zweites Kapazitätselement der mehreren Kapazitätselemente mit dem zweiten Kapazitätselement verbunden ist [z.B. parallel oder seriell zu dem zweiten Kapazitätselement geschaltet ist] oder wobei das erste Abstimmelement das zweite Kapazitätselement ist, wobei die Abstimmeinrichtung über die zweite Schleife mit dem Abstimmelement verbunden sein kann, wobei die zweite Schleife durch mehrere Widerstandselemente mehrfach unterbrochen sein kann, über die ein jeweiliger Teil des Abstimmsignals zur Abstimmung des Abstimmelements abfällt, wobei zumindest ein Teil der mehreren Kapazitätselemente [z.B. alle bis auf das erste Kapazitätselement] jeweils durch einen Widerstand, eine Drossel, oder eine Ferritperle oder eine Serienschaltung aus einem Widerstand und einer Drossel überbrückt werden können.

Bei Ausführungsbeispielen kann die magnetische Antenne zumindest zwei Abstimmelemente aufweisen, wobei ein zweites Abstimmelement der zumindest zwei Abstimmelemente über ein drittes Kapazitätselement der mehreren Kapazitätselemente mit dem dritten Kapazitätselement verbunden sein kann [z.B. parallel zu dem dritten Kapazitätselement geschaltet ist] oder wobei das zweite Abstimmelement das dritte Kapazitätselement sein kann.

Bei Ausführungsbeispielen können die erste Schleife und die zweite Schleife nebeneinander angeordnet sein, so dass die erste Schleife und die zweite Schleife kapazitiv gekoppelt sind.

Bei Ausführungsbeispielen können die erste Schleife und die zweite Schleife übereinander angeordnet sein, so dass die erste Schleife und die zweite Schleife kapazitiv gekoppelt sind.

Bei Ausführungsbeispielen können die erste Schleife und die zweite Schleife auf unterschiedlichen [z.B. unmittelbar benachbarten] Ebenen einer Leiterplatte angeordnet sein.

Bei Ausführungsbeispielen kann das Kapazitätselement oder zumindest eines der Kapazitätselemente [z.B. das zweite Kapazitätselement] zwei seriell geschaltete Kondensatoren aufweisen, wobei das zumindest eine Abstimmelement parallel zu einem der zwei seriell geschalteten Kondensatoren, die einen Spannungsteiler bilden, geschaltet ist.

Bei Ausführungsbeispielen kann die Antennenanordnung eine Abstimmeinrichtung aufweist, die mit dem zumindest einen Abstimmelement verbunden ist, wobei die Abstimmeinrichtung über die Schleife mit dem zumindest einen Abstimmelement verbunden ist.

Bei Ausführungsbeispielen kann die Abstimmeinrichtung ausgebildet sein, um das Steuersignal zur Abstimmung der magnetischen Antenne in Abhängigkeit von einer Phasenbeziehung zwischen einem in die magnetische Antenne vorlaufenden Signal und einem Phasensignal bereitzustellen.

Bei Ausführungsbeispielen kann das Phasensignal eine aus der magnetischen Antenne ausgekoppelte Leistung sein.

Bei Ausführungsbeispielen kann die Abstimmeinrichtung eine Koppelschleife aufweisen, die ausgebildet ist, um Leistung aus der magnetischen Antenne auszukoppeln, um die aus der magnetischen Antenne ausgekoppelte Leistung zu erhalten.

Weitere Ausführungsbeispiele schaffen eine Antennenanordnung mit einer magnetischen Antenne mit einer mehrfach unterbrochenen Schleife und zumindest einem Abstimmelement zur Abstimmung der magnetischen Antenne, wobei die Schleife der magnetischen Antenne durch mehrere Kapazitätselemente mehrfach unterbrochen ist, wobei ein Antennenanschluss der magnetischen Antenne mit der mehrfach unterbrochenen Schleife über ein erstes Kapazitätselement der mehreren Kapazitätselemente [z.B. zur Einkopplung oder Auskopplung eines Signals] gekoppelt ist, wobei das Abstimmelement mit der mehrfach unterbrochenen Schleife über ein zweites Kapazitätselement der mehreren Kapazitätselemente gekoppelt [z.B. verbunden] ist, wobei das erste Kapazitätselement und das zweite Kapazitätselement unterschiedlich sind.

Weitere Ausführungsbeispiele schaffen einen Teilnehmer eines drahtlosen Kommunikationssystems, wobei der Teilnehmer eine Antennenanordnung gemäß einem der hierin beschriebenen Ausführungsbeispiele aufweist, wobei der Teilnehmer eine Sende- und/oder Empfangseinrichtung aufweist, die mit einem Antennenanschluss der magnetischen Antenne verbunden ist.

Bei Ausführungsbeispielen kann der Teilnehmer ausgebildet sein, um Daten basierend auf einem Zeit- und/oder Frequenzsprungverfahren zu senden und/oder zu empfangen.

Bei Ausführungsbeispielen kann der Teilnehmer ausgebildet sein, um im ISM Band zu kommunizieren.

Bei Ausführungsbeispielen kann der Teilnehmer ein Endpunkt des Kommunikationssystems sein.

Bei Ausführungsbeispielen kann der Teilnehmer eine Basisstation des Kommunikationssystems sein.

Mit den in Ausführungsbeispielen adressierten magnetischen Antennen kann (1) die Baugröße von Teilnehmern eines Kommunikationssystems, wie z.B. von Sensorknoten, verringert werden, (2) durch die automatische Abstimmung eine Unabhängigkeit von der Umgebung geschaffen werden, und/oder (3) aus (teilweise) elektrisch abgeschirmten Umgebungen (besser) herausgesendet/empfangen werden.

Ausführungsbeispiele der vorliegenden Erfindung werden bezugnehmend auf die beiliegenden Figuren näher beschrieben. Es zeigen:

| | |
|---|---|
| Fig. 1a | eine schematische Ansicht eines Teilnehmers eines Kommunikationssystems, gemäß einem Ausführungsbeispiel der vorliegenden Erfindung, |
| Fig. 1b | eine schematische Ansicht eines Teilnehmers eines Kommunikationssystems, gemäß einem Ausführungsbeispiel der vorliegenden Erfindung, |
| Fig. 1c | eine schematische Ansicht eines Endpunkts eines Kommunikationssystems, gemäß einem Ausführungsbeispiel der vorliegenden Erfindung, |
| Fig. 2 | eine schematische Ansicht einer magnetischen Antenne, |
| Fig. 3 | eine schematische Ansicht einer magnetischen Antenne mit einer mehrfach unterbrochenen (z.B. kapazitiv verkürzten) Schleife, gemäß einem Ausführungsbeispiel der vorliegenden Erfindung, |
| Fig. 4 | eine schematische Ansicht einer magnetischen Antenne mit einer mehrfach unterbrochenen Schleife, wobei die Schleife achteckförmig ist, gemäß einem Ausführungsbeispiel der vorliegenden Erfindung, |
| Fig. 5 | eine schematische Ansicht einer Antennenanordnung mit einer ersten magnetischen Antenne und einer zweiten magnetischen Antenne, gemäß einem Ausführungsbeispiel der vorliegenden Erfindung, |
| Fig. 6a | ein schematisches Blockschaltbild einer Antennenanordnung, gemäß einem Ausführungsbeispiel der vorliegenden Erfindung, |
| Fig. 6b | ein schematisches Blockschaltbild einer Antennenanordnung, gemäß einem Ausführungsbeispiel der vorliegenden Erfindung, |
| Fig. 7 | ein schematisches Blockschaltbild einer Antennenanordnung, gemäß einem Ausführungsbeispiel der vorliegenden Erfindung, |
| Fig. 8 | in einem Diagramm Phasengänge eines Resonanzkreises aus [1] bei geringer Dämpfung und starker Dämpfung, |
| Fig. 9 | ein schematisches Blockschaltbild einer Antennenanordnung, gemäß einem Ausführungsbeispiel der vorliegenden Erfindung, |
| Fig. 10a | ein schematisches Blockschaltbild eines herkömmlichen Richtkopplers, |
| Fig. 10b | ein schematisches Blockschaltbild eines Richtkopplers, gemäß einem Ausführungsbeispiel der vorliegenden Erfindung, |
| Fig. 10c | ein schematisches Blockschaltbild eines Richtkopplers, gemäß einem weiteren Ausführungsbeispiel der vorliegenden Erfindung, |

Fig. 11a ein schematisches Blockschaltbild eines Transformators gemäß einer ersten Anordnung,

Fig. 11b ein schematisches Blockschaltbild eines Transformators gemäß einer zweiten Anordnung,

Fig. 12 ein schematisches Blockschaltbild einer Antennenanordnung, gemäß einem Ausführungsbeispiel der vorliegenden Erfindung,

Fig. 13 ein schematisches Blockschaltbild eines Messaufbaus zur Bestimmung einer Ausgangsleistung und einer reflektierten Leistung einer Antenne,

Fig. 14 ein schematisches Blockschaltbild eines Messaufbaus zur Bestimmung einer idealen Antennenanpassung,

Fig. 15 in einem Smith-Diagramm die Stromaufnahme der Sendeeinrichtung aufgetragen über die Antennenimpedanz,

Fig. 16 in einem Smith-Diagramm die Ausgangsleistung aufgetragen über der Antennenimpedanz,

Fig. 17a in einem Diagramm einen Verlauf eines Realteils R und eines Imaginärteils X der Antennenimpedanz aufgetragen über den Eingangsstrom,

Fig. 17b in einem Diagramm einen Verlauf der Ausgangsleistung aufgetragen über den Eingangsstrom,

Fig. 18 in einem Diagramm einen Verlauf eines Realteils R und eines Imaginärteils X der Antennenimpedanz sowie einen Verlauf der Ausgangsleistung aufgetragen über den Eingangsstrom,

Fig. 19 ein schematisches Blockschaltbild einer Antennenanordnung, gemäß einem Ausführungsbeispiel der vorliegenden Erfindung,

Fig. 20 einen Messaufbau zum Bestimmen der idealen Antennenanpassung, gemäß einem Ausführungsbeispiel der vorliegenden Erfindung,

Fig. 21 ein schematisches Blockschaltbild einer Sendeeinrichtung mit einem Leistungsverstärker, gemäß einem Ausführungsbeispiel der vorliegenden Erfindung,

Fig. 22 ein schematisches Blockschaltbild einer Antennenanordnung, gemäß einem Ausführungsbeispiel der vorliegenden Erfindung,

Fig. 23 ein schematisches Blockschaltbild eines Ringkopplers, der einen Zugriff auf eine Gleichtaktmode eines differentiellen Ports ermöglicht,

Fig. 24 eine schematische Ansicht eines Magnetkerns eines Baluns sowie einer Messwicklung um den Magnetkern zur Erfassung der Gleichtakteigenschaften des Baluns über die nichtlinearen Eigenschaften des Magnetkerns mithilfe der Messwicklung,

Fig. 25a ein schematisches Blockschaltbild einer Antennenanordnung, gemäß einem Ausführungsbeispiel der vorliegenden Erfindung,

Fig. 25b ein schematisches Blockschaltbild einer Antennenanordnung, gemäß einem weiteren Ausführungsbeispiel der vorliegenden Erfindung,

Fig. 25c ein schematisches Blockschaltbild einer Antennenanordnung, gemäß einem weiteren Ausführungsbeispiel der vorliegenden Erfindung,

Fig. 26 ein schematisches Blockschaltbild einer Antennenanordnung, gemäß einem weiteren Ausführungsbeispiel der vorliegenden Erfindung,

Fig. 27 ein schematisches Blockschaltbild einer Antennenanordnung, gemäß einem weiteren Ausführungsbeispiel der vorliegenden Erfindung,

Fig. 28 ein schematisches Blockschaltbild einer Ausführung des Abstimmelements als schaltbare Kondensatorbank,

Fig. 29 ein schematisches Blockschaltbild einer Antennenanordnung, gemäß einem weiteren Ausführungsbeispiel der vorliegenden Erfindung,

Fig. 30 ein schematisches Blockschaltbild einer Antennenanordnung, gemäß einem weiteren Ausführungsbeispiel der vorliegenden Erfindung,

Fig. 31 ein schematisches Blockschaltbild einer Antennenanordnung, gemäß einem weiteren Ausführungsbeispiel der vorliegenden Erfindung,

Fig. 32a-c drei unterschiedliche Ausführungen eines Abstimmelements, das parallel zu einem jeweiligen Kapazitätselement geschaltet ist, und

Fig. 33 ein Blockschaltbild einer in der Magnetresonanz (MR) üblichen magnetischen Antenne.

In der nachfolgenden Beschreibung der Ausführungsbeispiele der vorliegenden Erfindung werden in den Figuren gleiche oder gleichwirkende Elemente mit dem gleichen Bezugszeichen versehen, so dass deren Beschreibung untereinander austauschbar ist.

Bevor Ausführungsbeispiele einer Abstimmung einer magnetischen Antenne mit einem Abstimmelement in Abschnitt 3 beschrieben werden, werden zunächst Ausführungsbeispiele der magnetischen Antenne in Abschnitt 1 und Ausführungsbeispiele einer Erzeugung eines Abstimmsignals zur Abstimmung der magnetischen Antenne in Abschnitt 2 beschrieben.

## 1. Ausführung einer magnetischen Antenne

In der nachfolgenden Beschreibung wird dabei beispielhaft davon ausgegangen, dass die magnetische Antenne in einen Teilnehmer eines Kommunikationssystems implementiert werden kann.

Fig. 1a zeigt eine schematische Ansicht eines Teilnehmers 100 eines Kommunikationssystems, gemäß einem Ausführungsbeispiel der vorliegenden Erfindung. Der Teilnehmer 100 umfasst eine Sende- und/oder Empfangseinrichtung 102 (z.B. einen Transmitter) und eine mit der Sende- und/oder Empfangseinrichtung 102 verbundene Antennenanordnung 104, wobei die Antennenanordnung 104 eine magnetische Antenne 106 mit einer einfach (d.h. nur einmal) unterbrochenen Schleife 108 aufweist.

Fig. 1b zeigt eine schematische Ansicht eines Teilnehmers 100 eines Kommunikationssystems, gemäß einem Ausführungsbeispiel der vorliegenden Erfindung. Der Teilnehmer 100 umfasst eine Sende- und/oder Empfangseinrichtung 102 (z.B. einen Transmitter) und eine mit der Sende- und/oder Empfangseinrichtung 102 verbundene Antennenanordnung 104, wobei die Antennenanordnung 104 eine magnetische Antenne 106 mit einer mehrfach unterbrochenen Schleife 108 aufweist.

Im Folgenden werden primär Ausführungsbeispiele der in Fig. 1b gezeigten Antennenanordnung 104 mit der magnetischen Antenne 106 mit der mehrfach unterbrochenen Schleife beschrieben. Es sei jedoch darauf hingewiesen, dass die im folgenden beschriebenen Ausführungsbeispiele genauso auf die in Fig. 1a gezeigte Antennenanordnung 104 mit der magnetischen Antenne 106 mit der einfach unterbrochenen Schleife anwendbar sind.

Bei Ausführungsbeispielen kann die Schleife 108 der magnetischen Antenne 106 durch Kapazitätselemente 110, wie z.B. Resonanzkapazitäten (Resonanzkondensatoren), unterbrochen sein. Beispielsweise kann die Schleife 108 der magnetischen Antenne 106, wie dies in Fig. 1b zur Veranschaulichung gezeigt ist, durch zwei Kapazitätselemente 110 zweifach unterbrochen (z.B. kapazitiv verkürzt) sein. Es sei jedoch darauf hingewiesen, dass bei Ausführungsbeispielen die Schleife 108 der magnetischen Antenne 106 auch durch eine andere Anzahl von Kapazitätselementen 110 mehrfach unterbrochen sein kann. So kann bei Ausführungsbeispielen die Schleife 108 der magnetischen Antenne 106 durch n Kapazitätselemente 110 in n Segmente (oder Teile, oder Abschnitte) unterteilt sein, wobei n eine natürliche Zahl größer gleich zwei ist. Als Segmente werden dabei hierin die Teile bzw. Abschnitte der Schleife zwischen den jeweiligen Kapazitätselementen 110 bezeichnet.

Bei Ausführungsbeispielen können die Segmente der mehrfach unterbrochenen Schleife 108 durch die Kapazitätselemente 110 verbunden sein. Im Detail können jeweils zwei Segmente der mehrfach unterbrochenen Schleife durch jeweils ein Kapazitätselement, das in Reihe zwischen den zwei Segmenten geschaltet ist, verbunden sein. Mit anderen Worten, die Segmente der Schleife 108 der magnetischen Antenne 106 und die Kapazitätselemente 110 sind abwechselnd in Reihe zu einer Schleife verschaltet.

Die Sende- und/oder Empfangseinrichtung 102 kann dabei mit der magnetischen Antenne 106 über eines der Kapazitätselemente 110 verbunden sein. Das eine Kapazitätselement auf der einen Seite und die mehrfach unterbrochene Schleife 108 mit den anderen (bzw. übrigen) Kapazitätselementen auf der anderen Seite können (z.B. aus Sicht der Sende- und/oder Empfangseinrichtung 102) einen Parallelschwingkreis bilden.

Bei Ausführungsbeispielen kann die Antennenanordnung 102 ferner eine Abstimmeinrichtung zum Abstimmen der magnetischen Antenne 106 aufweisen. Die Abstimmeinrichtung kann dabei ausgebildet sein, um die magnetische Antenne 106 automatisch abzustimmen.

Bedingt durch die geometrische Form der Schleife 108 der magnetischen Antenne 106 wird die Strahlungsenergie von der magnetischen Antenne 106 nicht gleichmäßig in alle Richtungen einer Ebene abgestrahlt. Vielmehr weist das Antennendiagramm der in Fig. 1b gezeigten magnetischen Antenne 106 Nullstellen auf, d.h. es gibt Bereiche (z.B. Punkte) im Antennendiagramm, an denen die Strahlungsenergie der magnetischen Antenne praktisch null ist. Bei Ausführungsbeispielen kann die Antennenanordnung 104 daher eine zweite magnetische Antenne aufweisen, wie dies unten anhand von Fig. 5 näher erläutert wird, oder aber auch eine zusätzliche elektrische Antenne. Die zweite magnetische Antenne und/oder die zusätzliche elektrische Antenne können dabei so angeordnet sein, dass die Nullstellen der magnetischen Antenne 106 kompensiert werden.

Bei Ausführungsbeispielen kann der Teilnehmer 100 des Kommunikationssystems natürlich nicht nur ausgebildet sein, um Signale mittels der magnetischen Antenne 106 zu anderen Teilnehmern des Kommunikationssystems zu senden, sondern auch um Signale von anderen Teilnehmern des Kommunikationssystems mittels der magnetischen Antenne 106 zu empfangen. Hierzu kann der Teilnehmer 100 beispielsweise eine Empfangseinrichtung (z.B. einen Receiver) aufweisen, die mit der Antennenanordnung 104 verbunden ist. Natürlich kann der Teilnehmern 100 auch eine kombinierte Sendeempfangseinrichtung (z.B. ein Transceiver) 102 aufweisen.

Bei Ausführungsbeispielen kann der Teilnehmer 100 (bzw. das Kommunikationssystem des Teilnehmers) ausgebildet sein, um im ISM-Band (ISM = Industrial, Scientific and Medical Band) zu kommunizieren, d.h. um Signale im ISM-Band zu senden und/oder zu empfangen.

Bei Ausführungsbeispielen kann der Teilnehmer 100 (bzw. das Kommunikationssystem des Teilnehmers) ausgebildet sein, um Daten basierend auf dem Telegram-Splitting-Verfahren zu übertragen. Beim Telegram-Splitting-Verfahren werden Daten, wie z.B. ein Telegramm oder Datenpaket, in eine Mehrzahl von Sub-Datenpakete (oder Teildatenpakte, oder Teilpakete) aufgeteilt und die Sub-Datenpakete unter Verwendung eines Zeit- und/oder Frequenzsprungmusters in der Zeit und/oder in der Frequenz verteilt (d.h. nicht zusammenhängend) von einem Teilnehmer zu einem anderen Teilnehmer (z.B. von der Basistation zum Endpunkt, oder vom Endpunkt zur Basisstation) des Kommunikationssystems übertragen, wobei der Teilnehmer, der die Sub-Datenpakete empfängt, diese wieder zusammenfügt (oder kombiniert), um das Datenpaket zu erhalten. Jedes der Sub-Datenpakete enthält dabei nur einen Teil des Datenpakets. Das Datenpaket kann ferner kanalcodiert sein, so dass zum fehlerfreien Decodieren des Datenpakets nicht alle Sub-Datenpakete, sondern nur ein Teil der Sub-Datenpakete erforderlich ist.

Bei Ausführungsbeispielen kann das Kommunikationssystem ein persönliches Netzwerk (engl. Personal Area Network, PAN) oder ein Niedrigenergie-Weitverkehrsnetzwerk (engl. Low Power Wide Area Network, LPWAN) sein.

Der in Fig. 1b gezeigte Teilnehmer 100 des Kommunikationssystems kann eine Basisstation des Kommunikationssystems sein. Alternativ kann der in Fig. 1b gezeigte Teilnehmer 100 des Kommunikationssystems auch ein Endpunkt des Kommunikationssystems sein, wie dies nachfolgend anhand von Fig. 1c erläutert wird.

Im Detail zeigt Fig. 1c eine schematische Ansicht eines Teilnehmers 100 des Kommunikationssystems, wobei der Teilnehmer 100 ein Endpunkt ist, gemäß einem Ausführungsbeispiel der vorliegenden Erfindung.

Wie in Fig. 1c beispielhaft gezeigt ist, kann der Endpunkt 100 bei Ausführungsbeispielen ein Sensorknoten sein. Beispielsweise kann der Endpunkt 100 im Falle eines Sensorknotens einen Sensor 114, wie z.B. einen Temperatursensor, Drucksensor, Feuchtigkeitssensor oder irgendeinen anderen Sensor aufweisen, wobei die von dem Sensorknoten 100 gesendeten Signale von einem von dem Sensor bereitgestellten Sensorsignal abhängig sind. Zum Beispiel kann der Sensor einen Mikroprozessor 112 aufweisen, der das von dem Sensor bereitgestellte Sensorsignal verarbeitet, um basierend auf dem Sensorsignal zu übertragene Daten zu generieren, die von der Sendeeinrichtung (z.B. Sende- und Empfangseinrichtung) 102 gesendet werden, z.B. basierend auf dem Telegram Splitting Übertragungsverfahren.

Natürlich kann der Endpunkt 100 auch ein Aktorknoten sein, wobei der Aktorknoten einen Aktor 114 aufweist. In diesem Fall kann der Prozessor 112 beispielsweise ausgebildet sein, um den Aktor 114 basierend auf einem empfangenen Signal bzw. empfangenen Daten anzusteuern.

Bei Ausführungsbeispielen kann der Endpunkt 100 batteriebetrieben sein. Alternativ oder zusätzlich kann der Endpunkt 100 ein Energy Harvesting Element zur elektrischen Energiegewinnung aufweisen.

Im Folgenden werden detaillierte Ausführungsbeispiele der magnetischen Antenne 106 bzw. der Antennenanordnung 104 (z.B. für Sensorknoten oder Basisstationen) beschrieben. Die magnetische Antenne 106 bzw. die Antennenanordnung 104 können dabei für den Sende- und/oder Empfangsfall verwendet werden.

## 1.1. Anwendung von Magnetischen Antennen bei Sensorknoten

Eine magnetische Antenne 106 weist eine ein- oder mehrwindigen Stromschleife 108 auf. Im Empfangsfall induziert ein magnetisches Wechselfeld in der Schleife 108 eine Spannung (Induktionsgesetz), im Sendefall erzeugt ein in der Schleife 108 fließender Strom ein Magnetfeld (Gesetz von Biot-Savart). Soll die magnetische Antenne 106 nur bei einer Frequenz oder einem Bereich kleiner relativer Bandbreite betrieben werden, so kann die magnetische Antenne 106 mittels einer Resonanzkapazität in ihrer Effizienz deutlich gesteigert werden. Der Stromfluss in der Schleife 108 steigt in dem Maße der Resonanzüberhöhung (ausgedrückt durch den Gütefaktor Q), d.h. doppeltes Q bewirkt doppelten Stromfluss (und damit doppeltes Magnetfeld (geht nur mit der Wurzel bei P = konst.; nur bei U = konst. ginge es linear) bei gleicher eingespeister Leistung. Somit ist es erstrebenswert, einen möglichst hohen Q-Faktor zu erzielen, was gleichbedeutend damit ist, dass sowohl die Schleife 108, als auch die Kapazität möglichst geringe Verluste haben müssen. In der Regel überwiegen die Verluste in der Schleife 108 aufgrund der endlichen Leitfähigkeit des verwendeten Metalls (meist Cu).

Fig. 2 zeigt eine schematische Ansicht einer solchen magnetischen Antenne 106. Die magnetische Antenne 106 umfasst, wie bereits erwähnt, die Schleife 108 mit einer oder mehreren Windungen und die Resonanzkapazität 110 (C0). Die magnetische Antenne 106 kann dabei über den aus Resonanzkapazität 110 und Schleife 108 (Spule) gebildeten Parallelschwingkreis z.B. an die Sende- und/oder Empfangseinrichtung 102 (siehe Fig. 1) angekoppelt werden.

Die magnetische Antenne 106 hat den Vorteil einer hohen Antennengüte bei geringer Bauform.

Zudem hat die magnetische Antenne 106 den Vorteil, dass diese an unterschiedliche Umgebungsbedingungen angepasst werden kann, z.B. durch automatische Abstimmung.

Ausführungsbeispiele der vorliegenden Erfindung beziehen sich somit auf einen Sensorknoten mit einer magnetischen Antenne. Die magnetische Antenne kann dabei automatische abgestimmt werden.

## 1.2 Mehrfache Verkürzung der Schleife (engl. loop) der magnetischen Antenne

Fig. 3 zeigt eine schematische Ansicht einer magnetischen Antenne 106 mit einer mehrfach unterbrochenen (z.B. kapazitiv verkürzten) Schleife 108. Wie in Fig. 3 beispielhaft gezeigt ist, kann die Schleife 108 durch vier Kapazitätselemente 110 (4C0), wie beispielsweise Resonanzkapazitäten (z.B. Resonanzkondensatoren), in vier Segmente unterteilt sein. Es sei jedoch darauf hingewiesen, dass die Schleife 108 der magnetischen Antenne 106 auch in eine andere Anzahl von Segmenten unterteilt sein kann. So kann die Schleife 108 der magnetischen Antenne 106 bei Ausführungsbeispielen durch n Kapazitätselemente 110 in n Segmente unterteilt sein, wobei n eine natürliche Zahl größer gleich zwei ist.

Bei Ausführungsbeispielen kann die Schleife 108 der magnetischen Antenne in äquidistante Segmente unterteilt sein. Die Unterteilung der Schleife 108 in äquidistante Segmente hat den Vorteil, dass so insgesamt gesehen die niedrigsten E-Feldanteile erzielt werden. Natürlich kann die Schleife aber auch in nicht-äquidistante Segmente unterteilt werden.

Die niedrigeren elektrischen Felder bzw. die mehrfach kapazitive Verkürzung haben zum Vorteil, dass dielektrisches Material in direkter Umgebung der Antenne diese in ihrer Resonanzfrequenz entsprechend weniger verstimmt.

Ferner haben die niedrigeren elektrischen Felder bzw. die mehrfach kapazitive Verkürzung den Vorteil, dass dielektrisches, verlustbehaftetes Material in direkter Umgebung der Antenne deren Gütefaktor weniger herabsetzt.

Ferner haben die niedrigeren elektrischen Felder bzw. die mehrfach kapazitive Verkürzung den Vorteil, dass die Spannung an den Resonanzkapazitäten entsprechend geringer ausfällt (also z.B. halbe Spannung bei doppelter Verkürzung, dann aber auch doppelter Kapazitätswert). Dies ist insbesondere dann von Vorteil, wenn eine oder mehrere der Resonanzkapazitäten abstimmbar ausgeführt werden sollen, da dann die Abstimmorgane eine niedrigere Spannungsfestigkeit aufweisen können

Bei Ausführungsbeispielen kann die magnetische Antenne 106 (bzw. die Schleife 108 der magnetischen Antenne 106) mehrfach kapazitiv verkürzt sein.

Bei Ausführungsbeispielen befinden sich in der Magnetschleife seriell mehrere Kondensatoren 110.

## 1.3 Besondere Ausführung der Schleife (engl. loop) der magnetischen Antenne

Schleifen 108 mit einer runden Form haben das beste Verhältnis von Leiterbahnlänge zu aufgespannter (oder umschlossener) Fläche. Jedoch ist die Platzausnutzung auf einer üblicherweise rechteckigen Platine (Leiterbahnen) nicht optimal.

Formen mit mehr als vier Ecken, insbesondere die achteckige Form, bieten hier Vorteile. Es verschlechtert sich zwar das Verhältnis von Fläche zu Umfang und damit die Güte der magnetischen Antenne 106, allerdings steigt die Effizienz der magnetischen Antenne 106 bei einer gegebenen rechteckigen Platinenfläche, da die aufgespannte (oder umschlossene) Fläche größer wird. Fig. 4 zeigt eine symmetrische Ausführung (der Schleife 108) der magnetischen Antenne 106, es sind aber auch unsymmetrische Ausführungen (der Schleife 108) denkbar, bei denen z. B. die oberen und unteren Teilstücke (z.B. Segmente der Schleife 108) länger sind.

Im Detail zeigt Fig. 4 eine schematische Ansicht einer magnetischen Antenne 106 mit einer mehrfach unterbrochenen Schleife 108, wobei die Schleife 108 achteckförmig ist.

Wie in Fig. 4 beispielhaft gezeigt ist, kann die Schleife 108 durch (z.B. acht) Kapazitätselemente 110 in acht Segmente unterteilt sein, wobei die acht Segmente eckig sein können, so dass die Schleife 108 eine achteckige Form aufweist. Es sei jedoch darauf hingewiesen, dass die Schleife 108 auch in eine andere Anzahl von Segmenten unterteilt sein kann und/oder eine andere Form aufweisen kann. So kann die Schleife 108 der magnetischen Antenne bei Ausführungsbeispielen m-eckförmig sein, wobei m eine natürliche Zahl größer gleich drei ist, wie z.B. 3, 4, 5, 7, 8, 9, 10, 11 oder 12.

Bei Ausführungsbeispielen kann die magnetische Antenne 106 auf einer Leiterplatte (PCB, printed circuit board) ausgeführt sein.

Bei Ausführungsbeispielen kann die magnetische Antenne 106 (bzw. die Schleife 108 der magnetischen Antenne 106) Teilabschnitte (oder Segmente) aufweisen, die nicht rund sind.

Bei Ausführungsbeispielen kann eine Leitungsführung der Segmente der magnetischen Antenne 106 (bzw. der Schleife 108 der magnetischen Antenne 106) in den Bereichen (oder in den Stellen) mit Bauteilen gerade sein.

Bei Ausführungsbeispielen kann die magnetische Antenne 106 (bzw. die Schleife 108 der magnetischen Antenne 106) eine mehreckige Form oder mehr als vier Ecken aufweisen.

Eine solche magnetische Antenne 106 hat den Vorteil, dass das Layout leichter auf verschiedene Layoutprogramme übertragbar ist.

Ferner hat eine solche magnetische Antenne 106 den Vorteil, dass eine Platzierung der Bauteile einfacher ist, da an den Stellen mit den Bauteilen die Leitungsführung (der Schleife 108 der magnetischen Antenne 106) gerade ist.

Bei manchen Ausführungsbeispielen können die diagonal verlaufenden Seiten (Segmente der Schleife 108 der magnetischen Antenne 106) anstelle einer eckigen Form eine kreisbogenförmige Form aufweisen, um die Fläche noch etwas zu vergrößern und die Platinenfläche optimal auszunutzen. Man würde im Gegenzug die Vorteile der leichteren Bauteilplatzierung und des einfachen Layouts verlieren.

Obwohl die in Fig. 4 gezeigte Antennenanordnung 104 eine magnetische Antenne 106 mit einer mehrfach unterbrochenen Schleife 108 aufweist, sei darauf hingewiesen, dass die beschriebenen Ausführungsbeispiele genauso auf eine Antennenanordnung 104 mit einer magnetische Antennen 106 mit einer einfach unterbrochenen Schleife 108 (vgl. Fig. 1a) anwendbar sind.

1.4. Die Schleife wird auf einer Platine realisiert

Bei Ausführungsbeispielen kann die Schleife auf einer Platine (Leiterplatte, engl. printed circuit board (PCB)) realisiert werden.

Bei Ausführungsbeispielen kann auf der gleichen Platine (Leiterplatte) die Abstimmungsschaltung realisiert werden.

1.5. Mehrere Antennen

Bei Ausführungsbeispielen kann die Antennenanordnung 104 mehrere magnetische Antennen aufweisen.

Dies hat den Vorteil, dass die Nullstelle (z.B. Punkte im Antennendiagramm, an denen die Strahlungsenergie der magnetischen Antenne praktisch null ist) einer magnetischen Antenne umgangen werden kann.

1.5.1 Kreuzfeldloop mit Diversität

Bei Ausführungsbeispielen können zwei magnetische Antennen verwendet werden, wobei die zwei magnetischen Antennen möglichst (z.B. im Wesentlichen) orthogonal sind.

1.5.2 Plattgedrückte zweite Schleife (engl. loop) um aus Nullstelle zu kommen

Um ein möglichst flaches Gehäuse zu bekommen, kann die zweite magnetische Antenne (bzw. die Schleife der zweiten magnetischen Antenne) "plattgedrückt" ausgeführt werden. Bei Schleifen (engl. loops), die nicht rund sind, steigt der Widerstand der Wicklung im Vergleich zur aufgespannten (oder umschlossenen) Fläche, wodurch die Güte sinkt. Da bei der plattgedrückten Schleife (engl. loop) eine kleinere Fläche aufspannt wird, sinkt deren Abstrahleffizienz. Das erhöht zwar die Güte wieder etwas, trägt aber nicht zur Abstrahlung bei. Um den ersten gütereduzierenden Effekt zumindest teilweise zu kompensieren, kann ein breiterer Leiter (weniger Verluste) verwendet werden.

Fig. 5 zeigt eine schematische Ansicht einer Antennenanordnung 104 mit einer ersten magnetischen Antenne 106 und einer zweiten magnetischen Antenne 112, gemäß einem Ausführungsbeispiel der vorliegenden Erfindung.

Die erste magnetische Antenne 106 umfasst eine mehrfach unterbrochene Schleife 108. Wie in Fig. 5 beispielhaft gezeigt ist, kann die Schleife 108 der ersten magnetischen Antenne durch vier Kapazitätselemente 110, in vier Segmente unterteilt sein. Es sei jedoch darauf hingewiesen, dass die Schleife 108 der ersten magnetischen Antenne 106 auch in eine andere Anzahl von Segmenten unterteilt sein kann. So kann die Schleife 108 der ersten magnetischen Antenne 106 bei Ausführungsbeispielen durch n Kapazitätselemente 110 in n Segmente unterteilt sein, wobei n eine natürliche Zahl größer gleich zwei ist.

Die zweite magnetische Antenne 112 umfasst ebenfalls eine Schleife 114, wobei die Schleife 108 der ersten magnetischen Antenne 106 und die Schleife 114 der zweiten magnetischen Antenne 112 im Wesentlichen orthogonal zueinander angeordnet sein können.

Wie in Fig. 5 beispielhaft gezeigt ist, verläuft eine durch die Schleife 114 der zweiten magnetische Antenne 112 aufgespannten Fläche orthogonal zu einer durch die Schleife 108 der ersten magnetischen Antenne 106 aufgespannten Fläche. Im Detail verläuft in Fig. 5 die durch die Schleife 108 der ersten magnetischen Antenne 106 aufgespannten Fläche parallel zu der durch das Koordinatensystem definierten xy-Ebene, während die durch die Schleife 114 der zweiten magnetische Antenne 112 aufgespannten Fläche parallel zur oder in der z-Achse des Koordinatensystems verläuft.

Bei Ausführungsbeispielen kann eine aufgespannte (oder umschlossene) Fläche der Schleife 114 der zweiten magnetischen Antenne 112 zumindest um den Faktor zwei (z.B. um den Faktor drei, vier, fünf, oder zehn) kleiner sein als eine aufgespannte (oder umschlossene) Fläche der Schleife 108 der ersten magnetischen Antenne 106.

Mit anderen Worten, die Schleife 114 der zweiten magnetischen Antenne 112 kann "plattgedrückt" sein.

Wie in Fig. 5 ferner angedeutet ist, kann bei Ausführungsbeispielen ein Leiter der Schleife 114 der zweiten magnetischen Antenne 112 zumindest um den Faktor zwei (z.B. um den Faktor drei, vier oder fünf) dicker bzw. breiter sein als ein Leiter der Schleife 108 der ersten magnetischen Antenne 106.

Natürlich kann die Schleife 114 der zweiten magnetischen Antenne 112 ebenfalls mehrfach unterbrochen sein, beispielsweise durch zumindest zwei Kapazitätselemente.

Bei Ausführungsbeispielen kann die Antennenanordnung 104 eine zweite, möglichst orthogonale Schleife 114 aufweisen.

Bei Ausführungsbeispielen kann eine Drahtstärke/Breite der zweiten Schleife (engl. loop) 114 größer sein (als eine Drahtstärke/Breite der ersten Schleife 108), allerdings kann die zweite Schleife 114 flacher sein (als die erste Schleife 108).

Obwohl die in Fig. 5 gezeigte Antennenanordnung 104 magnetische Antennen mit mehrfach unterbrochenen Schleifen aufweist, sei darauf hingewiesen, dass die beschriebenen Ausführungsbeispiele genauso auf eine Antennenanordnung mit magnetischen Antennen mit einfach unterbrochenen Schleifen anwendbar sind.

### 1.5.3 Kombinierte Magnetische / elektrische Antenne um aus Nullstelle zu kommen

Um die Nullstelle (z.B. Punkte im Antennendiagramm, an denen die Strahlungsenergie der magnetischen Antenne praktisch null ist) der magnetischen Antenne 106 zu umgehen, kann zusätzlich zur magnetischen Antenne 106 eine elektrische Antenne auf der Leiterplatte (z.B. PCB) integriert werden, z.B. in Form einer PCB F-Antenne, als "Erweiterung" der Schleife 108 (z.B. des magnetischen Ringes/8-Ecks).

Bei Ausführungsbeispielen können eine elektrische und eine magnetische Antenne (z.B. auf einer Leiterplatte (z.B. PCB)) kombiniert werden.

### 1.5.4. Umschaltung der Schleifen (engl. loops)

Werden mehrere magnetischen Schleifen (bzw. magnetische Antennen) ohne weitere Maßnahmen zusammengeführt, so ergibt sich eine neue Nullstelle aus einer anderen Richtung.

Daher macht die Verwendung mehrerer magnetischer Schleifen (bzw. mehrerer magnetischer Antennen) nur Sinn, wenn die nichtbenutze(n) Schleife(n) (bzw. magnetische(n) Antenne(n)) ausgeschalten werden können.

#### 1.5.4.1. Ausschalten durch Unterbrechung des Resonanzstroms

Bei Ausführungsbeispielen kann der Stromfluss der nicht gewünschten magnetischen Antenne beispielsweise mittels eines Schalters unterbrochen werden. Da jeder Schalter aber eine gewisse Restkapazität aufweist, kommt dies letztlich einer starken Verstimmung der Resonanzfrequenz gleich.

1.5.4.2. Ausschalten durch zusätzliche Induktivität (L)

Bei Ausführungsbeispielen können einer oder mehrere Resonanzkondensatoren parallel mit einer Spule versehen werden. Diese bilden bei der ursprünglichen Resonanzfrequenz der Schleife (engl. loop) einen Parallelschwingkreis, der den Stromfluss darin unterbricht.

1.5.4.3 Ansteuerverhältnis ändern

Bei Ausführungsbeispielen kann durch eine leichte Verstimmung der Eigenresonanz einer der beiden Schleifen die Abstimmung der Schleifen und damit die Hauptabstrahlrichtung und damit die Nullstelle verschoben werden, da die Schleifen dann bei unverändert hohen Ansteuerleistungen unterschiedlich stark abstrahlen. Der nicht abgestrahlte Anteil der leicht verstimmten Schleife wird zurück reflektiert und im Sender absorbiert.

1.5.4.4. Phasenverschobene Ansteuerung von mag. Loops

Die Nullstelle einer Schleife hängt von ihrer Struktur im dreidimensionalen Raum ab. Diese ändert sich nicht, wenn beispielweise nur die Kapazität einer Resonanzkapazität geändert wird. Bei planaren Schleifen gibt es also immer eine Stellung, in der diese keine B-Feldlinien durchdringen, nämlich dann, wenn diese in der Ebene der Schleife verlaufen. Aber selbst bei einer dreidimensionalen Schleife (oder gekrümmten B-Linien), also z.B. bei einem nicht exakt in einer Ebene verlaufenden leicht verbogenen Kreisring, findet man immer eine Stellung in der sich Feldlinien, die von einer Seite und von der anderen Seite der Schleife eindringen, die Waage halten. Dies führt zu einer Kompensation, d.h. einer Nullstelle. Selbst orthogonale Schleifen würden unter 45° eine Nullstelle aufweisen, wenn deren Signale nur direkt zusammengeschaltet sind. Um dies vermeiden können deren Empfangssignale unter 90° Phasenversatz zusammengeführt werden, weil dann keine geometrische Auslöschung der Zeitsignale mehr möglich ist.

Bei Ausführungsbeispielen können mehrere magnetische Schleifen (engl. loops) phasenversetzt angesteuert werden.

Bei Ausführungsbeispielen können mehrere selbst abgestimmte magnetische Schleifen (engl. loops) phasenversetzt angesteuert werden.

1.5,5. Variation des Abstrahlverhältnisses über der Hop-Nummer

In Zusammenhang mit dem Telegram Splitting Übertragungsverfahren [6] kann Sende-Diversität (also aussenden mit verschiedenen Antennen) pro Telegram durchgeführt werden, da beim Telegram Splitting Übertragungsverfahren ein aussenden jedes Sub-Datenpaketes (Hops) auf einer anderen Antenne / mit unterschiedlicher Stärke auf den Antennen möglich ist.

Dies hat den Vorteil, dass die Übertragungssicherheit eines Telegramms erhöht werden kann.

Bei Ausführungsbeispielen können daher unterschiedliche Sub-Datenpakte (Hops) auf unterschiedlichen Antennen unterschiedlich stark abgestrahlt werden, so dass unterschiedliche Sub-Datenpakte mit unterschiedlichen Antennen-Nullstellen gesendet werden.

1.5.5.1. Ausführung der Schleife, bei der die Nullstelle von der Frequenz abhängt

Bei Ausführungsbeispielen können mehr oder weniger orthogonale Schleifen mit unterschiedlicher Resonanzfrequenz, deren Signale beispielsweise per entkoppelten Kombinierer (engl. combinier) zusammengefasst werden, verwendet werden. Liegen die Resonanzfrequenzen dicht beieinander, so müssen die Schleifen bereits gute geometrisch Orthogonalität (d.h. magnetische Entkopplung) aufweisen. Andernfalls gibt es Güteeinbußen und Resonanzverwerfungen. Daher wird die Resonanzfrequenz mit Absicht etwas verstimmt. Unterschiedliche Sub-Datenpakete (Hops) liegen auf unterschiedlichen Frequenzen und werden dadurch von den Schleifen mit unterschiedlichen Resonanzen unterschiedlich stark ausgesendet, dadurch ist die Nullstelle der mag. Antenne jeweils verschoben.

Bei Ausführungsbeispielen ändert sich das Abstrahlverhältnis der magnetischen Antennen über der Frequenz.

Bei Ausführungsbeispielen verschiebt sich die Nullstelle der Antenne über der Frequenz.

2. Erzeugung eines Abstimmsignals

Fig. 6a zeigt ein schematisches Blockschaltbild einer Antennenanordnung 104, gemäß einem Ausführungsbeispiel der vorliegenden Erfindung.

Die Antennenanordnung 104 umfasst eine magnetische Antenne 104 mit einer einfach (d.h. nur einmal) unterbrochenen Schleife 108 und einem Abstimmelement 111 zur Abstimmung der magnetischen Antenne 104.

Die Abstimmeinrichtung 120 ist ausgebildet, um ein Abstimmsignal (z.B. ein Steuersignal) 122 zur Abstimmung der magnetischen Antenne 106 bereitzustellen, und um das Abstimmelement 111 mit dem Abstimmsignal 122 anzusteuern, um die magnetische Antenne 106 abzustimmen.

Bei Ausführungsbeispielen kann die Schleife 108 der magnetischen Antenne durch das Abstimmelement 111 unterbrochen sein, wobei das Abstimmelement 111 eine variable (oder einstellbare) Kapazität (z.B. variable Resonanzkapazität) sein kann. Beispielsweise kann das Abstimmelement 111 ein variabler Kondensator oder eine Kapazitätsdiode sein.

Fig. 6b zeigt ein schematisches Blockschaltbild einer Antennenanordnung 104, gemäß einem Ausführungsbeispiel der vorliegenden Erfindung.

Die Antennenanordnung 104 umfasst eine magnetische Antenne 104 mit einer mehrfach unterbrochenen Schleife 108 und zumindest einem Abstimmelement 111 zur Abstimmung der magnetischen Antenne 104.

Die Abstimmeinrichtung 120 ist ausgebildet, um ein Abstimmsignal (z.B. Steuersignal) 122 zur Abstimmung der magnetischen Antenne 106 bereitzustellen, und um das Abstimmelement 111 mit dem Abstimmsignal 122 anzusteuern, um die magnetische Antenne 106 abzustimmen.

Bei Ausführungsbeispielen kann die Schleife 108 der magnetischen Antenne 106 durch Kapazitätselemente 110, wie z.B. Resonanzkapazitäten (Resonanzkondensatoren), mehrfach unterbrochen sein. Beispielsweise kann die Schleife 108 der magnetischen Antenne 106, wie dies in Fig. 6b zur Veranschaulichung gezeigt ist, durch zwei Kapazitätselemente 110 zweifach unterbrochen (z.B. kapazitiv verkürzt) sein. Es sei jedoch darauf hingewiesen, dass bei Ausführungsbeispielen die Schleife 108 der magnetischen Antenne 106 auch durch eine andere Anzahl von Kapazitätselementen 110 mehrfach unterbrochen sein kann. So kann bei Ausführungsbeispielen die Schleife 108 der magnetischen Antenne 106 durch n Kapazitätselemente 110 in n Segmente (oder Teile, oder Abschnitte) unterteilt sein, wobei n eine natürliche Zahl größer gleich zwei ist. Als Segmente werden dabei hierin die Teile bzw. Abschnitte der Schleife 108 zwischen den jeweiligen Kapazitätselementen 110 bezeichnet.

Das zumindest eine Abstimmelement 111 kann dabei eines der Kapazitätselemente 110 sein, wobei das Abstimmelement 111 als variables Kapazitätselement, z.B. als variable Resonanzkapazität, ausgeführt sein kann. Beispielsweise kann das Abstimmelement 111 ein variabler Kondensator oder eine Kapazitätsdiode sein. Natürlich können auch eine echte Teilmenge oder alle der Kapazitätselemente 110 Abstimmelemente 111 sein, wie z. B. variable Kapazitätselemente (z.B. variable Kondensatoren oder Kapazitätsdioden). Mit anderen Worten, es können auch mehrere Abstimmelemente, z.B. Kapazitätsdioden, sein, wie z.B. an n-1 von n Unterbrechungen.

Wie in den Fig. 6a und 6b beispielhaft angedeutet ist, kann die Antennenanordnung 104 mit einer Quelle und/oder Senke 102, wie z.B. einer Sende- und/oder Empfangseinrichtung (z.B. eines Teilnehmers 100 eines Kommunikationssystems), verbunden sein. Es sei jedoch darauf hingewiesen, dass sich Ausführungsbeispiele der vorliegenden Erfindung primär auf die Antennenanordnung 104 beziehen, welche in einer Vielzahl von unterschiedlichen Anwendungsgebieten implementiert werden kann.

Im Folgenden werden detaillierte Ausführungsbeispiele der Erzeugung des Abstimmsignals 122 (z.B. Abstimmregelgröße bzw. Abstimmspannung) beschrieben.

Obwohl in den folgenden Ausführungsbeispielen manchmal auf eine magnetische Antenne 106 mit einer einfach unterbrochenen Schleife 108 und manchmal auf eine magnetische Antenne 106 mit einer mehrfach unterbrochen Schleife 108 Bezug genommen wird, sei darauf hingewiesen, dass diese Ausführungsbeispiele genauso auch auf die jeweils andere Ausführung der magnetischen Antenne 106 anwendbar sind.

### 2.1. Erzeugung eines Abstimmsignals (z.B. Abstimmspannung) durch Phasenauswertung

Fig. 7 zeigt ein schematisches Blockschaltbild einer Antennenanordnung 104, gemäß einem Ausführungsbeispiel der vorliegenden Erfindung. Die Antennenanordnung 104 umfasst die magnetische Antenne 106 mit dem Abstimmelement 111 und die Abstimmeinrichtung 120 zur Abstimmung der magnetischen Antenne 106.

Die Abstimmeinrichtung 120 ist ausgebildet, um das Abstimmsignal 122 zur Abstimmung der magnetischen Antenne 106 in Abhängigkeit von einer Phasenlage eines in die magnetische Antenne 106 vorlaufenden Signals 124 (z.B. vorlaufenden Leistung oder vorlaufenden Welle) bereitzustellen, und um das Abstimmelement 111 mit dem Abstimmsignal 122 anzusteuern, um die magnetische Antenne 106 abzustimmen.

Bei Ausführungsbeispielen kann die Abstimmeinrichtung 120 ausgebildet sein, um das Abstimmsignal 122 zur Abstimmung der magnetischen Antenne 106 in Abhängigkeit von einer Phasenbeziehung zwischen des in die magnetische Antenne vorlaufenden Signals 124 (z.B. vorlaufenden Leistung)und einem Phasensignal 126 bereitzustellen.

Das Phasensignal 126 kann auf einem in zumindest einem Abschnitt der Schleife 108 fließenden Strom und/oder auf einem durch die Schleife 108 bzw. magnetische Antenne 106 erzeugten Magnetfeld (z.B. im Nahfeld) basieren.

Das Phasensignal 126 kann eine aus der magnetischen Antenne 106 (z.B. induktiv) ausgekoppelte Leistung sein.

Beispielsweise kann die Antennenanordnung 104 eine Koppelschleife 128 aufweisen, die ausgebildet ist, um Leistung aus der magnetischen Antenne 106 auszukoppeln, um die aus der magnetischen Antenne (z.B. induktiv) ausgekoppelte Leistung zu erhalten. Die Schleife 108 der magnetischen Antenne 106 und die Koppelschleife 128 können auf derselben Leiterplatte angeordnet bzw. implementiert sein.

Bei Ausführungsbeispielen kann die Abstimmeinrichtung 120 ausgebildet sein, um das Abstimmelement 111 mit dem Abstimmsignal 122 anzusteuern, um eine Phasendifferenz zwischen des in die magnetische Antenne vorlaufenden Signals 124 (z.B. vorlaufenden Leistung oder vorlaufenden Welle) und dem Phasensignal 126 auf einen vorgegebenen Sollwert hin zu regeln.

Beispielsweise kann die Abstimmeinrichtung ausgebildet sein, um durch Ansteuerung des Abstimmelements mit dem Steuersignal die Phasendifferenz zwischen des in die magnetische Antenne vorlaufenden Signals 124 (z.B. vorlaufenden Leistung) und dem Phasensignal auf den vorgegebenen Sollwert hin zu regeln.

Zum Beispiel kann die Abstimmeinrichtung ausgebildet sein, um das Steuersignal nachzuführen, um einer Abweichung der Phasendifferenz zwischen des in die magnetische Antenne vorlaufenden Signals 124 (z.B. vorlaufenden Leistung) und dem Phasensignal von dem vorgegebenen Sollwert entgegenzuwirken.

Bei Ausführungsbeispielen kann die Abstimmeinrichtung ausgebildet sein, um die Regelung der Phasendifferenz zwischen des in die magnetische Antenne vorlaufenden Signals 124 (z.B. vorlaufenden Leistung) und dem Phasensignal auf den vorgegebenen Sollwert hin unter Verwendung einer Regelschleife oder einer Feed-Forward-Regelung zu bewirken.

Im Folgenden wird die Funktionsweise des in Fig. 7 gezeigten Ausführungsbeispiels der Erzeugung des Abstimmsignals 122 detailliert beschrieben.

Die Transmissionsmessung eines Resonanzkreises weist an der Resonanzstelle ein Betragsmaximum und einen Phasenwendepunkt auf. Je nach Kopplungsgrad der speisenden Quelle mit dem Kreis kann dieser zwischen 90° (lose Kopplung, siehe [1]) und 0° (feste Kopplung, siehe [2] bzw. Fig. 8) liegen.

Im Detail zeigt Fig. 8 in einem Diagramm Phasengänge eines Resonanzkreises aus [1] bei geringer Dämpfung und starker Dämpfung. Dabei beschreibt in Fig. 8 die Ordinate die Phasenverschiebung in Grad und die Abszisse die Frequenz.

Der Phasengang ist eine monoton steigende arctan-Funktion, die von einem Wert $\varphi 0$ (bei $f = 0$) bis zu einem Wert $\varphi 0 + 180°$ (bei $f \rightarrow \infty$) verläuft (siehe Fig. 8). Der Wert bei Resonanz ist dann $\varphi R = \varphi 0 + 90°$ und ist ein Wendepunkt. Bisweilen wird die Phase mit negativem Vorzeichen gezählt, dann gilt obenstehendes entsprechend (aus monoton steigend wird monoton fallend usw., (siehe [2]).

Ausführungsbeispiele nutzen diesen Sachverhalt für eine automatische Frequenznachregelung aus, indem die Phasenlage des in die Schleife 108 (engl. loop) vorlaufenden Signals 124 (z.B. vorlaufenden Leistung) mit einer z.B. über eine kleine Koppelschleife 128 von der Schleife 108 induktiv ausgekoppelten Leistung verglichen wird.

Zur Ermittlung der Phasenlage des vorlaufenden Signals 124 (z.B. vorlaufenden Leistung) kann beispielsweise ein Richtkoppler herangezogen werden. Zudem entsteht über unterschiedliche Leitungslängen bis zu dem Ort, wo der Phasenvergleicher auf der Platine angeordnet ist, ein weiterer Phasenversatz. Bei manchen Ausführungsbeispielen wird daher in eine der beiden zum Phasenvergleicher laufenden Leitungen einen Phasenschieber $\Delta\varphi 0$ eingefügt, sodass bei Resonanz dort die beiden Signale genau eine Phasendifferenz von z.B. 90° aufweisen.

Phasenvergleicher sind aus der Literatur hinreichend bekannt. Die dafür häufig eingesetzte Gilbert-Zelle (siehe [4]) wirkt im Prinzip wie ein Multiplizierer. Zwei sinusförmige Zeitsignale mit um $\Delta\varphi$ von 90° abweichender Phasenverschiebung ergeben nach Multiplikation folgendes Ausgangssignal:

$$\sin(\omega t + \Delta\varphi)\cos(\omega t) = \frac{1}{2}[\sin(\Delta\varphi) + \sin(2\omega t + \Delta\varphi)]$$

(die Amplituden sind hier der Einfachheit halber auf 1 normiert). Der Anteil mit der doppelten Frequenz $2\omega t$ lässt sich leicht mit einem Tiefpass ausblenden, so dass der Gleichanteil $\sim\sin(\Delta\varphi)$ übrig bleibt. Da die Sinusfunktion eine ungerade Funktion ist, resultiert also eine Regelgröße, die um den Arbeitspunkt 90° herum ihr Vorzeichen wechselt und nur bei exakt 90° Null ergibt. Bei vorzeichenrichtig geschlossener Regelschleife wird die Resonanzfrequenz der Schleife 108 also aufgrund der quasi unendliche hohen Regelverstärkung so lange nachgeregelt, bis die Spannung am Multipliziererausgang verschwindet, was gleichbedeutend damit ist, dass die beiden Spannungen am Multiplizierereingang 90° Phasenverschiebung aufweisen. Nach den obigen Ausführungen ist die Schleife 108 bei der eingespeisten Frequenz dann in Resonanz. Fig. 9 zeigt ein Blockschaltbild der beschriebenen Anordnung. Der Phasenschieber ist hier im Auskoppelpfad des Richtkopplers eingezeichnet. Wie schon erwähnt, kann er auch im Pfad der Koppelschleife eingeschleift sein. Dies kann vorzugsweise so gewählt werden, dass die jeweils kleinere Phasenverschiebung benötigt wird.

Im Detail zeigt Fig. 9 ein schematisches Blockschaltbild einer Antennenanordnung 108, gemäß einem Ausführungsbeispiel der vorliegenden Erfindung. Die Antennenanordnung 108 umfasst die magnetische Antenne 106 und die Abstimmeinrichtung 120.

Wie in Fig. 9 gezeigt ist, kann die Abstimmeinrichtung 120 ausgebildet sein, um von dem in die magnetische Antenne 106 vorlaufenden Signal 124 (z.B. vorlaufenden Leistung) ein Signal abzuleiten (z.B. abzuzweigen), um ein abgeleitetes (z.B. abgezweigtes) Signal 132 zu erhalten. Die Abstimmeinrichtung 120 kann dabei ausgebildet sein, um das Abstimmsignal 122 zur Abstimmung der magnetischen Antenne 106 in Abhängigkeit von einer Phasenbeziehung zwischen dem abgeleiteten Signal 132 und dem Phasensignal 126 bereitzustellen.

Beispielsweise kann die Abstimmeinrichtung 120 ausgebildet sein, um das Abstimmelement 111 mit dem Abstimmsignal 122 anzusteuern, um die Phasendifferenz zwischen dem abgeleiteten Signal 132 und dem Phasensignal 126 auf einen vorgegebenen Sollwert hin zu regeln.

Bei Ausführungsbeispielen kann die Abstimmeinrichtung 120 ferner einen Signalkombinierer 136 (z.B. Multiplizierer oder Subtrahierer) aufweisen, der ausgebildet ist, um (1) das Phasensignal 126 oder eine phasenverschobene Version des Phasensignals, und (2) das abgeleitete Signal 132 oder eine phasenverschobene Version 138 des abgeleiteten Signals 132, zu kombinieren, um ein kombiniertes Signal 140 zu erhalten. Die Abstimmeinrichtung 120 kann dabei ausgebildet sein, um das Abstimmelement 111 mit dem Abstimmsignal 122 anzusteuern, um (1) einen Gleichanteil des kombinierten Signals 140 oder (2) eine tiefpassgefilterte Version 146 des kombinierten Signals 140 auf einen vorgegebenen Sollwert hin zu regeln.

Bei Ausführungsbeispielen kann die Abstimmeinrichtung 120 ferner einen Phasenschieber 134 aufweisen, der ausgebildet sein kann, um eines aus dem abgeleiteten Signal 132 und dem Phasensignal 126 phasenzuverschieben, um ein phasenverschobenes Signal 138 zu erhalten. Der Signalkombinierer (z.B. Multiplizierer oder Subtrahierer) 136 kann ausgebildet sein kann, um das phasenverschobene Signal 138 und das andere aus dem abgeleiteten Signal 132 und dem Phasensignal 126 zu kombinieren, um ein kombiniertes Signal 140 zu erhalten. Der Phasenschieber 134 kann dabei ausgebildet sein, um das eine aus dem abgeleiteten Signal 132 oder dem Phasensignal 126 derart phasenzuverschieben, dass, im Resonanzfall der magnetischen Antenne 106, das phasenverschobene Signal 138 und das andere aus dem abgeleiteten Signal 132 und dem Phasensignal 126 am Signalkombinierer 136 eine vordefinierte Phasendifferenz (z.B. 90° $\pm$ 3° oder $\pm$ 1° oder 0,1°) aufweisen.

In dem in Fig. 9 gezeigten Ausführungsbeispiel ist der Phasenschieber 134 beispielhaft ausgebildet, um das abgeleitete Signal 132 phasenzuverschieben, um das phasenverschobene Signal 138 zu erhalten, wobei der Signalkombinierer 136 in diesem Fall ausgebildet sein kann, um das phasenverschobene Signal 138 und das Phasensignal 126 zu kombinieren, um das kombinierte Signal 140 zu erhalten. Gemäß einem anderen Ausführungsbeispiel kann der Phasenschieber 134 ausgebildet sein, um das Phasensignal 126 phasenzuverschieben, um das phasenverschobene Signal 138 zu erhalten, wobei der Signalkombinierer 136 in diesem Fall ausgebildet sein kann, um das phasenverschobene Signal 138 und das abgeleitete Signal 132 zu kombinieren, um das kombinierte Signal 140 zu erhalten.

Bei Ausführungsbeispielen kann die Abstimmeinrichtung ferner einen Energieauskoppler 130 (z.B. einen Richtkoppler oder eine andere Vorrichtung zum Auskoppeln von Energie) aufweisen, der ausgebildet sein kann, um einen Teil des in die magnetische Antenne 106 vorlaufenden Signals 124 (z.B. vorlaufenden Leistung) auszukoppeln, um das abgeleitete Signal 132 zu erhalten.

Bei Ausführungsbeispielen kann die Abstimmeinrichtung 120 ferner einen Regelverstärker 144 aufweisen, der ausgebildet ist, um das Abstimmsignal 122 (z.B. Steuersignal) zur Abstimmung der magnetischen Antenne 106 bereitzustellen, wobei der Regelverstärker 144 ausgebildet sein kann, um das Abstimmelement 111 mit dem Abstimmsignal 122 anzusteuern, um (1) einen Gleichanteil des kombinierten Signals 140 oder (2) eine tiefpassgefilterte Version 146 des kombinierten Signals 140 auf einen vorgegebenen Sollwert hin zu regeln.

Bei Ausführungsbeispielen kann die Abstimmeinrichtung 120 ferner einen Tiefpassfilter 142 aufweisen, der ausgebildet sein kann, um das kombinierte Signal 140 tiefpasszufiltern, um ein tiefpassgefiltertes Signal 146 zu erhalten, das den Gleichanteil des kombinierten Signals 140 aufweist.

Mit anderen Worten, Fig. 9 zeigt ein Blockschaltbild zur automatischen Frequenzregelung unter Auswertung der transmittierten Phase. Der Regelverstärker 144 kann im Allgemeinen als I-Regler oder PI-Regler ausgeführt sein. Insbesondere bei Frequency-Hopping-Systemen [6] ist darauf zu achten, dass dessen Einschwingzeit kurz genug ist. Dies lässt sich durch Wahl einer entsprechend kurzen Regelzeitkonstante (z.B. $\leq$10 $\mu$s) erreichen.

Für den in Fig. 9 gezeigten Richtkoppler 130 sind in der Literatur diverse Ausführungen bekannt. Eine davon ist in [5, Seite 88, Bild 7.3] in einer speziellen Ausführungsform zu finden. Sie ist hier in Fig. 10a in allgemeiner Form dargestellt.

Im Detail zeigt Fig. 10a ein schematisches Blockschaltbild eines herkömmlichen Richtkopplers 130. Der Richtkoppler 130 umfasst einen ersten Anschluss 150, einen zweiten Anschluss 151, einen dritten Anschluss 152 und einen vierten Anschluss 153. Ferner umfasst der Richtkoppler 130 einen ersten Widerstand 154 (z.B. der Größe Z0/N), der zwischen dem ersten Anschluss 150 und dem zweiten Anschluss 151 geschaltet ist, und einen zweiten Widerstand 155 der zwischen einem Zwischenknoten zwischen zwei Transformatoren 157_1 und 157_2 und Masse geschaltet ist. Der erste Transformator 157_1 umfasst eine erste Spule 158_1, die zwischen dem ersten Anschluss 150 und dem dritten Anschluss 152 geschaltet ist, und eine zweite Spule 159_1, die zwischen dem Zwischenknoten und Masse geschaltet ist. Der zweite Transformator 157_2 umfasst eine erste Spule 158_2, die zwischen dem zweiten Anschluss 151 und dem vierten Anschluss 153 geschaltet ist, und eine zweite Spule 159_2, die zwischen dem Zwischenknoten und Masse geschaltet ist.

Im Gegensatz zu dem in Fig. 10a gezeigten Richtkoppler 130 mit zwei Transformatoren, schaffen Ausführungsbeispiele der vorliegenden Erfindung einen Richtkoppler 130 mit nur einem Transformator (reduzierter Übertrageranzahl). Ausführungsbeispiele des Richtkopplers 130 mit nur einem Transformator sind in den Fig. 10b und 10c gezeigt.

Fig. 10b zeigt ein schematisches Blockschaltbild eines Richtkopplers 130, gemäß einem Ausführungsbeispiel der vorliegenden Erfindung. Der Richtkoppler 130 umfasst einen ersten Anschluss 150, einen zweiten Anschluss 151, einen dritten Anschluss 152 und einen vierten Anschluss 153. Ferner umfasst der Richtkoppler 130 einen ersten Widerstand 154 (z.B. der Größe Z0/N), der zwischen dem ersten Anschluss 150 und dem zweiten Anschluss 151 geschaltet ist, einen zweiten Widerstand 155 (z.B. der Größe 2N*Z0), der zwischen dem ersten Anschluss 150 und dem dritten Anschluss 152 geschaltet ist, und einen dritten Widerstand 156 (z.B. der Größe 2N*Z0), der zwischen dem zweiten Anschluss 151 und dem vierten Anschluss 153 geschaltet ist. Ferner umfasst der Richtkoppler 130 einen Transformator 157, wobei eine erste Spule 158 des Transformators 157 zwischen dem ersten Anschluss 150 und dem dritten Anschluss 152 geschaltet ist, und wobei eine zweite Spule 159 des Transformators 157 zwischen dem zweiten Anschluss 151 und dem vierten Anschluss 153 geschaltet ist. Die erste Spule 158 und die zweite Spule 159 können dabei die gleiche Anzahl an Wicklungen aufweisen.

Fig. 10c zeigt ein schematisches Blockschaltbild eines Richtkopplers 130, gemäß einem Ausführungsbeispiel der vorliegenden Erfindung. Der Richtkoppler 130 umfasst einen ersten Anschluss 150, einen zweiten Anschluss 151, einen dritten Anschluss 152 und einen vierten Anschluss 153. Ferner umfasst der Richtkoppler 130 einen ersten Widerstand 154 (z.B. der Größe Z0/N), der zwischen dem ersten Anschluss 150 und dem zweiten Anschluss 151 geschaltet ist, einen zweiten Widerstand 155 (z. B. der Größe 2N*Z0), der zwischen dem ersten Anschluss 150 und dem dritten Anschluss 152 geschaltet ist, und einen dritten Widerstand 156 (z.B. der Größe 2N*Z0), der zwischen dem zweiten Anschluss 151 und dem vierten Anschluss 153 geschaltet ist. Ferner umfasst der Richtkoppler 130 einen Transformator 157, wobei eine erste Spule 158 des Transformators 157 zwischen dem ersten Anschluss 150 und dem zweiten Anschluss 151 geschaltet ist, und wobei eine zweite Spule 159 des Transformators 157 zwischen dem dritten Anschluss 152 und dem vierten Anschluss 153 geschaltet ist. Die erste Spule 158 und die zweite Spule 159 können dabei die gleiche Anzahl an Wicklungen aufweisen.

Der in Fig. 10b gezeigte Richtkoppler 130 geht aus dem in Fig. 10a gezeigten Richtkoppler hervor, indem die beiden festgekoppelten Übertrager 157_1 und 157_2 von Fig. 10a zu einem zusammengefasst werden und der in der Mitte befindliche Widerstand 155 der Größe N·Z_0 zu gleichen Teilen auf beide Seiten des noch verbleibenden Übertragers 157 in Fig. 10b verschoben wird, was in zwei Widerstände 155 und 156 mit dem Wert 2N·Z_0 resultiert. Da Widerstände im Vergleich zu Transformatoren weder von den Kosten noch vom Volumen ins Gewicht fallen ist dieser minimale Mehraufwand irrelevant. Tatsächlich kann die Verschiebung des inneren Widerstandes auch zu ungleichen Teilen erfolgen, solange der Wert einer gedachten Parallelschaltung dieser beiden Widerstände immer den Wert N·Z_0 ergibt. Im Grenzfall würde also auch nur ein Widerstand mit dem Wert N·Z_0 genügen, der auf der linken oder rechten Seite des Übertragers 157 von Fig. 10b angebracht wäre. Allerdings haben reale Transformatoren nie 100% Koppelfaktor, so dass die streng symmetrische Version von Fig. 10b auch zu einem möglichst symmetrischen Richtkopplerverhalten führt (d.h. die beiden Ausgänge für vor- und rücklaufende Leistung haben dann bei Vor- oder Rückwärtsspeisung auch möglichst gleiche Eigenschaften).

Fig. 10c zeigt eine Abwandlung des in Fig. 10b gezeigten Richtkopplers 130, bei der der Übertrager 157 um 90° gedreht angeordnet ist. Es lässt sich zeigen, dass dies bei idealen Übertragern mit einem Übersetzungsverhältnis von 1:1 immer möglich ist, solange eine galvanische Trennung keine Rolle spielt. Beweis dazu siehe Fig. 11a und 11b.

Gegeben sei ein festgekoppelter (k = 100%) Übertrager mit dem Übersetzungsverhältnis 1:1 und unendlich hoher Hauptinduktivität (idealer Trafo). Er sei wie in Fig. 11a in einem Netzwerk eingebunden, wo an drei Knoten die auf Masse bezogenen Spannungen $U_1$, $U_2$ und $U_3$ vorliegen mögen. Die Spannung $U_4$ ist nun nicht mehr frei wählbar, denn sie unterliegt aufgrund des Schaltungszwangs $U_{prim} = U_{sek}$ der Bedingung

$$U_4 = U_3 - U_{sek} = U_3 - (U_1 - U_2) = U_2 + U_3 - U_1$$

Wenn es nicht auf eine galvanische Trennung ankommt (und nur dann!) kann der Übertrager auch um 90° gedreht werden, wie dies in Fig. 11b gezeigt ist. Auch hier seien vom Netzwerk die Potenziale $U_1$, $U_2$ und $U_3$ in gleicher Weise vorgegeben. Nun sei $U_{prim} = U_1 - U_3$. Wegen $U_{prim} = U_{sek} = U_2 - U_4$ muss für $U_4$ also gelten:

$$U_4 = -U_{prim} + U_2 = U_2 - (U_1 - U_3) = U_2 + U_3 - U_1$$

Die vierte per Schaltungszwang festgelegte Spannung ergibt also in beiden Fällen den gleichen Wert, somit sind die Netzwerke äquivalent. qed.

Da nun aber reale Übertrager nichtideal sind, d.h. die Hauptinduktivität ist nicht unendlich groß, die Streuinduktivität ist nicht Null und der Koppelfaktor ist kleiner als 100%, kann je nach vorhandenem Übertrager und beabsichtigten Frequenzbereich die Version aus Fig. 10b oder Fig. 10c bessere Ergebnisse liefern.

Bei Ausführungsbeispielen erfolgt eine Auswertung der Phasenlage des in die magnetische Schleife 108 (engl. magnetic Loop) vorlaufenden Signals 124 (z.B. vorlaufenden Leistung), beispielsweise mittels eines Vergleichs zwischen der Phasenlage des in die magnetische Schleife 108 vorlaufenden Signals 124 (z.B. vorlaufenden Leistung) mit der z.B. über eine kleine Koppelschleife 128 von der Schleife 108 induktiv ausgekoppelten Leistung.

Da die Abstimmrichtung durch diese Methode der Phasenauswertung bekannt ist (im Verfahren im nächsten Abschnitt ist die Richtung, in die abgestimmt werden muss, nicht bekannt), ist eine sehr schnelle Nachführung der Resonanz möglich, dadurch ist bei Frequency-Hopping-Systemen eine Abstimmung pro Hop möglich, magnetische Antennen können somit für Frequency-Hopping-Systeme oder für Telegram-Splitting-Systeme [6] und [7] verwendet werden.

Ausführungsbeispiele schaffen eine Richtkopplerversion mit reduzierter Übertrageranzahl.

<u>2.2. Erzeugung einer Abstimminformation / Anpassinformation durch Amplitudenauswertung bei Selbstempfang</u>

Fig. 12 zeigt ein schematisches Blockschaltbild einer Antennenanordnung 104, gemäß einem Ausführungsbeispiel der vorliegenden Erfindung. Die Antennenanordnung 104 umfasst die magnetische Antenne 106 mit dem Abstimmelement 111 und die Abstimmeinrichtung 120 zur Abstimmung der magnetischen Antenne 106.

Die Abstimmeinrichtung 120 ist ausgebildet, um das Abstimmsignal 122 (z.B. Abstimmspannung) zur Abstimmung der magnetischen Antenne 106 in Abhängigkeit einer Amplitude eines Signals 160, das auf einem durch die Schleife 108 bzw. durch die magnetische Antenne 106 erzeugten Magnetfeld (z.B. im Nahfeld) basiert, bereitzustellen, und um das Abstimmelement 111 mit dem Abstimmsignal 122 anzusteuern, um die magnetische Antenne 106 abzustimmen.

Bei Ausführungsbeispielen kann die Antennenanordnung 104 eine Induktionsschleife 162 (oder Induktionsspule) aufweisen, die ausgebildet ist, um das Signal 160, das auf dem durch die Schleife erzeugten Magnetfeld basiert, bereitzustellen. Die Schleife 108 der magnetischen Antenne 106 und die Induktionsschleife 162 (oder Induktionsspule) können auf derselben Leiterplatte angeordnet (z.B. implementiert) sein.

Bei Ausführungsbeispielen kann die Abstimmreinrichtung 120 ausgebildet sein, um das Abstimmelement 111 mit dem Abstimmsignal 122 anzusteuern, dass um die Amplitude des Signals 160 auf einen vorgegebenen Sollwert hin zu regeln, beispielsweise derart, dass die Amplitude größer oder gleich dem vorgegebenen (z.B. vordefinierten) Sollwert (z.B. Referenzwert) ist.

Beispielsweise kann die Abstimmeinrichtung 120 ausgebildet sein, um durch Ansteuerung des Abstimmelements 111 mit dem Abstimmsignal 122 (z.B. Steuersignal) die Amplitude des Signals, das auf dem durch die Schleife erzeugten Magnetfeld basiert, auf den vorgegebenen Sollwert hin zu regeln.

Zum Beispiel kann die Abstimmeinrichtung 120 ausgebildet sein, um das Abstimmsignal 122 (z.B. Steuersignal) nachzuführen, um einer Abweichung der Amplitude des Signals, das auf dem durch die Schleife erzeugten Magnetfeld basiert, von dem vorgegebenen Sollwert entgegenzuwirken.

Der vorgegebene Sollwert kann im Vorfeld (z.B. bei einer werkseitigen Kalibrierung) durch eine Referenzmessung im ungestörten Fall der magnetischen Antenne 106 und/oder im Resonanzfall der magnetischen Antenne 106 ermittelt werden.

Ferner oder alternativ kann die Abstimmeinrichtung ausgebildet sein, um den vorgegebenen Sollwert durch eine Referenzmessung im ungestörten Fall der magnetischen Antenne 106 und/oder im Resonanzfall der magnetischen Antenne 106 zu ermitteln.

Bei der Referenzmessung kann ein vorgegebenes Signal mit der magnetischen Antenne 106 ausgesendet werden. Beispielsweise kann das vorgegebene Signal eine vorgegebene Signalform, vorgegebene Sendefrequenz, vorgegebene Bandbreite, vorgegebene Amplitude und/oder vorgegebene Modulationsart aufweisen. Beispielsweise kann das vorgegebene Signal ein Sinussignal mit einer normierten Sendespannung sein.

Bei magnetischen Empfangsantennen wird in der Regel auf maximalen Empfangspegel abgestimmt (Resonanzfrequenz) bzw. angepasst (Leistungsanspassung). Bei magnetischen Sendeantennen auf maximale Abstrahlleistung. Die Abstimminformation bzw. Anpassinformation kann, wie nachfolgend in den Abschnitten 2.2.1. und 2.2.2. detailliert beschrieben wird, erhalten werden, womit die Abstimmung bzw. Anpassung der magnetischen Antenne 106 bei Ausführungsbeispielen auch automatisch nachführbar ist.

Im Folgenden wird für eine magnetische Sendeantenne ein detailliertes Ausführungsbeispiel zur Ermittlung einer Regelgröße durch Selbstempfang beschrieben.

2.2.1. Seibstempfang

Um eine messtechnisch erfassbare Größe zu erhalten, welche eine Aussage über die Anpassung der magnetischen Antenne 106 gibt, kann bei Ausführungsbeispielen eine kleine Induktionsschleife 162 oder eine kleine SMD Spule 162 neben der eigentlichen magnetischen Antenne 106 auf der Leiterplatte platziert werden. Für den Fall, dass die magnetische Antenne 106 gut angepasst ist, wird in dieser Schleife 162 eine Spannung mit einer bestimmten Amplitude induziert. Wenn anschließend die magnetische Antenne 106 bei der geforderten Frequenz durch einen Körper in der Nähe nicht mehr resonant und angepasst ist, verringert sich die Amplitude der induzierten Spannung. Dieser Spannungsunterschied kann anschließend entsprechend detektiert werden. Nach Abgriff und Gleichrichtung kann daraus z.B. eine analoge Regelgröße gewonnen werden oder durch AlD Wandlung eine entsprechende digitale Regelung aufgebaut werden.

Werden verschiedene Materialen in die Nähe der magnetischen Antenne 106 gebracht so lässt sich der Einfluss der Materialien auf die Antenneneigenschaften entsprechend qualitativ anhand der induzierten Messspannung bewerten. Als Referenz dient ein im ungestörten Fall ermittelter Wert mit normierter Sendespannung. Diese Referenzmessung kann im Einsatzfall auch durch Aussenden eines Sinustones auf einer oder mehrerer Frequenzen durch die magnetische Sendeantenne 106 und Empfang an der Induktionsschleife 162 wiederholt werden. Dadurch ist ein Nachmessen und Überprüfen der Resonanzkurve der verbauten magnetischen Antenne 106 am Einsatzort möglich. Wird die gewonnene Induktionsschleife 162 z.B. nach Gleichrichtung und A/D Wandlung beispielsweise in einem Mikrocontroller mit entsprechenden Tabellen oder Richtwerten verglichen, so können damit Strategien zur Optimierung der Antenneneigenschaften (Nachstimmen, Anpassen) speziell für die aktuelle Einsatzsituation umgesetzt werden.

Bei Ausführungsbeispielen erfolgt somit eine Erzeugung eines Abstimmsignals (z.B. von Abstimminformation bzw. Anpassinformation) durch Selbstempfang.

Bei Ausführungsbeispielen kann hierzu eine kleine Induktionsschleife 162 oder eine kleine SMD Spule 160 auf der gleichen (oder derselben) Leiterplatte (engl. printed circuit board (PCB)) wie die magnetische Sendeantenne 106 platziert werden.

Bei Ausführungsbeispielen kann aus der Empfangsleistung der Induktionsschleife 162 bzw. der SMD Spule 162 eine Aussage über die Abstimmung bzw. Anpassung erzeugt werden, beispielsweise durch einen Vergleich mit einer abgelegten Kalibrierinformation.

2.2.2. Abstimmrichtung bzw. Anpassungsrichtung durch senden auf mehreren Frequenzen

In Abschnitt 2.2.1. wurde aufgezeigt, wie der Grad der aktuellen Abstimmung bzw. Anpassung gemessen werden kann.

Nach einmaligem Erfassen einer oder mehrerer Größen kann allerdings nicht eindeutig festgestellt werden, in welche Richtung die (magnetische) Antenne 106 verstimmt bzw. falsch angepasst ist. Also ob aktuell für eine zu hohe oder zu niedrige Frequenz abgestimmt ist bzw. zu induktiv oder kapazitiv abgepasst ist. Normalerweise würde in einem Kalibrierschritt häufiger gesendet, jedes Mal gemessen und die Anpassung der magnetischen Antenne 106 verändert werden, bis ein Sollwert bzw. Sollwertbereich (z.B. Optimum) erreicht ist.

Dieses Problem kann gelöst werden, indem auf verschieden Frequenzen gesendet wird und dabei eine oder mehrere Messgrößen erfasst werden. Mithilfe dieser Information kann eine Messkurve erzeugt werden, die die Anpassung über die Frequenz darstellt (oder es wird der beste Punkt ausgewählt).

Bei Ausführungsbeispielen kann eine Ausstrahlung eines "Kalibriertones" oder eines Sendesignals auf mehreren Frequenzen erfolgen.

Bei Ausführungsbeispielen kann eine Messung einer Selbstempfangsleistung auf mehreren Frequenzen erfolgen.

Bei Ausführungsbeispielen kann eine Generierung der "Abstimmrichtung bzw. Anpassungsrichtung" durch Auswertung des Verlaufs der Empfangsleistung auf den verschiedenen Frequenzen erfolgen.

2.3. Abstimmung durch Messung des Leistungs- oder Stromverbrauches der Sendeeinrichtung (Sende-ICs)

Eine Antenne 106 ist dann am besten abgestimmt, wenn keine Leistung reflektiert ($P_{reflekt}$) wird, bzw. das Verhältnis der in die Antenne 106 transmittierten Leistung ($P_{aus}$) zur reflektierten Leistung ($P_{reflekt}$) maximal wird. Unter Anpassung versteht man sowohl die Anpassung an eine gewünschte Impedanz, als auch eine Abstimmung auf die gewünschte Sendefrequenz. Durch ein Anpass Netzwerk (engl. Matching Network) kann die Impedanz verändert werden. Dies verändert die Angepasste-Frequenz der Antenne und die Effizienz der Verstärker. Bei magnetischen Antennen werden die Empfangsfrequenz und die Anpassung gleichermaßen verstimmt. Dies kann z.B. durch umschalten von Kondensatoren erfolgen. Bei elektrischen Antennen kann z.B. durch Schalter die elektrische Länge und so die Frequenz verstimmt werden. In diesem Kapitel wird beschrieben, wie ein Abstimmsignal zur Reduktion der reflektierten Leistung bestimmt werden kann.

2.3.1. Messaufbau

Zur Bestimmung der Leistung, die in die Antenne 170 hinein bzw. herausgeht, können beispielsweise ein Richtkoppler 172 und zwei Powermeter 174 und 176 verwendet werden, wie dies in Fig. 13 gezeigt ist.

Mithilfe des in Fig. 14 gezeigten Messaufbaus konnte gezeigt werden, dass bei typischen Sendeeinrichtungen 102 (z.B. Senderschaltkreisen), wie sie z.B. für drahtlose Sensorknoten verwendet werden, der Eingangsstrom sich je nach Antennenanpassung ändert. Der Messaufbau umfasst ein Amperemeter 178, das den Eingangsstrom der Sendeeinrichtung 102 (z.B. Sendeschaltung) misst, ein Powermeter 180, das die Ausgangsleistung misst, und einen koaxialen Tuner 182.

Mit dem koaxialen Tuner 182 können für die benötigte Frequenz alle gewünschten Impedanzen nachgebildet werden. Um dies zu bewerkstelligen kann der Tuner 182 beispielsweise mit Hilfe eines Vector Netzwerkanalysators (VNA) kalibriert und anschließend mit dem Testobjekt verbunden werden.

Mit dem in Fig. 14 gezeigten Messaufbau kann der aufgenommene Strom der Sendeeinrichtung 102 (z.B. Sendesystem) und die abgegebene Sendeleistung für alle eingestellten komplexen Impedanzen ermittelt werden. Wie in Fig. 14 gezeigt ist, kann nun die Sendeeinrichtung 102 (z.B. Frontend) vermessen werden und der Verlauf zwischen Ausgangsleistung und Eingangsstrom abgetragen werden.

Daraus können zwei 3D Graphen erzeugt werden, die den Eingangsstrom und die Ausgangsleistung über der Antennenimpedanz zeigen, wie dies in den Fig. 15 und Fig. 16 dargestellt ist.

Im Detail zeigt Fig. 15 in einem Smith-Diagramm die Stromaufnahme der Sendeeinrichtung 102 aufgetragen über die Antennenimpedanz. Der untere Bereich des Smith-Diagramms zeigt dabei eine höhere Stromaufnahme, während der obere Bereich des Smith-Diagramms eine niedrigere Stromaufnahme zeigt. In der Mitte des Smith-Diagramms bei 50 Ohm nimmt die Sendeeinrichtung 102 ca. 100 mA auf.

Fig. 16 zeigt in einem Smith-Diagramm die Ausgangsleistung aufgetragen über der Antennenimpedanz. Der mittlere Bereich des Smith-Charts zeigt dabei eine Ausgangsleistung von ca. 18 dBm, wobei die Leistung zum Rande des Smith-Diagramms absinkt.

Wird nun der Impedanz- und Leistungsverlauf schematisch über den Eingangsstrom (der Sendeeinrichtung 102) aufgetragen, ergeben sich Verläufe wie in Fig. 17a, Fig. 17b und Fig. 18 gezeigt.

Im Detail zeigt Fig. 17a in einem Diagramm einen Verlauf eines Realteils R und eines Imaginärteils X der Antennenimpedanz aufgetragen über den Eingangsstrom der Sendeeinrichtung 102. Dabei beschreibt die Ordinate die Impedanz in Ohm und die Abszisse den Eingangsstrom der Sendeeinrichtung 102 in mA.

Fig. 17b zeigt in einem Diagramm einen Verlauf der Ausgangsleistung aufgetragen über den Eingangsstrom der Sendeeinrichtung 102. Dabei Beschreibt die Ordinate die Leistung und die Abszisse den Eingangsstrom der Sendeeinrichtung 102 in mA.

Fig. 18 zeigt in einem Diagramm einen Verlauf eines Realteils R und eines Imaginärteils X der Antennenimpedanz sowie einen Verlauf der Ausgangsleistung aufgetragen über den Eingangsstrom der Sendeeinrichtung 102. Dabei beschreibt in Fig. 18 die Ordinate die Impedanz in Ohm bzw. die Leistung in dBm und die Abszisse den Eingangsstrom der Sendeeinrichtung 102 in mA.

Es ergibt sich, dass der Imaginärteil X streng monoton steigend mit dem Eingangsstrom (der Sendeeinrichtung 102) ist. Von den Messpunkten "Kurzschluss" bis "offen", wie in Fig. 17a dargestellt, nimmt der Eingangsstrom (der Sendeeinrichtung 102) stetig zu. Der Verlauf der Ausgangsleistung über den Eingangsstrom zeigt, dass ein Eingangsstrom von ca. 100 mA mit der maximalen Ausgangsleistung korrespondiert (Pout über Iin). Dies ist bei dem Messpunkt (50 + 0j) Ohm.

Der Messaufbau zeigt somit, dass es möglich ist, über eine Messung des Eingangsstroms (der Sendeeinrichtung 102) eine Aussage über die Qualität der Antennenanpassung zu treffen.

2.3.2. Erzeugung des Abstimmsignals in Abhängigkeit von einer Leistungs- oder Stromaufnahme der Sendeeinrichtung

Fig. 19 zeigt ein schematisches Blockschaltbild einer Antennenanordnung 104, gemäß einem Ausführungsbeispiel der vorliegenden Erfindung. Die Antennenanordnung 104 umfasst eine Antenne 106 mit einem Abstimmelement 111, und die Abstimmeinrichtung 120 zur Abstimmung der Antenne 106. Die Abstimmeinrichtung 120 ist ausgebildet, um das Abstimmsignal 122 zur Abstimmung der Antenne 106 in Abhängigkeit von einer Leistungs- oder Stromaufnahme einer mit der Antenne 106 verbundenen Sendeeinrichtung 102 bereitzustellen, und um das Abstimmelement 111 mit dem Abstimmsignal 122 anzusteuern, um die Antenne 106 abzustimmen.

Wie in Fig. 19 gezeigt ist, kann die Antenne 106 bei Ausführungsbeispielen eine magnetische Antenne 106 mit einer einfach oder mehrfach unterbrochenen Schleife 108 sein. Bei Ausführungsbeispielen kann die Antenne 106 jedoch auch eine elektrische Antenne sein.

In der nachfolgenden Beschreibung wird beispielhaft davon ausgegangen, dass die Antenne 106 eine magnetische Antenne ist. Es sei jedoch darauf hingewiesen, dass die nachfolgend beschriebenen Ausführungsbeispiele hinsichtlich der Abstimmung der Antenne in Abhängigkeit von einer Leistungs- oder Stromaufnahme der mit der Antenne 106 verbundenen Sendeeinrichtung 102 bzw. von einer Leistungs- oder Stromaufnahme eines aktiven Bauelements der Sendeeinrichtung auch auf eine elektrische Antenne anwendbar sind.

Bei Ausführungsbeispielen kann die Stromaufnahme der Sendeeinrichtung z.B. mittels eines Strommessers 186 (z.B. Amperemeters) ermittelt werden. Anstelle der Stromaufnahme kann auch die Leistungsaufnahme der Sendeeinrichtung 102 ermittelt werden, beispielsweise mittels eines Leistungsmessers (z.B. Powermeters).

Bei Ausführungsbeispielen kann die Abstimmeinrichtung 102 ausgebildet sein, um das Abstimmelement 111 mit dem Abstimmsignal 122 anzusteuern, um die Leistungs- oder Stromaufnahme der Sendeinrichtung 102 auf einen vorgegebenen (z.B. vordefinierten) Sollwertebereich hin zu regeln.

Beispielsweise kann die Abstimmeinrichtung 120 ausgebildet sein, um durch Ansteuerung des Abstimmelements 111 mit dem Abstimmsignal 122 (z.B. Steuersignal) die Leistungs- oder Stromaufnahme der Sendeinrichtung 102 auf den vorgegebenen Sollwertebereich hin zu regeln.

Zum Beispiel kann die Abstimmeinrichtung 120 ausgebildet sein, um das Abstimmsignal 122 (z.B. Steuersignal) nachzuführen, um einer Abweichung der Leistungs- oder Stromaufnahme der Sendeinrichtung 102 von dem vorgegebenen Wertebereich entgegenzuwirken.

Der vorgegebene Sollwerteberich (z.B. vordefinierte Wertebereich) kann beispielsweise

- durch eine Systemsimulation unter Annahme einer idealen oder nahezu idealen Anpassung der magnetischen Antenne,
- bei Abschluss der Sendeeinrichtung 102 mit einer vordefinierten Impedanz (z.B. 50 Ohm),
- basierend auf einer Antennenmessung (z.B. mittels eines Antennentuners),
- basierend auf einem Mittelwert der Leistungs- oder Stromaufnahme bei kurzgeschlossenem Abschluss und offenem Abschluss der Sendeeinrichtung 102,
- basierend auf einer Messung einer Abstrahlungsleistung,

ermittelt werden.

Fig. 20 zeigt einen Messaufbau zum Bestimmen der idealen Antennenanpassung, gemäß einem Ausführungsbeispiel der vorliegenden Erfindung. Der Messaufbau umfasst eine Sendeeinrichtung 102, eine magnetische Antenne 106 mit dem Abstimmelement 111, ein Anpassungsnetzwerk 113 zwischen der Sendeinrichtung 102 und der magnetischen Antenne 106 sowie ein Amperemeter 186 zur Messung der Stromaufnahme der Sendeeinrichtung 102, wobei das Abstimmsignal 122 zur Abstimmung der magnetischen Antenne 106 in Abhängigkeit von der gemessenen Stromaufnahme der Sendeeinrichtung 102 erzeugt wird. Der in Fig. 20 gezeigte Messaufbau kann beispielsweise in einem Gerät, wie z.B. einem Teilnehmer 100 eines Kommunikationssystems, implementiert werden.

Wie in Fig. 20 zu erkennen ist, kann das Gerät nun im Gegensatz zum Aufbau aus Fig. 13 stark vereinfacht werden, weil anstelle eines Richtkopplers 172 und zweier Powermeter 174 und 176 bei Ausführungsbeispielen nur noch ein Amperemeter 186 erforderlich ist. Die Strommessung kann für die Abstimmung der Sendeantenne 106 genutzt werden.

Die Kalibrierung des Aufbaus kann folgende Schritte umfassen:

1. Feststellen des idealen Stromwertes, und
2. Einstellen der (magnetischen) Antenne 106.

Im nächsten Schritt kann die (magnetische) Antenne 106 auf Grundlage der kalibrierten Stromwerte angepasst werden. Im laufenden Betrieb kann die Antennenanpassung solange verändert werden, bis der gewünschte Strom (Eingangsstrom der Sendeeinrichtung) erreicht ist. Durch die monoton steigende Impedanzkurve ist nach einmaligem verstellen der (magnetischen) Antenne 106 direkt die Richtung bekannt, in der das Optimum liegt. Das Einstellen ist auch während des laufenden Betriebes möglich. Als Sendesignal kann entweder ein CW-Signal (CW = Continuous wave, dt. eine ungedämpfte, also zeitlich konstante abgestrahlte Welle) oder auch direkt das modulierte Signal z.B. G-MSK (Gaussian Minimum Shift Keying) verwendet werden.

Das Einstellen der (magnetischen) Antenne 106 ist durch ein Testsignal (CW) möglich, wobei das Nutzsignal z.B. nur bei optimierten Bedingungen gesendet wird. Durch Optimierung der Antennenanpassung wird das System in einem optimalen Wirkungsgrad betrieben. Hierdurch kann der Energiebedarf gesenkt werden.

Das genutzte Anpassungsnetzwerk kann beispielsweise N-Zustände haben, die direkt mit entsprechenden Stromwerten verknüpft werden können. Somit ist die Anpassung der (magnetischen) Antenne 106 über wenige Schritte durch eine Tabelle möglich. Dies minimiert den Programmieraufwand.

Durch Veränderung der Phase des Sendesignals kann die (magnetische) Antenne 106 zusätzlich angepasst werden.

Wenn eine Anpassung nicht möglich ist, kann das System (z.B. der Teilnehmer 100 oder die Abstimmeinrichtung 120 des Teilnehmers 100) den Sendevorgang unterbrechen und zu einem späteren Zeitpunkt die Anpassung erneut überprüfen. Hierdurch kann Energie gespart werden, da der Teilnehmer (z.B. Knoten) immer mit optimalem Wirkungsgrad sendet.

Ausführungsbeispiele haben den Vorteil der Einsparung an Hardwarekosten, da kein HF-Koppler und kein Powermeter benötigt wird.

Ausführungsbeispiele haben den Vorteil, dass keine Dämpfung der Ausgangsleistung durch den HF-Koppler erfolgt.

Ausführungsbeispiele haben den Vorteil, dass ein steigender Strom die Richtung der benötigten Anpassung angibt. Es ist keine Minimumsuche erforderlich, wodurch der Idealwert schneller gefunden werden kann.

Ausführungsbeispiele haben den Vorteil, dass, im Falle einer digitalen bzw. softwarebasierten Implementierung, diese durch eine Zuweisungstabelle einfach zu programmieren ist.

Ausführungsbeispiele haben den Vorteil, dass diese auf verschiedene Sendesysteme anwendbar sind.

Ausführungsbeispiele haben den Vorteil der Energieeffizienz.

Bei Ausführungsbeispielen kann das Gerät (z.B. der Teilnehmer 100 bzw. die Abstimmeinrichtung 120 des Teilnehmers 100) den Stromverbrauch der Sendeeinrichtung 102 (z.B. Sende-IC bzw. Sendesystem) ermitteln (z.B. messen).

Bei Ausführungsbeispielen kann das Gerät (z.B. der Teilnehmer 100) eine abstimmbare (magnetische) Antenne 106 aufweisen.

Bei Ausführungsbeispielen kann das Gerät (z.B. der Teilnehmer 100 bzw. die Abstimmeinrichtung 120 des Teilnehmers 100) die (magnetische) Antenne 106 verstimmen (ggf. Sonderfall "Kurzschluss" und "offen", 50 $\Omega$).

Bei Ausführungsbeispielen kann das Gerät (z.B. der Teilnehmer 100 bzw. die Abstimmeinrichtung 120 des Teilnehmers 100) die Strominformation verwenden, um eine ideale Antenneneinstellung zu finden (siehe Ablauf oben).

Bei Ausführungsbeispielen kann das Gerät (z.B. der Teilnehmer 100 bzw. die Abstimmeinrichtung 120 des Teilnehmers 100) die veränderbare (z.B. abstimmbare) (magnetisch) Antenne 106 durch Messung des Stromverbrauches der Sendeeinrichtung 102 (z.B. Sende-IC) abstimmen.

Bei Ausführungsbeispielen kann das Gerät (z.B. der Teilnehmer 100 bzw. die Abstimmeinrichtung 120 des Teilnehmers 100) eine Abweichung von der Anpassung durch Abweichungen der Stromaufnahme bei idealer Anpassung (50 $\Omega$) erkennen.

### 2.3.3. Charakterisierung des Systems

Um eine Aussage von dem gemessenen Eingangsstromwert (der Sendeeinrichtung 102) auf die Antennenanpassung machen zu können, können dem System (z.B. dem Teilnehmer 100 bzw. der Abstimmeinrichtung 120 des Teilnehmers 100) Informationen über die Stromaufnahme bei idealer Anpassung gegeben werden.

Der Eingangsstrom (der Sendeeinrichtung 102) kann auf unterschiedliche Arten bestimmt werden. Jede Methode kann prinzipiell in jedem Stadium durchgeführt werden.

#### 2.3.3.1. Simulation des Systems

Bei Ausführungsbeispielen kann der Eingangsstorm (der Sendeeinrichtung 102) bei idealer Anpassung (der magnetischen Antenne 106) mithilfe einer Systemsimulation z.B. in ADS ermittelt werden. Wenn hinreichend gute Modelle vorhanden sind, kann die Simulation eine Abhängigkeit von Stromverbrauch zu Anpassung der (magnetischen) Antenne 106 liefern.

#### 2.3.3.2. Messungen bei idealem Impedanz Abschluss

Bei Ausführungsbeispielen kann der gewünschte Eingangsstrom (der Sendeeinrichtung 102) mit maximaler Ausgangsleistung z.B. bei der Inbetriebnahme über Speichern des aktuellen Stromwertes bei einem 50 Ohm abgeschlossenen Ausgang gemacht werden.

#### 2.3.3.3. Einmalige Messung mit Tuner z.B. im Labor

Bei Ausführungsbeispielen kann über einen Aufbau wie in Fig. 14 mithilfe eines Antennentuners 182 jeder Punkt gemessen und die maximale Leistung gefunden werden.

2.3.3.4. Messung an jeder Hardware, z.B. Test bei Inbetriebnahme in der Fertigung

Bei Ausführungsbeispielen kann der ideale Punkt auch über Verbinden (z.B. Anschrauben) verschiedener Kalibriernormale erreicht werden. Beispielsweise kann ein 50 Ohm Abschluss verwendet werden, welcher direkt den idealen Strom angibt.

Es kann auch ein Abschluss (z.B. Stecker) mit "offenem" Ende bzw. "Kurzschluss" verwendet werden, um die Richtung des Impedanzverlaufs zu bestimmen. Der ideale Strom kann als Mittelwert zwischen den beiden (z.B. "offen" und "Kurzschluss") angenommen werden.

Es können alle der drei Kalibrierstandards ("offen", "Kurzschluss", "50 Ohm") zusammen oder einzeln genutzt werden, um eine Information über den Stromverlauf zu erhalten.

Es können auch weitere Standards abweichend von 50 Ω genutzt werden, wenn die ideale Impedanz für maximale Leistung davon abweicht.

2.3.3.5. Kalibrierung der Stromaufnahme durch Empfang mit einer Referenzantenne

Bei Ausführungsbeispielen kann zur Kalibrierung eine Funkstrecke aufgebaut werden, wobei das vom Sender mit einer (magnetischen) Antenne 106 abgestrahlte Signal durch eine weitere Antenne empfangen und die Empfangsleistung ausgewertet werden kann. Hierbei können die Abstimmelemente 111 der (magnetischen) Antenne 106 manuell verändert und die entsprechende Empfangsleistung und Stromaufnahme notiert werden. Die Stromaufnahme bei maximaler Empfangsleistung ist der Wert, auf den im Betrieb abgestimmt wird. Für eine bessere Reproduzierbarkeit kann die Messung in einer geschirmten und reflexionsarmen Umgebung, wie z.B. in Antennenmesshalle, durchgeführt werden.

2.3.3.6. Messung mit on Board Schaltung z.B. im Feld

Bei Ausführungsbeispielen können externe Kalibrierstecker auch direkt auf der Platine realisiert werden und z.B. über einen HF-Schalter umgeschaltet werden. So ist eine Ermittlung des idealen Stromes auch unter unterschiedlichen Betriebsmodi bzw. Umgebungsbedingungen, wie z.B. Temperatur (Kälte, Wärme), möglich.

2.3.3.7. Vorkenntnisse des Verlaufs der Impedanz der Antenne

Bei Ausführungsbeispielen kann durch Vorkenntnis des Impedanzverhaltens bei Verstimmung der verwendeten (magnetischen) Antenne 106 für den jeweiligen Verlauf der Impedanz eine Aussage über die ideale Stromaufnahme der Sendeeinrichtung 102 (z.B. Sendesystem) getroffen werden. Es kann eine Funktion ermittelt werden, die für die verwendete (magnetische) Antenne 106 den idealen Punkt zwischen den Fällen "Kurzschluss" und "Offen" geben kann. Dies ist nur nötig, falls der Verlauf von einer Geraden (Fall: Mitte zwischen "Kurzschluss" und "offen" ist ideal) abweicht.

2.3.3.8. Rückmeldung der ausgensendeten Leistung von einem anderen Teilnehmer

Bei Ausführungsbeispielen kann im normalen Betrieb (z.B. im Feld) das ausgesendete Signal von einem anderen Teilnehmer empfangen werden, wobei dieser an den sendenden Teilnehmer rückmelden kann, wie gut das empfangene Signal war, wodurch der sendende Teilnehmer eine Abstimmspannung erzeugen kann.

2.3.4. Vorteile und Ausführungsbeispiele

Ausführungsbeispiele haben den Vorteil, dass eine Kalibrierung des Geräts (z.B. Teilnehmers 100 bzw. der magnetischen Antenne 106) im Betrieb ("Kurzschluss", "Offen", 50 Ohm) vorgenommen werden kann.

Ausführungsbeispiele haben den Vorteil, dass das Gerät (z.B. der Teilnehmer 100 bzw. die Abstimmeinrichtung 120 des Teilnehmers 100) eine Anpassungsinformation durch vorherige Kalibrierung enthalten kann.

Ausführungsbeispiele haben den Vorteil, dass das Gerät (z.B. der Teilnehmer 100 bzw. die Abstimmeinrichtung 120 des Teilnehmers 100) eine Kalibrierung mit weniger Standards (z.B. nur "Kurzschluss" und "offen") vornehmen kann, wobei die Mitte als ideal angenommen werden kann.

Ausführungsbeispiele haben den Vorteil, dass das Gerät (z.B. der Teilnehmer 100 bzw. die Abstimmeinrichtung 120 des Teilnehmers 100) durch bekanntes Antennenverhalten die Kalibrierung vereinfachen / optimieren kann.

Bei Ausführungsbeispielen kann das Gerät (z.B. der Teilnehmer 100 bzw. die Abstimmeinrichtung 120 des Teilnehmers 100) den Stromverbrauch der Sendeeinrichtung (z.B. Sende-IC bzw. Sendesystem) messen.

Bei Ausführungsbeispielen kann das Gerät (z.B. der Teilnehmer 100) eine abstimmbare (magnetische) Antenne 106 aufweisen.

Bei Ausführungsbeispielen kann das Gerät (z.B. der Teilnehmer 100 bzw. die Abstimmeinrichtung 120 des Teilnehmers 100) die (magnetische) Antenne 106 verstimmen (ggf. Sonderfall Kurzschluss und Offen, 50 Ω).

Bei Ausführungsbeispielen kann das Gerät (z.B. der Teilnehmer 100 bzw. die Abstimmeinrichtung 120 des Teilnehmers 100) die Strominformation verwenden, um ideale Antenneneinstellung zu finden (siehe Ablauf oben).

Bei Ausführungsbeispielen kann das Gerät (z.B. der Teilnehmer 100 bzw. die Abstimmeinrichtung 120 des Teilnehmers 100) die veränderbare (z.B. abstimmbare) (magnetische) Antenne 106 durch Messung des Stromverbrauches der Sendeeinrichtung 102 (z.B. Sende-IC) abstimmen.

Bei Ausführungsbeispielen kann das Gerät (z.B. der Teilnehmer 100 bzw. die Abstimmeinrichtung 120 des Teilnehmers 100) die Anpassungsinformation durch vorherige Kalibrierung enthalten.

Bei Ausführungsbeispielen kann das Gerät (z.B. der Teilnehmer 100 bzw. die Abstimmeinrichtung 120 des Teilnehmers 100) eine Kalibrierung im Betrieb ("Kurzschluss", "Offen, "50 Ohm") vornehmen.

Bei Ausführungsbeispielen kann das Gerät (z.B. der Teilnehmer 100 bzw. die Abstimmeinrichtung 120 des Teilnehmers 100) eine Abweichung von der Anpassung durch Abweichungen der Stromaufnahme bei idealer Anpassung (50 Ω) erkennen.

Bei Ausführungsbeispielen kann das Gerät (z.B. der Teilnehmer 100 bzw. die Abstimmeinrichtung 120 des Teilnehmers 100) eine Kalibrierung z.B. im Betrieb mit weniger Standards (z.B. nur "Kurzschluss" und "offen") vornehmen, wobei die Mitte als ideal angenommen werden kann.

Bei Ausführungsbeispielen kann das Gerät (z.B. der Teilnehmer 100 bzw. die Abstimmeinrichtung 120 des Teilnehmers 100) eine Kalibrierung z.B. im Betrieb mit 50 Ohm als Referenz für eine ideale Anpassung der Antenne 106 vornehmen.

Bei Ausführungsbeispielen kann das Gerät (z.B. der Teilnehmer 100 bzw. die Abstimmeinrichtung 120 des Teilnehmers 100) eine Anpassungsinformation (Stromaufnahme) nutzen, um einen optimalen Sendezeitpunkt zu finden. Beispielsweise kann erst gesendet werden, wenn der optimale Wirkungsgrad erreicht ist.

Bei Ausführungsbeispielen kann das Gerät (z.B. der Teilnehmer 100 bzw. die Abstimmeinrichtung 120 des Teilnehmers 100) die Antennenanpassung nutzen, um Energie zu sparen.

Bei Ausführungsbeispielen kann das Gerät (z.B. der Teilnehmer 100 bzw. die Abstimmeinrichtung 120 des Teilnehmers 100) eine Phaseneinstellung nutzen, um die Antennenanpassung zu verändern.

Bei Ausführungsbeispielen kann das Gerät (z.B. der Teilnehmer 100) eine Rückmeldung über das ausgesendete Signal von einem anderen Teilnehmer im Funknetz erhalten.

## 2.4. Stromverbrauch / Sonstige Effekte einer Endstufe

In Abschnitt 2.3 wurde die Abstimmung (der magnetischen Antenne 106) durch Messung des Stromverbrauches der Sendeeinrichtung 102 (z.B. Sende-IC) beschrieben. Die Sendeeinrichtung 102 weist in der Regel einen Leistungsverstärker auf, der die zur Abstrahlung mit einer Antenne 106 nötige Sendeleistung bereitstellt.

Der Leistungsverstärker ist in der Regel aus mehreren aktiven sowie passiven elektronischen Komponenten aufgebaut. Diese können zur Erfassung von elektrischen Messgrößen genutzt werden, die Rückschlüsse auf die Antennenanpassung ermöglichen und somit zur Erzeugung des Abstimmsignals 122 (z.B. Abstimmspannung) eingesetzt werden können.

### 2.4.1. Messung des Versorgungsstroms der aktiven Bauelemente

Die Messung des Versorgungsstroms des bzw. der aktiven Bauelemente (z.B. Leistungstransistoren) des Leistungsverstärkers (der Sendeeinrichtung 102) ist äquivalent zur Messung des Stromverbrauches der Sendeeinrichtung (z.B. Sende-IC) und erlaubt eine präzisere Erfassung der Anpassungsinformation. Andere Verbraucher in der Sendeeinrichtung 102 (z.B. Sende-IC) stören die Messung nicht.

Bei zwei oder mehr aktiven Bauelementen kann über die Differenz der Versorgungsströme eine Aussage über die Anpassung getroffen werden. Beispiele wären hier Verstärker, die nach dem Balanced-, Gegentakt- (Push-Pull-) und Doherty-Verfahren aufgebaut sind. Insbesondere Gegentakt- und Doherty-Verstärker reagieren empfindlich auf rücklaufende Leistung, die sich wiederum in einem veränderten Betriebsverhalten und damit auch in den Versorgungsströmen zeigt.

### 2.4.2. Messung des Biasstroms der aktiven Bauelemente

Die direkte Messung des Stromverbrauchs ist bei höheren Leistungen durch die damit verbundenen höheren Spannungen aufwändiger (hochliegende Current-sense notwendig).

Metall-Halbleiter-Feldeffekttransistoren (MESFET) haben einen Schottky-Kontakt am Gate, der bei höheren HF-Eingangsleistungen $P_{in}$ gleichrichtend wirkt, es fließt ein Gatestrom $I_{Bias}$ (siehe Fig. 21). Über die parasitäre Gate-Drain-Kapazität ($C_{GD}$) 192 (des Transistors 194) ist dieser Gleichrichteffekt auch abhängig von der Ausgangsleistung

$P_{out}$. Falls schaltungstechnisch Zugriff auf den Gate-Anschluss besteht, kann eine Spannung $V_{meas}$ am Transistor $R_{Bias}$ in Abhängigkeit des Gatestroms abgegriffen werden; diese Spannung ist bei gegebener Eingangsleistung $P_{in}$ abhängig von der Ausgangsleistung $P_{out}$ und somit der Anpassung der Last. Es besteht somit über die Messspannung $V_{meas}$ die Möglichkeit eine Aussage über die Anpassung der Last also der Antenne 106 zu treffen. $V_{meas}$ kann ggfs. direkt über einen Analog-Digital-Umsetzer abgegriffen und zur Steuerung des Antennen-Tuners zur Abstimmung verwendet werden, wie dies in Fig. 21 gezeigt ist.

Im Detail zeigt Fig. 21 ein schematisches Blockschaltbild einer Sendeeinrichtung mit einem Leistungsverstärker 190, gemäß einem Ausführungsbeispiel der vorliegenden Erfindung. Wie in Fig. 21 zu erkennen ist, kann eine Abstimmspannung zur Regelung des Antennen-Tuners basierend auf einer (z.B. durch eine) Messung des Biasstroms I_Bias der aktiven Bauelemente 194 erzeugt werden.

2.4.3. Erzeugen einer Abstimmspannung durch Messung der Gleichtaktmode der magnetischen Antenne

Die Antennenschleife 108 einer magnetischen Antenne 106 ist eine differenzielle Last. Mithilfe eines Transformators (Balun) kann diese zweipolige differenzielle Last von einer einpoligen Quelle angesteuert werden, wie dies in Fig. 23 gezeigt ist.

Im Detail zeigt Fig. 22 ein schematisches Blockschaltbild einer Antennenanordnung 104, gemäß einem Ausführungsbeispiel der vorliegenden Erfindung. Die Antennenanordnung 104 umfasst die magnetische Antenne 106 mit der Schleife 108 und dem Abstimmelement 111, wobei die magnetische Antenne 106 über einen Transformator 196 (Balun) mit einer Quelle 102, wie z.B. einer Sendeeinrichtung, verbunden ist. Die Antennenschleife 108 kann dabei differentiell angesteuert werden, so dass die Gleichtaktmode $Z_{cc11}$ vor dem Balun 196 nicht mehr sichtbar ist.

Wie in Fig. 22 zu erkennen ist, "sieht" die Quelle 102 dabei die Lastimpedanz $Z_L$.

Die magnetische Antenne 106 umfassend Antennenschleife 108 und Anpasselement 111 hat die differenzielle Impedanz $Z_d$. Über die Umgebung 197 ist die magnetische Antenne 106 mit der Impedanz $Z_c$ verkoppelt. Diese parasitäre Verkopplung führt zur Verstimmung der (magnetischen) Antenne 106 und kann mithilfe des Anpasselements 111 ausgeglichen werden.

Am Eingang der magnetischen Antenne 106 sind somit zwei Impedanzen messbar. Die Gegentaktimpedanz $Z_{dd11}$ beschreibt den Gegentaktbetrieb (Normalbetrieb der (magnetischen Antenne 106). Die Gleichtaktimpedanz $Z_{cc11}$ beschreibt den Gleichtaktbetrieb, der durch unerwünschte Verkopplung mit der Umgebung zustande kommt. Am Eingang des Baluns 196 ist nur mehr die Impedanz $Z_L$ messbar.

Die Erzeugung eines Abstimmsignals (z.B. Abstimmspannung) 122 zur Regelung des Anpasselements 111 kann durch Zugriff auf die Gleichtaktmode, die aus der Gleichtaktimpedanz $Z_{cc11}$ resultiert, erfolgen.

Wenn die magnetische Antenne 106 differenziell angesteuert wird, dann kann die (magnetische) Antenne 106 mit einem Gegentakt- oder mit einem Gleichtaktsignal beaufschlagt werden und über den Stromverbrauch eine Aussage über die Verstimmung getroffen werden.

Die Gleichtaktmode kann über zwei Methoden gemessen bzw. eingespeist werden, die nachfolgend beschrieben sind.

2.4.3.1. Messung und Einspeisung der Gleichtaktmode über den Gleichtaktzweig des Ausgangsbaluns

Spezielle Baluns 196 ermöglichen einen Zugriff auf die Gleichtaktmode des differenziellen Ports. Ein Beispiel ist der sogenannte Ringkoppler (auch Rat-Race-Koppler) in Fig. 23. Die Gleichtakteigenschaften der magnetischen Antenne können dann entweder über eine aktive Messung mithilfe eines Messsignals oder über die reflektierte Leistung bestimmt werden und daraus eine Abstimmspannung abgeleitet werden.

2.4.3.2. Messung der Gleichtaktmode über die Nichtlinearität des Magnetkerns

Um die Baugröße des Baluns 196 insbesondere bei niedrigen Frequenzen zu optimieren, werden Magnetkerne mit einer von Vakuum (bzw. Luft) abweichenden Permeabilitätszahl eingesetzt. Diese Magnetkerne weisen ein nichtlineares Verhalten auf.

Mithilfe einer Messwicklung oder eines Hallsensors können magnetische Gleichströme, die durch das nichtlineare verhalten des Magnetkerns entstehen, erfasst werden, wie dies in Fig. 24 gezeigt ist.

Im Detail zeigt Fig. 24 eine schematische Ansicht eines Magnetkerns 198 eines Baluns 196 sowie einer Messwicklung 199 um den Magnetkern 198 zur Erfassung der Gleichtakteigenschaften des Baluns über die nichtlinearen Eigenschaften des Magnetkerns 198 mithilfe der Messwicklung.

2.4.4. Ausführungsbeispiele

Bei Ausführungsbeispielen kann das Gerät (z.B. der Teilnehmer 102 bzw. die Abstimmeinrichtung 120 des Teilnehmers 100) den Stromverbrauch des bzw. der Leistungstransistoren (aktiven Bauelemente) messen (z.B. zur Erzeugung des Abstimmsignals (z.B. Abstimmspannung)).

Bei Ausführungsbeispielen kann das Gerät (z.B. der Teilnehmer 102 bzw. die Abstimmeinrichtung 120 des Teilnehmers 100) die Differenz der Versorgungsströme von zwei Leistungstransistoren zur Erzeugung einer Abstimmspannung bestimmen.

Bei Ausführungsbeispielen kann das Gerät (z.B. der Teilnehmer 102 bzw. die Abstimmeinrichtung 120 des Teilnehmers 100) einen Biasstrom des bzw. der Leistungstransistoren (z.B. der Sendeeinrichtung 102) zur Erzeugung einer Abstimmspannung 122 erfassen (z.B. messen).

Bei Ausführungsbeispielen kann das Gerät (z.B. der Teilnehmer 102 bzw. die Abstimmeinrichtung 120 des Teilnehmers 100) einen Biasstrom des bzw. der Leistungstransistoren (z.B. der Sendeeinrichtung 102) durch Messung einer Spannung über einen Widerstand im Biaszweig ermitteln (z.B. bestimmen).

Bei Ausführungsbeispielen kann das Gerät (z.B. der Teilnehmer 102 bzw. die Abstimmeinrichtung 120 des Teilnehmers 100) eine Differenz der Biasströme von zwei Leistungstransistoren (z.B. der Sendeeinrichtung 102) zur Erzeugung eines Abstimmsignals 122 (z.B. Abstimmspannung) ermitteln (z.B. bestimmen).

Bei Ausführungsbeispielen kann das Gerät (z.B. der Teilnehmer 102 bzw. die Abstimmeinrichtung 120 des Teilnehmers 100) eine Differenz der Ströme eines Verstärkers im Balanced-Betrieb zur Erzeugung eines Abstimmsignals 122 (z.B. Abstimmspannung) ermitteln (z.B. bestimmen).

Bei Ausführungsbeispielen kann das Gerät (z.B. der Teilnehmer 102 bzw. die Abstimmeinrichtung 120 des Teilnehmers 100) eine Differenz der Ströme eines Verstärkers im Doherty-Betrieb zur Erzeugung eines Abstimmsignals 122 (z.B. Abstimmspannung) ermitteln (z.B. bestimmen).

Bei Ausführungsbeispielen kann das Gerät (z.B. der Teilnehmer 102 bzw. die Abstimmeinrichtung 120 des Teilnehmers 100) eine Differenz der Ströme eines Verstärkers im Gegentakt-Betrieb zur Erzeugung eines Abstimmsignals 122 (z.B. Abstimmspannung) ermitteln (z.B. bestimmen).

Bei Ausführungsbeispielen kann das Gerät (z.B. der Teilnehmer 102 bzw. die Abstimmeinrichtung 120 des Teilnehmers 100) eine Gleichtaktimpedanz einer magnetischen Antenne 106 zur Erzeugung eines Abstimmsignals (z.B. Abstimmspannung) ermitteln (z.B. bestimmen).

Bei Ausführungsbeispielen kann das Gerät (z.B. der Teilnehmer 102 bzw. die Abstimmeinrichtung 120 des Teilnehmers 100) eine Gleichtaktimpedanz (z.B. der magnetischen Antenne 106) mithilfe eines Messsignals ermitteln (z.B. bestimmen).

Bei Ausführungsbeispielen kann das Gerät (z.B. der Teilnehmer 102 bzw. die Abstimmeinrichtung 120 des Teilnehmers 100) abwechselnd ein Gegentakt- und ein Gleichtaktsignal in die magnetische Antenne 106 einspeisen und den Stromverbrauch ermitteln und diese Information zur Erzeugung eines Abstimmsignals 122 (z.B. Abstimmspannung) nutzen.

Bei Ausführungsbeispielen kann das Gerät (z.B. der Teilnehmer 102 bzw. die Abstimmeinrichtung 120 des Teilnehmers 100) ein Gleichtaktsignal (z.B. in die magnetische Antenne 106) mithilfe eines Baluns 196 einspeisen, das einen Zugriff auf die Gleichtaktmode ermöglicht.

Bei Ausführungsbeispielen kann das Gerät (z.B. der Teilnehmer 102 bzw. die Abstimmeinrichtung 120 des Teilnehmers 100) ein reflektiertes Gleichtaktsignal einer magnetischen Antenne 106 zur Erzeugung eines Abstimmsignals (z.B. Abstimmspannung) ermitteln (z.B. messen).

Bei Ausführungsbeispielen kann das Gerät (z.B. der Teilnehmer 102 bzw. die Abstimmeinrichtung 120 des Teilnehmers 100) ein Gleichtaktsignal (z.B. der magnetischen Antenne 106) mithilfe eines Baluns ermitteln (z.B. messen), das einen Zugriff auf die Gleichtaktmode ermöglicht.

Bei Ausführungsbeispielen kann das Gerät (z.B. der Teilnehmer 102 bzw. die Abstimmeinrichtung 120 des Teilnehmers 100) Zugriff auf die Gleichtaktmode (z.B. der magnetischen Antenne) mithilfe eines Ringkopplers haben.

Bei Ausführungsbeispielen kann das Gerät (z.B. der Teilnehmer 102 bzw. die Abstimmeinrichtung 120 des Teilnehmers 100) Zugriff auf die Gleichtaktmode (z.B. der magnetischen Antenne) über die nichtlinearen Eigenschaften eines Magnetkerns haben.

Bei Ausführungsbeispielen kann das Gerät (z.B. der Teilnehmer 102 bzw. die Abstimmeinrichtung 120 des Teilnehmers 100) nichtlineare Eigenschaften eines Magnetkerns (z.B. eines Baluns 196) zur Messung eines magnetischen Gleichstroms mithilfe eines Hallsensors nutzen.

Bei Ausführungsbeispielen kann das Gerät (z.B. der Teilnehmer 102 bzw. die Abstimmeinrichtung 120 des Teilnehmers 100) nichtlineare Eigenschaften eines Magnetkerns (z.B. eines Baluns 196) zur Messung eines magnetischen Gleichstroms mithilfe einer Messwicklung am Magnetkern nutzen.

3. Abstimmung einer Schleife (engl. loop) einer magnetischen Antenne

Fig. 25a zeigt ein schematisches Blockschaltbild einer Antennenanordnung 104, gemäß einem Ausführungsbeispiel der vorliegenden Erfindung. Die Antennenanordnung 104 umfasst eine magnetische Antenne 106 mit einer einfach oder mehrfach (z.B. zumindest zweifach) unterbrochenen Schleife 108 und zumindest einem Abstimmelement 111 zur Abstimmung der magnetischen Antenne 106, wobei die Schleife 108 der magnetischen Antenne 106 durch ein oder mehrere Kapazitätselemente 110_1-110_n unterbrochen ist, wobei ein Signal an einem ersten Punkt 116_1 (z.B. Speisepunkt, oder Speiseort) in die magnetische Antenne 106 eingekoppelt und/oder aus der magnetischen Antenne 106 ausgekoppelt wird, wobei das zumindest eine Abstimmelement 111 an die magnetische Antenne 106 an zumindest einem zweiten Punkt 116_2 (z.B. Abstimmpunkt, oder Abstimmort) angekoppelt ist, wobei der erste Punkt 116_1 und der zumindest eine zweite Punkt 116_2 unterschiedlich sind.

Wie in Fig. 25a beispielhaft gezeigt ist, kann die Schleife 108 der magnetischen Antenne 106 durch n = 2 Kapazitätselemente 110_1-110_n (z.B. Resonanzkapazitäten) unterbrochen sein. Die Schleife 108 der magnetischen Antenne 106 kann jedoch genauso durch eine andere Anzahl n von Kapazitätselementen 110_1-110_n unterbrochen sein. So kann bei Ausführungsbeispielen die Schleife 108 der magnetischen Antenne 106, bei kapazitiver Kopplung, durch n Kapazitätselemente 110_1-110_n unterbrochen sein, wobei n eine natürliche Zahl größer gleich zwei ist, $n \geq 2$. Die n Kapazitätselemente 110_1-110_n können hierbei den gleichen oder aber auch unterschiedliche Kapazitätswerte aufweisen.

Bei Ausführungsbeispielen kann der erste Punkt 116_1 (z.B. Speisepunkt) ein erster Abschnitt oder Bereich der einfach oder mehrfach unterbrochenen Schleife 108 sein, an dem die Schleife 108 unterbrochen ist, wie z.B. durch eines der ein oder mehreren Kapazitätselemente 110_1-110_n, wie beispielsweise dem ersten Kapazitätselement 110_1 bei dem in Fig. 25a gezeigten Ausführungsbeispiel.

So kann bei Ausführungsbeispielen das Signal über ein erstes Kapazitätselement 110_1 in die magnetische Antenne 106 eingekoppelt und/oder aus der magnetischen Antenne 106 ausgekoppelt werden.

Beispielsweise kann hierzu ein Antennenanschluss 119 der Antennenanordnung 104 kapazitiv (z.B. über ein oder mehrere Koppelkondensatoren 117) an die magnetische Antenne 106 oder, wie dies in dem in Fig. 25a gezeigten Ausführungseispiel gezeigt ist, an das erste Kapazitätselement 110_1 angekoppelt sein.

Das Signal kann hierbei, wie dies in Fig. 25a angedeutet ist, durch eine Quelle und/oder Senke 102, wie z.B. einer Sende- und/oder Empfangseinrichtung (z.B. eines Teilnehmers 100 eines Kommunikationssystems) bereitgestellt oder aufgenommen werden. Die Quelle und/oder Senke 102 kann hierzu mit dem Antennenanschluss 119 der Antennenanordnung 104 verbunden sein.

Bei Ausführungsbeispielen kann der zweite Punkt 116_2 (z.B. Abstimmpunkt) ein zweiter Abschnitt oder Bereich der einfach oder mehrfach unterbrochenen Schleife 108 sein, an dem die Schleife 108 unterbrochen ist, wie z.B. durch eines der ein oder mehreren Kapazitätselemente 110_1-110 n, wie beispielsweise dem zweiten Kapazitätselement 110_2 bei dem in Fig. 25a gezeigten Ausführungsbeispiel.

So kann bei Ausführungsbeispielen das zumindest eine Abstimmelement 111 über ein zweites Kapazitätselement 110_2 mit der magnetischen Antenne 106 verbunden sein, z.B. durch Parallelschaltung (oder alternativ Serienschaltung) zu dem zweiten Kapazitätselement 110_2.

Alternativ kann auch zumindest eines der Kapazitätselemente 110_1-110_n das zumindest eine Abstimmelement 111 sein, wie dies in Fig. 25b gezeigt ist.

Im Detail zeigt Fig. 25b ein schematisches Blockschaltbild einer Antennenanordnung 104, gemäß einem weiteren Ausführungsbeispiel der vorliegenden Erfindung. Im Gegensatz zu dem in Fig. 25a gezeigten Ausführungsbeispiel ist zumindest eines der Kapazitätselemente 110_1-110_n als das zumindest eine Abstimmelement 111 ausgeführt.

Bei Ausführungsbeispielen kann die Schleife 108 der magnetischen Antenne 106 somit durch das zumindest eine Abstimmelement 111 selbst unterbrochen sein.

Anstelle der in den Fig. 25a und 25b gezeigten kapazitiven Einkopplung des Signals in die magnetische Antenne 106 und/oder Auskopplung des Signals aus der magnetischen Antenne 106, kann das Signal auch über eine Koppelschleife in die magnetische Antenne 106 eingekoppelt und/oder aus der magnetischen Antenne 106 ausgekoppelt werden, wie dies in Fig. 25c gezeigt ist.

Im Detail zeigt Fig. 25c ein schematisches Blockschaltbild einer Antennenanordnung 104, gemäß einem weiteren Ausführungsbeispiel der vorliegenden Erfindung. Im Gegensatz zu den in Fig. 25a und 25b gezeigten Ausführungsbeispielen wird das Signal über eine Koppelschleife 128 in die magnetische Antenne 106 eingekoppelt und/oder aus der magnetischen Antenne 106 ausgekoppelt.

Die Koppelschleife 128 kann dabei so angeordnet sein, dass das Signal über die Koppelschleife 128 primär bzw. hauptsächlich an einem ersten Punkt 116_1 (Speisepunkt; z.B. ein Abschnitt oder Bereich) der Schleife 108 in die magnetische Antenne 106 eingekoppelt wird, so dass der erste Punkt 116_1 und der zweite Punkt 116_2 voneinander beabstandet sind.

Beispielsweise kann die Koppelschleife 128 benachbart zu dem ersten Kapazitätselement 110_1 angeordnet sein (z.B. so, dass ein Abstand zwischen der Koppelschleife 128 und dem ersten Kapazitätselement 110_1 kleiner ist als ein Abstand zwischen Koppelschleife 128 und dem zweiten Kapazitätselement 110_2), so dass der erste Punkt 116_1 (z.B. Speisepunkt) und der zweite Punkt 112_2 (z.B. Abstimmpunkt) voneinander beabstandet sind.

Bei dem in Fig. 25c gezeigten Ausführungsbeispiel ist die Schleife 108 der magnetischen Antenne 106 beispielhaft durch n = 2 Kapazitätselemente 110_1-110_n (z.B. Resonanzkapazitäten) unterbrochen sein. Die Schleife 108 der magnetischen Antenne 106 kann jedoch genauso durch eine andere Anzahl n von Kapazitätselementen 110_1-110_n unterbrochen sein. So kann bei Ausführungsbeispielen die Schleife 108 der magnetischen Antenne 106, bei induktiver Kopplung, durch n Kapazitätselemente 110_1-110_n unterbrochen sein, wobei n eine natürliche Zahl größer gleich eins ist, n ≥ 1. Die n Kapazitätselemente 110_1-110_n können hierbei den gleichen oder aber auch unterschiedliche Kapazitätswerte aufweisen.

Im Folgenden werden detaillierte Ausführungsbeispiele der Antennenanordnung 104, und im speziellen, des zumindest einen Abstimmelements zur Abstimmung der magnetischen Antenne 106 beschrieben.

3.1 Abstimmung bei kapazitiver Einspeisung nicht am Einspeisepunkt

Im Gegensatz zum Einsatz in der Magnetresonanz werden beim Einsatz in einem Teilnehmer eines Kommunikationssystems keine oder nur vernachlässigbare Verluste in die Schleife 108 (engl. loop) eingekoppelt. Bei Annäherung an eine metallische Wand erfolgt über die Wirbelströme eine Verringerung des Wertes der Ersatzinduktivität $L_{ers}$ (d.h. die Resonanzfrequenz steigt)( $L_{ers}$ ist hierbei die resultierende Induktivität, die sich ergibt, wenn alle Schleifenäste und Resonanzkondensatoren (inkl. Abstimmelemente) einbezogen werden, außer das erste Kapazitätselement 110_1), bei Annäherung an ein Dielektrikum steigt der Wert der Ersatzinduktivität $L_{ers}$ (d.h. die Resonanzfrequenz fällt), weil der kapazitive Anteil in der Anordnung zunimmt. Wenn nun die Güte Q konstant bleibt (d.h. keine eingekoppelten Verluste), der Wert der Ersatzinduktivität $L_{ers}$ sich aber ändert, dann ändert sich auch der serielle Verlustwiderstand $R_{ers}$ wegen der Beziehung $R_{ers} = \frac{\omega_0 L_{ers}}{Q}$ (Hinweis: Äquivalente Überlegungen können auch für einen parallelen Verlustwiderstand angestellt werden). Würde nun eine geänderte Ersatzinduktivität $L_{ers}$ in Kauf genommen werden, so müsste nach Fig. 33 zunächst die Abstimmkapazität $C_{ts}$ korrigiert werden, um wieder bei $\omega_0$ in Resonanz zu sein, es müsste aber auch die Lastanpassung mittels der Anpassungskapazität $C_{ms}$ korrigiert werden, da sich ja der serielle Verlustwiederstand $R_{ers}$ mit verändert hat.

Die Verhältnisse liegen grundlegend anders, wenn die Abstimmkapazität $C_{ts}$ konstant gehalten wird und ein im Prinzip beliebig anderer Kondensator in der z.B. *n*-fach kapazitiv verkürzten Schleife 108 veränderbar ausführt wird. Bezogen auf Fig. 33 wäre das z.B. (bei hier nur *n* = 2-facher Verkürzung) der rechts gezeichnete 56 pF Kondensator. Eine Veränderung der i.a. *n* - 1 möglichen Kondensatoren zur gewünschten (also vorherigen) Resonanzfrequenz $\omega_0$ hin bedeutet ja letztlich, dass sich die Anordnung dann wegen konstanter Abstimmkapazität $C_{ts}$ wieder auf den gleichen Wert der Ersatzinduktivität $L_{ers}$ einstellt, somit auch den gleichen Wert für den Verlustwiderstand $R_{ers}$ aufweist. Dies hat zur Folge, dass trotz Frequenzkorrektur die Anpassungskapazität $C_{ms}$ nicht verändert werden muss.

Bei Ausführungsbeispielen kann, bei einfacher (oder mehrfacher) Verkürzung der Schleife 108, eine kapazitive Einspeisung erfolgen, wobei die Abstimmung nicht am Punkt der Einspeisung erfolgt.

Bei Ausführungsbeispielen kann, bei mehrfacher Verkürzung der Schleife 108 eine allgemeine Einspeisung (z.B. Koppelung; z.B. induktive Kopplung) erfolgen, wobei die Abstimmung nicht am Punkt (oder Abschnitt bzw. Bereich der Schleife) der Einspeisung erfolgt.

Bei Ausführungsbeispielen können der Punkt der Einspeisung und der Punkt der Anpassung derart angeordnet sein, dass die Abstimmung nicht oder nur geringfügig die Lastanpassung verändert.

3.2 Abstimmung gegenüber der Einspeisestelle

Fig. 26 zeigt ein schematisches Blockschaltbild einer Antennenanordnung 104, gemäß einem weiteren Ausführungsbeispiel der vorliegenden Erfindung. Die magnetische Antenne 106 weist eine Schleife 108 auf, die durch beispielsweise n = 4 Kapazitätselemente 110_1-110_n (Resonanzkapazitäten) vierfach unterbrochen ist. Natürlich kann die Schleife 108 auch durch eine andere Anzahl an Kapazitätselementen 110_1-110_n unterbrochen sein, wie dies oben bereits erwähnt wurde.

Bei dem in Fig. 26 gezeigten Ausführungsbeispiel wird ein Signal über ein erstes Kapazitätselement 110_1 der n = 4 Kapazitätselemente 110_1-110_n in die magnetische Antenne 106 eingekoppelt und/oder aus der magnetischen Antenne 106 ausgekoppelt. Ein Antennenanschluss 119 der Antennenanordnung 104 kann hierzu beispielsweise kapazitiv über zwei Lastanpassungskondensatoren 117 mit dem ersten Kapazitätselement 110_1 verbunden sein. Alternativ kann natürlich auch eine induktive Einkopplung mittels einer Koppelschleife 128 (siehe Fig. 25c) erfolgen.

Die magnetische Antenne 106 umfasst ferner ein Abstimmelement 111 zur Abstimmung der magnetischen Antenne 106, wobei das Abstimmelement 111 mit einem zweiten Kapazitätselement 111 der n = 4 Kapazitätselemente 110_1-110_n verbunden ist. Beispielsweise kann das Abstimmelement 111 parallel zu dem zweiten Kapazitätselement 110_2 geschaltet sein. Natürlich kann das Abstimmelement 111, wie oben beschrieben, auch als das zweite Kapazitätselement ausgeführt sein, oder mit anderen Worten, das zweite Kapazitätselement ersetzten.

Mit anderen Worten, Fig. 26 zeigt am Beispiel einer vierfach verkürzten Schleife 108, wo das variable Abstimmelement 111 zur Frequenzkorrektur (in Fig. 26 auch mit D-Cp bezeichnet) sitzen kann, im Detail, gegenüber der Einspeisestelle.

Im Unterschied zu Fig. 33 ist bei dem in Fig. 26 gezeigten Ausführungsbeispiel der Lastanpassungskondensator in zwei Lastanpassungskondensatoren 117 2Cs aufgeteilt, was zu einer besseren Symmetrierung führt. Die zwei Lastanpassungskondensatoren 117 2*Cs* sind in Fig. 26 noch variabel gezeichnet, müssen aber nach einmaliger Justage nicht mehr geändert werden bzw. können als Festwert bestückt werden.

Bei Ausführungsbeispielen kann, bei mehrfacher (z.B. zumindest zweifacher) Verkürzung der Schleife 108, eine kapazitive Einkopplung erfolgen, wobei eine Abstimmung gegenüber der Einspeisestelle erfolgen kann.

Bei Ausführungsbeispielen kann, bei einfacher oder mehrfacher Verkürzung der Schleife 108, eine allgemeine Einkopplung erfolgen, wobei eine Abstimmung gegenüber der Einspeisestelle erfolgen kann.

3.3 Abstimmung direkt an der Stelle des ersten(...)Verkürzungskondensators

Die obigen Überlegungen zeigen, dass eine erforderliche Frequenzkorrektur die (restliche) Schleife (engl. loop) immer auf eine Ersatzinduktivität mit dem konstanten Wert $L_{ers}$ einstellt, solange nicht die Kapazität am Einspeisepunkt verändert wird. Dabei ist es im Prinzip unerheblich, welche der n - 1 möglichen Resonanzkapazitäten 110_2-110_n zur Frequenzkorrektur herangezogen wird. In Fig. 26 ist zur Variation die der Einspeisung gegenüberliegende Stelle gewählt. Dies mag bei relativ großen Korrekturen den Vorteil mit sich bringen, dass sich die dadurch eingebrachte Unsymmetrie (es sind dann ja nicht mehr alle n - 1 Resonanzkapazitäten gleich groß) am geringsten auswirkt. Bei kleinen Korrekturen ist das aber völlig irrelevant, so dass im Prinzip jede der *n* - 1 Resonanzkapazitäten 110_2-110_n, also auch die der Einspeisestelle am nächsten liegende, zur Korrektur herangezogen werden kann. Eine entsprechende Ausführungsform zeigt Fig. 27.

Im Detail zeigt Fig. 27 ein schematisches Blockschaltbild einer Antennenanordnung 104, gemäß einem weiteren Ausführungsbeispiel der vorliegenden Erfindung. Die magnetische Antenne 106 weist eine Schleife 108 auf, die durch beispielsweise n = 8 Kapazitätselemente 110_1-110_n (Resonanzkapazitäten) achtfach unterbrochen ist. Natürlich kann die Schleife 108 auch durch eine andere Anzahl an Kapazitätselementen 110_1-110_n unterbrochen sein, wie dies oben bereits erwähnt wurde.

Bei dem in Fig. 27 gezeigten Ausführungsbeispiel wird ein Signal über ein erstes Kapazitätselement 110_1 der n = 8 Kapazitätselemente 110_1-110_n in die magnetische Antenne 106 eingekoppelt und/oder aus der magnetischen Antenne 106 ausgekoppelt. Ein Antennenanschluss 119_1 der Antennenanordnung 104 kann hierzu beispielsweise kapazitiv über einen Lastanpassungskondensator 117 mit einem ersten Anschluss des ersten Kapazitätselements 110_1 verbunden sein, wobei ein zweiter Anschluss des ersten Kapazitätselements 110_1 über einen Lastanpassungskondensator 117 auf ein Bezugspotentialanschluss 119_2 (z.B. Masse) geschaltet sein kann. Alternativ kann natürlich auch eine induktive Einkopplung mittels einer Koppelschleife 128 (siehe Fig. 25c) erfolgen.

Die magnetische Antenne 106 umfasst ferner ein Abstimmelement 111 zur Abstimmung der magnetischen Antenne 106, wobei das Abstimmelement 111 mit einem zweiten Kapazitätselement 111 der n = 8 Kapazitätselemente 110_1-110_n verbunden ist. Beispielsweise kann das Abstimmelement 111 parallel zu dem zweiten Kapazitätselement 110_2 geschaltet sein.

Auch bei dem in Fig. 27 gezeigten Ausführungsbeispiel sind somit der erste Punkt 116_1 (z.B. Speisepunkt), an dem das Signal in die magnetische Antenne 106 eingekoppelt und/oder aus der magnetischen Antenne 106 ausgekoppelt wird, und der zweite Punkt 116_2 (z.B. Abstimmpunkt), an dem die Ankopplung des Abstimmelements 111 an die magnetische Antenne 106 erfolgt, voneinander beabstandet.

Verglichen mit dem in Fig. 26 gezeigten Ausführungsbeispiel, sind das erste Kapazitätselement 110_1 und das zweite Kapazitätselement 110_2 in einer Draufsicht auf die Schleife 108 jedoch nicht symmetrisch angeordnet, z.B. in Bezug auf eine Achse 202, die durch den ersten Punkt 116_1 (Speisepunkt) und einen Mittelpunkt der Schleife 108 verläuft.

Beispielsweise können in einer Draufsicht auf die mehrfach unterbrochene Schleife 108 das erste Kapazitätselement 110_1 und das zweite Kapazitätselement 110_2 unmittelbar benachbarte Kapazitätselemente sein.

Wie in Fig. 27 zu erkennen ist, kann das Abstimmelement 111 mehrere anti-seriell geschaltete Kapazitätsdiodenpaare aufweisen. Natürlich kann das Abstimmelement 111 bei Ausführungsbeispielen auch nur ein anti-seriell geschaltetes Kapazitätsdiodenpaar oder aber auch mehrere anti-seriell geschaltete Kapazitätsdiodenpaare aufweisen.

Wie in Fig. 27 ferner zu erkennen ist, kann das Abstimmelement 111 ferner mit einem ersten Abstimmanschluss 204 der Antennenanordnung 104 verbunden sein, an dem ein Steuersignal (z.B. Abstimmsignal) zur Abstimmung der magnetischen Antenne 106 anliegen kann. Beispielsweise kann ein Knoten zwischen dem jeweiligen Kapazitätsdiodenpaar über entsprechende Widerstände mit dem Abstimmanschluss 204 verbunden sein, an dem das Steuersignal zur Abstimmung der magnetischen Antenne 106 anliegen kann. Ein zweiter Abstimmanschluss kann auf ein Bezugspotentialanschluss (z.B. Masse) geschaltet sein, wie z.B. der Anschluss 119_2.

Das Steuersignal kann beispielsweise von einer Abstimmeinrichtung 120 bereitgestellt werden, wie sie in Abschnitt 2 beschrieben ist.

Mit anderen Worten, Fig. 27 zeigt eine Frequenz-Abstimmung bei einer n=8-fach verkürzten Schleife 108 an dem der Einspeisestelle 116_1 direkt benachbarten Resonanzkondensatorplatz 110_2; hier mittels zweier Doppelpärchen (siehe Abschnitt 3.4). Die Bezugszeichen 206 und 208 markieren die für die DC-Zufuhr relevanten Widerstände.

Durch Wahl der am Einspeisepunkt nächstgelegenen Stelle können Überbrückungswiderstände an den anderen Resonanzkondensatoren eingespart werden (siehe Abschnitt 5). Mit anderen Worten, wird ein gleich hoher marginaler Güteverlust in Kauf genommen, dann können die jetzt in weitaus geringerer Anzahl anfallenden Widerstände auch entsprechend niederohmiger gewählt werden. Dies ist vorteilhaft für kurze Umschaltzeiten, was insbesondere für frequenzsprungbasierte Übertragungsverfahren, wie z.B. Telegram-Splitting [7], relevant ist. Die Zuführung der Steuerspannung/von Steuersignalen selbst kann direkt ohne weitere Maßnahmen (wie in Abschnitt 5 beschrieben) erfolgen.

Bei Ausführungsbeispielen kann, bei einer mehrfacher (z.B. zumindest zweifacher) Verkürzung der Schleife 108, eine Abstimmung asymmetrisch nicht gegenüber, sondern nahe der Einspeisestelle aber eben nicht direkt an der Einspeisestelle erfolgen.

Bei Ausführungsbeispielen kann, bei einer mehrfachen Verkürzung der Schleife 108, eine Abstimmung am ersten (oder zweiten, oder dritten) Verkürzungskondensator (= zweites, drittes oder viertes Kapazitätselement 110_2, 110_3, 110_4) erfolgen.

Ausführungsbeispiele können für Frequency-Hopping-Systeme und/oder Telegram-Splitting-Systeme verwendet werden.

## 4. Veränderbare Kapazität

Magnetische Antennen 106 haben die Eigenschaft, dass diese sehr schmalbandig sind und dadurch nur einen geringen Frequenzbereich abdecken. Durch die Verwendung von veränderbaren Kapazitäten kann die magnetische Antenne 106 im Frequenzbereich abgestimmt werden (siehe Abschnitt 3).

Für eine schnelle automatische Frequenzregelung (z. B. für Frequency-Hopping-Systeme oder Telegram-Splitting-Systeme) ist eine - wie im Amateurfunk bei magnetischen Antennen übliche - mechanisch veränderliche Kapazität unbrauchbar. Viel geeigneter sind hierfür z.B. Kapazitätsdioden. Diese werden in Rückwärtsrichtung betrieben, d.h. es fließt nur ein äußerst geringer Sperrstrom. Zur Vermeidung von Stromfluss durch die anliegende HF-Spannung (z.B. während der positiven oder negativen Halbwelle) werden diese i.a. anti-seriell als Pärchen betrieben.

Allerdings ist der Abstimmbereich der Kapazitätsdioden begrenzt. Dies gilt insbesondere, da für eine weite Abstimmung hohe Spannungen benötigt werden, die in mobilen Endgeräten meist nicht zur Verfügung stehen und erst erzeugt werden müssen.

Weitere Technologien für kontinuierlich abstimmbare Kapazitäten sind dielektrisch abstimmbare Kondensatoren, dessen Dielektrikum abhängig von der Feldstärke im Dielektrikum ist und damit über die anliegende Spannung verändert werden kann. Als Dielektrikum eignet sich z.B. Barium-Strontium-Titanat (BST). Bei RF-MEMS-Kondensatoren wird der Effekt ausgenutzt, dass sich geladene bewegliche Elektroden beim Anlegen einer Spannung gegenseitig anziehen bzw. abstoßen und somit ihre Kapazität verändern.

Eine weitere Möglichkeit, um einen größeren Frequenzbereich abstimmen zu können, sind umschaltbare Kapazitäten. Dabei werden Kapazitäten über HF-Schalter parallelgeschaltet, wie dies in Fig. 28 gezeigt ist.

Denkbar sind auch z.B. binär gestufte Kondensatorarrays, die per pin-Dioden geschaltet werden. Dies hat aber zwei entscheidende Nachteile: Erstens ist zur Bestromung einer pin-Diode ein zig-fach höherer Strom erforderlich (und für ein gewisses Bitmuster müssen dann auch mehrere pin-Dioden gleichzeitig bestromt werden) und zweitens ist ihre Ansteuerung nicht so leicht, wie bei einer Kapazitätsdiode, welche nur einen analogen DC-Spannungswert erfordert. Für pin-Dioden ist zudem entweder ein paralleler Bus mit den Bits oder Serializer-Deserializer oder einen AD-Wandler vor Ort erforderlich. Beispielsweise kann der AD Wandler genutzt werden, um binär gestufte Kondensatorarrays durch eine analoge Regelspannung ansteuern zu können. Heutzutage gibt es auch ICs (IC = Integrated Circuit, dt. integrierter Schaltkreis) mit Kondensatorbänken, die geschalten werden. Als Schaltelement sind hier CMOS-Schalter üblich.

Haben die Kapazitäten unterschiedliche Werte, kann durch unterschiedliche Kombination weniger Kapazitäten eine große Anzahl unterschiedlicher Gesamtkapazitätswerte realisiert werden. Haben die n parallelgeschalteten Kapazitäten die Werte C, 2*C, 4*C, 8*C, ..., 2n *C, so kann die Kapazität mit einer Granularität von C zwischen C und (2n-1)*C variiert werden. Derartige umschaltbare Kapazitäten sind in integrierter Form als sog. DTC (DTC = Digitally Tunable Capacitor, dt. digital steuerbarer Kondensator) verfügbar und können so in kleiner Bauform in Schaltungen eingesetzt werden, doch auch eine diskrete Schaltung ist denkbar. Ebenfalls ist eine Serienschaltung der Kapazitäten denkbar, doch technisch aufwändiger.

Diese Kondensatorbänke haben jedoch den entscheidenden Nachteil, dass sie keine kontinuierliche Abstimmung erlauben und so für den Einsatz in analogen Regelschleifen (siehe Abschnitt 2) nicht oder nur teilweise geeignet sind, falls sehr kleine Abstimmschritte erforderlich sind.

Natürlich können auch elektronisch abstimmbare bzw. schaltbare Induktivitäten als Abstimmelement zur Abstimmung der magnetischen Antenne verwendet werden.

4.1 Kombination Kapazitätsdiode mit schaltbaren Kapazitäten

Kontinuierlich abstimmbare Kapazitäten (z.B. Kapazitätsdioden) haben den Nachteil des geringen Abstimmbereiches. Schaltbare Kapazitäten (z.B. Kondensatorbänke) haben den Nachteil, dass diese nicht kontinuierlich abstimmbar sind. Durch eine Kombination (von zumindest einer kontinuierlich abstimmbaren Kapazität und schaltbaren Kapazitäten) können die Vorteile beider Abstimmelemente kombiniert werden.

Bei Ausführungsbeispielen kann eine Abstimmung der Schleife 108 der magnetischen Antenne 106 über eine veränderliche Kapazität erfolgen.

Bei Ausführungsbeispielen kann die veränderliche Kapazität geschaltete Kondensatoren aufweisen.

Bei Ausführungsbeispielen kann eine Größe (z.B. ein Kapazitätswert) der veränderlichen Kapazität durch eine Spannung gesteuert werden.

Bei Ausführungsbeispielen kann die veränderliche Kapazität eine Kapazitätsdiode aufweisen.

Bei Ausführungsbeispielen kann die veränderliche Kapazität ein BST-Varaktor aufweisen.

Bei Ausführungsbeispielen kann die veränderliche Kapazität ein RF-MEMS-Kondensator aufweisen.

Bei Ausführungsbeispielen kann die veränderliche Kapazität eine Kombination aus geschalteten Kondensatoren und zumindest einem aus einer Kapazitätsdiode, BST-Varaktor und RF-MEMS-Kondensator aufweisen.

Bei Ausführungsbeispielen kann mit den schaltbaren Kondensatoren eine Bereichswahl (z.B. 868 MHz / 915 MHz) und/oder eine Grobeinstellung erfolgen, wobei mit der variablen Kapazität (z.B. Kapazitätsdiode, BST-Varaktor und/oder RF-MEMS-Kondensator) eine Feineinstellung bzw. die analoge Regelung in der Regelschleife erfolgen kann.

Bei Ausführungsbeispielen kann die veränderliche Kapazität auf zwei oder mehrere Stellen verteilt werden. Ein Teil der Kapazität (z.B. die Kapazitätsdiode) kann an der Stelle des Verkürzungskondensator 110_2 links von der Einspeisestelle (vgl. Fig. 27) und eine Chipsatzkondensatorbank an der Stelle des Verkürzungskondensators 110_8 rechts von der Einspeisestelle angekoppelt sein.

4.2 Schaltbare Kapazitäten mit Grob/Feinbereich

Ein Finetuning (oder eine Feinabstimmung) - z.B. wegen Annäherung an ein dielektrisch wirksames Material - kann entweder durch zusätzliche Kapazitätsdioden erfolgen (siehe Abschnitt 4.1, entweder parallel oder seriell zu den geschalteten Kapazitäten) oder indem bei den geschalteten Kapazitäten eine Abstufung der Kapazitätswerte vorgenommen wird. So können größere Kapazitäten verwendet werden, um einen ausreichend großen Frequenzbereich abzudecken, während kleinere Kapazitäten verwendet werden können, um durch Zu- oder Wegschalten der jeweiligen kleineren Kapazitäten das Finetuning vorzunehmen. Ist der Frequenzbereich genau bekannt, so können beispielsweise bei einer Zwei-Band-Lösung ein zuschaltbarer großer Kapazitätswert für die Band-Umschaltung und mehrere kleine schaltbare Kapazitätswerte für das Finetuning vorgesehen werden.

Bei Ausführungsbeispielen kann eine Abstimmung der Schleife 108 der magnetischen Antenne 106 über eine veränderliche Kapazität erfolgen.

Bei Ausführungsbeispielen kann die veränderliche Kapazität eine Kombination aus geschalteten Kondensatoren mit mindestens zwei Kondensatorbereichen aufweisen, wobei ein erster der Kondensatorbereiche für eine Abstimmbereichswahl und ein zweiter der Kondensatorbereiche für eine Feineinstellung verwendet wird.

4.3 Schaltbare oder abstimmbare Induktivität

Die Abstimmung kann auch über eine (z.B. zusätzlichen) veränderbare Induktivität erfolgen. Induktivitäten lassen sich beispielsweise verändern, indem diese über Schalter unterschiedlich angezapft werden. Natürlich sind auch andere Abstimmmethoden denkbar. Beispielsweise ist auch eine Kombination aus einer schaltbaren Induktivität und einer Kapazitätsdiode möglich, wobei mittels der schaltbaren Induktivität eine Abstimmung über einen größeren (oder weiteren) Frequenzbereich (z.B. bei Frequenzsprungverfahren) erfolgt, und wobei über die Kapazitätsdiode eine Feinabstimmung (Finetuning) erfolgt.

Bei Ausführungsbeispielen kann eine Abstimmung der Schleife 108 der magnetischen Antenne 106 über eine veränderliche Induktivität erfolgen.

Bei Ausführungsbeispielen kann die Abstimmung über eine veränderliche Induktivität erfolgen.

Bei Ausführungsbeispielen kann die veränderliche Reaktanz eine Kombination aus geschalteten Induktivitäten für eine Abstimmbereichswahl und eine variable Kapazität (Kapazitätsdiode, BST-Varaktor bzw. RF-MEMS-Kondensator) für die Feinabstimmung aufweisen.

Bei Ausführungsbeispielen kann die veränderliche Reaktanz eine Kombination aus geschalteten Induktivitäten für eine Abstimmbereichswahl und eine variable Induktivität für die Feinabstimmung aufweisen.

Bei Ausführungsbeispielen kann mit den schaltbaren Induktivitäten eine Bereichswahl (z.B. 868 MHz / 915 MHz) und/oder eine Grobeinstellung erfolgen, wobei mit der variablen Kapazität (z.B. Kapazitätsdiode, BST-Varaktor und/oder RF-MEMS-Kondensator) oder der variablen Induktivität eine Feineinstellung bzw. die analoge Regelung in der Regelschleife erfolgen kann.

5. Zuführung der Steuerspannung (z.B. Abstimmspannung)

Abstimmelemente 111, wie z.B. Kapazitätsdioden oder auch andere abstimmbare Elemente, benötigen eine Zuführung einer Steuerspannung (z.B. Abstimmspannung) bzw. eines Steuersignals (Abstimmsignals). In unmittelbarer Nähe einer in Resonanz betriebenen Schleife 108 sind andere Leiter, welche hochfrequente Ströme tragen können, unzweckmäßig. Per Induktion kann sich ungewollt Energie einkoppeln, wodurch sich die Frequenz der Schleife 108 verstimmen kann. Dies sollte also nach Möglichkeit vermieden werden.

5.1 DC über dünne, unterbrochene Leiterbahnen

Bei Ausführungsbeispielen kann eine Steuerspannung (z.B. DC-Spannung (DC = Direct Current, dt. Gleichspannung)) über zwei dünne Leiterbahnen (z.B. mit einer Breite von höchstens 300 $\mu$m (oder 200 $\mu$m oder 150 $\mu$m oder 100 $\mu$m oder 75 $\mu$m)) zum Abstimmelement 111 (z.B. Kapazitätsdiode) geführt werden, in der in mehr oder minder regelmäßigen Abständen ein für HF hochohmiges Bauteil eingeschleift ist. Dies kann beispielsweise eine Drossel sein (was allerdings wieder ein gewisses Resonanzrisiko in sich birgt) oder - bei geringem Strombedarf - nur ein hochohmiger Widerstand im Bereich von mehreren 10 kOhm. Da Kapazitätsdioden als Abstimmelemente 111 nur einen Sperrstrom benötigen, der bei Zimmertemperatur i.a. im sub nA-Bereich liegt, entsteht über diese Widerstände kaum ein Spannungsabfall. In einer geschlossenen Regelschleife wird ohnehin entsprechend nachgeregelt. Geeignet sind auch sog. Chip Ferritperlen (engl. chip ferrite beads), die als sog. EMI Suppression Filter (EMI = Electromagnetic Interference, dt. elektromagnetische Störausstrahlung) ausgelegt sind (z.B. solange diese klein im Vergleich zur Schleife sind; Ferritperlen sind ja absichtlich aus verlustbehaftetem Ferritmaterial und das würde wieder die Güte der Schleife verschlechtern). Die dünnen Leiterbahnen können z.B. direkt durch das Zentrum der Schleife 108 verlaufen, wo das Magnetfeld niedriger ist als in direkter Nähe der stromtragenden Schleife 108. Dünne Leiterbahnen sind vorteilhaft, da die dann sehr geringe Kupferfläche praktisch kein Feld aus der Schleife 108 verdrängen.

Bei Ausführungsbeispielen erfolgt eine Zuführung der Steuerspannung oder Steuersignale über dünne, mit Widerständen oder/und Drosseln oder/und Ferritperlen unterbrochenen Leitungen.

Bei Ausführungsbeispielen können die dünnen Leitungen eine Leiterbahnbreite von weniger als 300 $\mu$m (oder 200 $\mu$m oder 150 $\mu$m oder 100 $\mu$m oder 75 $\mu$m) aufweisen.

5.2 Die DC-Spannung wird über die Schleife direkt geleitet

Bei Ausführungsbeispielen können die Resonanzkapazitäten 110_2-110_n einen Strompfad für die Steuerspannung (z.B. DC-Spannung) erhalten. Dies kann durch parallel geschaltete Widerstände oder Drosseln oder einer Serienschaltung aus diesen Bauelementen erfolgen. Ein Beispiel zeigt Fig. 29.

Im Detail zeigt Fig. 29 ein schematisches Blockschaltbild einer Antennenanordnung 104, gemäß einem weiteren Ausführungsbeispiel der vorliegenden Erfindung. Die magnetische Antenne 106 weist eine Schleife 108 auf, die durch beispielsweise n = 4 Kapazitätselemente 110_1-110_n (Resonanzkapazitäten) vierfach unterbrochen ist. Natürlich kann die Schleife 108 auch durch eine andere Anzahl an Kapazitätselementen 110_1-110_n unterbrochen sein, wie dies oben bereits erwähnt wurde.

Bei dem in Fig. 29 gezeigten Ausführungsbeispiel wird ein Signal über ein erstes Kapazitätselement 110_1 der n = 8 Kapazitätselemente 110_1-110_n in die magnetische Antenne 106 eingekoppelt und/oder aus der magnetischen Antenne 106 ausgekoppelt. Ein Antennenanschluss 119_1 der Antennenanordnung 104 kann hierzu beispielsweise kapazitiv über einen Lastanpassungskondensator 117 mit einem ersten Anschluss des ersten Kapazitätselements 110_1 verbunden sein, wobei ein zweiter Anschluss des ersten Kapazitätselements 110_1 über einen Lastanpassungskondensator 117 auf ein Bezugspotentialanschluss 119_2 (z.B. Masse) geschaltet sein kann. Alternativ kann natürlich auch eine induktive Einkopplung mittels einer Koppelschleife 128 (siehe Fig. 25c) erfolgen.

Die magnetische Antenne 106 umfasst ferner ein Abstimmelement 111 zur Abstimmung der magnetischen Antenne 106, wobei das Abstimmelement 111 mit einem zweiten Kapazitätselement 111 der n = 4 Kapazitätselemente 110_1-110_n verbunden ist. Beispielsweise kann das Abstimmelement 111 parallel zu dem zweiten Kapazitätselement 110_2 geschaltet sein.

Bei dem in Fig. 29 gezeigtem Ausführungsbeispiel weist das Abstimmelement 111 ein anti-seriell geschaltetes Kapazitätsdiodenpaar auf. Ein Knoten zwischen dem anti-seriell geschalteten Kapazitätsdiodenpaar kann hierbei über einen Widerstand 210 mit einem der Anschlüsse des zweiten Kapazitätselements 110_2 verbunden sein, da die Steuerspannung (z.B. Abstimmspannung), mit der das seriell geschaltete Kapazitätsdiodenpaar auf den gewünschten Kapazitätswert eingestellt bzw. abgestimmt wird, über die Schleife 108 der magnetischen Antenne 106 geführt wird.

Hierzu können die Kapazitätselemente 110_2-110_n jeweils durch einen Widerstand 212 überbrückt werden, wobei die Steuerspannung über das erste Kapazitätselement 110_1 an die Schleife 108 der magnetischen Antenne 106 angelegt werden kann. Alternativ zum Widerstand kann auch eine Drossel oder eine Ferritperle oder einer Serienschaltung aus einem Widerstand und einer Drossel zum Einsatz kommen.

Zur Zuführung der Steuerspannung kann beispielsweise ein erster Anschluss des ersten Kapazitätselements 110_1 (z.B. über einen Widerstand 214 und/oder eine Mantelwellensperre 216) mit einem ersten Abstimmanschluss 204_1 (tune +) der Antennenanordnung 104 verbunden sein, während ein zweiter Anschluss des ersten Kapazitätselements 110_1 (z.B. über einen Widerstand 214 und/oder eine optionale Mantelwellensperre 216) mit einem zweiten Abstimmanschluss 204_2 (tune -) der Antennenanordnung 104 verbunden sein kann.

Das Steuersignal (z.B. Abstimmsignal) kann beispielsweise von einer Abstimmeinrichtung 120 bereitgestellt werden, wie sie in Abschnitt 2 beschrieben ist.

Mit anderen Worten, Fig. 29 zeigt eine Zufuhr der Steuerspannung (DC-Spannung) für die Kapazitätsdiodenanordnung über die Schleife 108 selbst mittels resisitiv (z.B. 120 kOhm) überbrückter Resonanzkapazitäten 110_2-110_n. Die in Fig. 29 gezeigte Mantelwellensperre 216 ist für den späteren Betrieb nicht erforderlich.

Es kann leicht abgeschätzt werden, dass derart hochohmige Widerstände die Güte der Schleife 108 praktisch nicht herabsetzen.

Bei Ausführungsbeispielen kann, bei einfacher und/oder mehrfacher Verkürzung der Schleife 108, eine Zuführung der Steuerspannung bzw. des Steuersignals über die Schleife 108 direkt erfolgen.

Bei Ausführungsbeispielen kann, bei mehrfacher Verkürzung der Schleife 108, eine Überbrückung der Kapazitätselemente 110_2-110_n (z.B. Verkürzungskondensatoren) mit Widerständen, Drosseln oder Serienschaltungen von Widerständen und Drosseln erfolgen.

## 5.3 Zuführung der Steuerspannung (Abstimmung) auf mehrere Stellen über die Schleife

Fig. 30 zeigt ein schematisches Blockschaltbild einer Antennenanordnung 104, gemäß einem weiteren Ausführungsbeispiel der vorliegenden Erfindung. Die in Fig. 30 gezeigte Antennenanordnung 104 entspricht im Wesentlichen der in Fig. 29 gezeigten Antennenanordnung 104.

Verglichen mit der in Fig. 29 gezeigten Antennenanordnung 104 weist die magnetische Antenne 106 jedoch drei Abstimmelemente 111_1-111_3 zur Abstimmung der magnetischen Antenne 106 auf. Ein erstes Abstimmelement 111_1 kann dabei mit dem zweiten Kapazitätselement 110_2 verbunden sein (z.B. parallel zu dem zweiten Kapazitätselement 110_2 geschaltet sein), wobei ein zweites Abstimmelement 111_2 mit dem dritten Kapazitätselement 110_3 verbunden sein kann (z.B. parallel zu dem dritten Kapazitätselement 110_2 geschaltet sein kann), und wobei ein drittes Abstimmelement 111_2 mit dem vierten Kapazitätselement 110_4 verbunden sein kann (z.B. parallel zu dem vierten Kapazitätselement 110_4 geschaltet sein kann).

Mit anderen Worten, Fig. 30 zeigt DC-mäßig per Spannungsteiler in Reihe geschaltete Kapazitätsdioden.

Die in Fig. 30 gezeigte Ausführungsform ist vorteilhaft, wenn an mehreren Stellen in der Schleife 108 variable Kapazitäten benötigt werden. Als Nachteil ist der in den in Reihe geschalteten Widerständen 212 fließende Querstrom (der deutlich höher als der Dioden-Sperrstrom ist) zu nennen. Auch der entsprechend erforderliche höhere Spannungshub ist nachteilig, denn an jedem Kapazitätsdiodenpaar fällt gemäß Spannungsteilung nur ein entsprechender Bruchteil der Steuerspannung ab. Die Steuerspannung muss also an dem Einspeisepunkt 204_1 (tune) um diesen Faktor höher sein.

Bei Ausführungsbeispielen kann, bei mehrfacher Verkürzung, eine Abstimmung an mehreren Stellen durch eine seriell anliegende Steuerspannung oder Steuersignal erfolgen.

Bei Ausführungsbeispielen kann eine Zuführung der Steuerspannung oder des Steuersignals über die Schleife 108 erfolgen.

## 5.4 Schlitzen der Schleife der Länge nach / Aufteilung auf mehrere PCB Lagen

Das im Folgenden beschriebene Ausführungsbeispiel umgeht beide Nachteile des in Fig. 30 gezeigten Ausführungsbeispiels und ermöglicht dennoch eine Ansteuerung von Kapazitätsdioden an mehreren Stellen.

Fig. 31 zeigt ein schematisches Blockschaltbild einer Antennenanordnung 104, gemäß einem weiteren Ausführungsbeispiel der vorliegenden Erfindung.

Die magnetische Antenne 106 weist eine erste Schleife 108_1 auf, die durch beispielsweise n = 4 Kapazitätselemente 110_1-110_n (Resonanzkapazitäten) vierfach unterbrochen ist. Natürlich kann die erste Schleife 108_1 auch durch eine andere Anzahl an Kapazitätselementen 110_1-110_n unterbrochen sein, wie dies oben bereits erwähnt wurde.

Die magnetische Antenne 106 weist ferner eine zweite Schleife 108_1 auf, die beispielsweise durch n = 4 Widerstandselemente 220_1-220_n vierfach unterbrochen ist. Natürlich kann die zweite Schleife 108_2 auch durch eine andere Anzahl an Widerstandselementen 220_1-220_n unterbrochen sein.

Wie in Fig. 31 angedeutet ist, können die erste Schleife 108_1 und die zweite Schleife 108_2 kapazitiv gekoppelt sein, beispielsweise durch äquidistant gesetzte Überbrückungskondensatoren 240 oder aber auch durch eine übereinanderliegende Platzierung z.B. auf unmittelbar benachbarten Leiterbahnebenen einer Leiterplatte.

Bei dem in Fig. 31 gezeigten Ausführungsbeispiel wird ein Signal über ein erstes Kapazitätselement 110_1 der n = 4 Kapazitätselemente 110_1-110_n in die magnetische Antenne 106 eingekoppelt und/oder aus der magnetischen Antenne 106 ausgekoppelt. Ein Antennenanschluss 119_1 der Antennenanordnung 104 kann hierzu beispielsweise kapazitiv über einen Lastanpassungskondensator 117 mit einem ersten Anschluss des ersten Kapazitätselements 110_1 verbunden sein, wobei ein zweiter Anschluss des ersten Kapazitätselements 110_1 über einen Lastanpassungskondensator 117 auf ein Bezugspotentialanschluss 119_2 (z.B. Masse) geschaltet sein kann. Alternativ kann natürlich auch eine induktive Einkopplung mittels einer Koppelschleife 128 (siehe Fig. 25c) erfolgen.

Die magnetische Antenne 106 umfasst ferner drei Abstimmelemente 111_1-111_3 zur Abstimmung der magnetischen Antenne 106, wobei ein erstes Abstimmelement 111_1 mit dem zweiten Kapazitätselement 110_2 verbunden sein kann (z.B. parallel zu dem zweiten Kapazitätselement 110_2 geschaltet sein), wobei ein zweites Abstimmelement 111_2 mit dem dritten Kapazitätselement 110_3 verbunden sein kann (z.B. parallel zu dem dritten Kapazitätselement 110_2 geschaltet sein kann), und wobei ein drittes Abstimmelement 111_2 mit dem vierten Kapazitätselement 110_4 verbunden sein kann (z.B. parallel zu dem vierten Kapazitätselement 110_4 geschaltet sein kann).

Wie in Fig. 31 zu erkennen ist, können die Abstimmelemente 111_1-111_3 jeweils ein anti-seriell geschaltetes Kapazitätsdiodenpaar aufweisen.

Ein Knoten zwischen dem jeweiligen anti-seriell geschalteten Kapazitätsdiodenpaar kann hierbei über einen jeweiligen Widerstand 210 mit einem der Anschlüsse des jeweiligen Widerstandselements 220_2-220_3 verbunden sein, da die Steuerspannung (z.B. Abstimmspannung), mit der das seriell geschaltete Kapazitätsdiodenpaar auf den gewünschten Kapazitätswert eingestellt bzw. abgestimmt wird, über die erste Schleife 108_1 und die zweite Schleife 108_2 der magnetischen Antenne 106 geführt wird. Hierzu können die Kapazitätselemente 110_2-110_n ebenfalls durch jeweils einen Widerstand 212 überbrückt werden.

Ein erster Abstimmanschluss 204_1 (tune +) kann hierbei über das erste Widerstandselement 220_1 und einen ersten Widerstand 214_1 mit der zweiten Schleife 108_2 verbunden sein, wobei der erste Widerstand 214_1 in Reihe zu dem ersten Widerstandselement 220_1 geschaltet ist. Ein zweiter Abstimmanschluss 204_2 (tune -) kann über einen zweiten Widerstand 214_2 mit einem ersten Anschluss des ersten Kapazitätselements 110_1 verbunden sein, während ein zweiter Anschluss des ersten Kapazitätselements 110_1 über einen dritten Widerstand 214_3 auf ein Bezugspotential (z.B. Masse) geschaltet sein kann. Im Prinzip könnten der erste Widerstand 214_1 und der dritte Widerstand 214_3 auch entfallen, da die DC-Abstimmspannung bereits über die Widerstandselemente 220_1 und 214_2 auf den Innen- bzw. Außenring 108_1 und 108_2 gebracht wird (oder umgekehrt). Die hier gezeigte doppelte Einspeisung dient nur der Verringerung des Spannungsabfalles über die Widerstände 220_2...4. Siehe Ausführungen weiter unten.

Die Steuerspannung (z.B. Abstimmspannung) kann beispielsweise von einer Abstimmeinrichtung 120 bereitgestellt werden, wie sie in Abschnitt 2 beschrieben ist.

Mit anderen Worten, Fig. 31 zeigt eine Zufuhr der Kapazitätsdioden-Steuerspannung über einen geschlitzte Schleife 108_1 und 108_2. Auch hier ist die eingezeichnete Mantelwellensperre 216 für den späteren Betrieb überflüssig.

Im Gegensatz zu Fig. 30 fließt hier über alle Widerstände 212, 220_1-220_4, 214_1-214_3 (Rp) nur der Sperrstrom. Die erste Schleife 108_1 (der äußere Ring) trägt also im Wesentlichen Massepotential, die zweite Schleife 108_2 (der innere Ring) das Potential vom Abstimmanschluss 204_1 (tune +). Da also an jedem der Widerstände 212, 220_1-220_4, 214_1-214_3 nur eine sehr kleine vernachlässigbare Spannung abfällt, erreicht auch jedes Kapazitätsdiodenpärchen die volle Steuerspannung. Damit die Schleife 108_1 und 108_2 nach wie vor in voller Breite für den HF-Strom zur Verfügung steht, können beide Ringe 108_1 und 108_2 mehr oder minder äquidistant kapazitiv gebrückt werden. Für 868 MHz wären sicher schon 100 pF ausreichend. Ein kapazitives Brücken kann auch durch das enge Beieinanderliegen oder das Führen von Streifen übereinander auf verschiedenen Lagen der PCB erfolgen (PCB = Printed Circuit Board, dt. Leiterplatte). Hier ist bei mehrlagigen Platinen mit beispielsweise vier Lagen auch eine verschachtelte Führung möglich, um die kapazitive Kopplung zu erhöhen. Beispielsweise könnte die erste Schleife 108_1 auf einer ersten Lage und einer dritten Lage ausgeführt sein, während die zweite Schleife 108_2 auf einer zweiten Lage und einer vierten Lage ausgeführt sein kann.

Bei Ausführungsbeispielen kann die Antennenanordnung 104 eine einfach oder mehrfach geschlitzte Schleife aufweisen.

Bei Ausführungsbeispielen kann die Steuerspannung oder das Steuersignal über die einzelnen Streifen (erste Schleife 108_1 und zweite Schleife 108_2) geführt werden.

Bei Ausführungsbeispielen können die einzelnen Streifen (erste Schleife 108_1 und zweite Schleife 108_2) kapazitiv gebrückt werden.

Bei Ausführungsbeispielen können zwei oder mehr Streifen (erste Schleife 108_1 und zweite Schleife 108_2) übereinander auf zwei oder mehreren Lagen einer PCB geführt werden.

Bei Ausführungsbeispielen kann ein kapazitives Brücken durch dieses Übereinanderlegen auf mehreren PCB Lagen erfolgen.

Bei Ausführungsbeispielen kann eine Abstimmung an einer oder mehreren Stellen mit parallel anliegender Steuerspannung/Steuersignalen erfolgen.

6. Verringerung der Signalspannung an der Kapazitätsdiode

Eine Kapazitätsdiode kann nicht beliebig weit ausgesteuert werden. So liegt die Grenze der Sperrspannung i.a. bei knapp über 30 V, oftmals sogar weit darunter (siehe z.B. [8]). Eine sehr hohe überlagerte hochfrequente Spannung muss nicht notwendigerweise gleich zu einer Zerstörung des Bauteils führen, es können aber dadurch Nichtlinearitäten entstehen, die unerwünschte Oberwellen erzeugen. Zwar werden diese über die Resonanzeigenschaft der Schleife 108 entsprechend gedämpft, doch ist es stets besser, diese gleich in ihrer Entstehung zu vermeiden. Somit ist es erstrebenswert, die HF-Spannung an den Kapazitätsdioden ausreichend klein zu halten. Dies erreicht man z.B.

1) Durch mehrfach kapazitive Verkürzung des Loops (bereits angemeldet ×1880/×1881 bzw. bekannt)
2) Durch Kaskadierung mehrerer Diodenpärchen (Stand der Technik, s. z.B. /6/)
3) Durch Einbindung der Kapazitätsdioden an Stellen geringerer HF-Spannung (neu)

Die Versionen 2) und 3) seien an Fig. 32 erläutert (entnommen aus [7]).

Im Detail zeigen Fig. 32a-c drei unterschiedliche Ausführungen eines Abstimmelements 111, das parallel zu einem jeweiligen Kapazitätselement 110_2 geschaltet ist, wobei Fig. 32a eine normale Konfiguration zeigt, bei der die Dioden parallel zur Rest-Resonanzkapazität C1 liegen, wobei Fig. 32b eine zweifach aufgestockte Konfiguration zeigen parallel zur Resonanzkapazität C2, und wobei Fig. 32c eine Variante mit Spannungsteiler 2C1 und C3 zeigt. Ck ist hierbei ein Koppelkondensator mit $X_{Ck} \rightarrow 0$.

Fig. 32c soll beispielhaft zeigen, dass das Diodenpärchen parallel zu C3 im gewünschten Resonanzfall etwas mehr als die Kapazität 2C1 ergibt, so dass in Summe etwa ein wirksamer Kapazitätswert nach Fig. 32a resultiert (*Ck* fungiert ja als HF-Kurzschluss). Man sieht, dass sich durch die Maßnahme von Fig. 32c die anliegende HF-Spannung an dem Diodenpärchen in etwa halbiert. Allerdings kann damit bei gleichem Kapazitätsvariationsbereich der Dioden die Resonanzfrequenz der Schleife weniger weit verstimmt werden, da sich der Kapazitätshub nach den Gesetzen der Parallel- und Serienschaltung von Kapazitäten geringer in die Gesamtkapazität einbringt. Im Grenzfall kann die Kapazität C3 nach Fig. 32c auch den Wert Null annehmen. Dann bildet das Kapazitätsdiodenpärchen mit der darüber befindlichen Kapazität 2C1 (die dann natürlich einen ganz anderen Wert haben kann) einen kapazitiven Spannungsteiler. Der Einfluss der Dioden auf die Resonanzfrequenz nimmt dann i.a. zwar zu, allerdings auch die an ihnen liegende HF-Spannung.

6. Weitere Ausführungsbeispiele

Ausführungsbeispiele der vorliegenden Erfindung schaffen (z.B. selbstabstimmende) magnetische Antennen für z. B. Sensorknoten. Mit dem IoT, dem Internet der Dinge (engl. Internet of Things) wächst die Anzahl der drahtlos kommunizierenden Sensorknoten. Hierbei werden auch immer stärkere Anforderungen an einen kleinen Formfaktor und eine einfache Handhabbarkeit gestellt. Diese Anforderungen können mit bestehenden elektrischen Antennen nur schlecht erfüllt werden. Ausführungsbeispiele der vorliegenden Erfindung ermöglichen es magnetische Antennen in Sensorknoten einzusetzen und somit die vorgenannten Anforderungen zu erfüllen.

Die hierin beschriebenen Ausführungsbeispiele können in einem Kommunikationssystem, wie es Beispielsweise im ETSI Standard TS 103 357 [7] spezifiziert ist, Anwendung finden. Natürlich können die hierin beschriebenen Ausführungsbeispiele auch in anderen Kommunikationssystemen Anwendung finden, wie z.B. WLAN, Bluetooth, ZigBee, usw.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt.

Diese kann eine universell einsetzbare Hardware wie ein Computerprozessor (CPU) sein oder für das Verfahren spezifische Hardware, wie beispielsweise ein ASIC.

Die hierin beschriebenen Vorrichtungen können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Vorrichtungen, oder jedwede Komponenten der hierin beschriebenen Vorrichtungen können zumindest teilweise in Hardware und/oder in Software (Computerprogramm) implementiert sein.

Die hierin beschriebenen Verfahren können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Verfahren, oder jedwede Komponenten der hierin beschriebenen Verfahren können zumindest teilweise durch Hardware und/oder durch Software ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

Literaturverzeichnis

[1] https://de.wikipedia.org/wiki/Schwingkreis

[2] J. Bollenbeck, R. Oppelt: "Ein neuartiges Tracking-Filter für hochwertige LO-Signale", UKW-Berichte 3/2013, S. 157 - 176

[3] US 7,890,070

[4] https://de.wikipedia.org/wiki/Gilbertzelle

[5] J. v. Parpart: "Breitbandige Ferrit-Hochfrequenztransformatoren", Hüthig GmbH, Heidelberg, 1997

[6] DE 10 2011 082 098 B4

[7] ETSI TS 103 357

[8] https://www.infineon.com/dgdl/Infineon-BB833SERIES-DS-v01_01-en.pdf?fileld=db3a304313d846880113d969a38b0112

[9] Fa. Studer-Revox: "B760 Schaltplansammlung"

[10] Xinqiang Yan et al.: "A monople/loop dual-tunded RF coil for ultrahigh field MRI", http://qims.amegroups.com/article/view/4219/5131

[11] Hans Würtz: "DX-Antennen mit spiegelnden Flächen"; DL2FA, Mauthäuslerstr. 47, 8000 München 70 (12. Teil; Fortsetzung aus cq-DL 12/81, Seite 583)

[12] Hans Nussbaum: "Magnetantennen: Selbstbau-Loops für Sende- und Empfangsbetrieb"; Verlag für Technik und Handwerk; Auflage: 3., veränd. Neuaufl. (25. Februar 2008); 3881803858


**Patentansprüche**

**1.** Antennenanordnung (104), mit folgenden Merkmalen:

einer magnetischen Antenne (106) mit einer mehrfach unterbrochenen Schleife (108) und zumindest einem Abstimmelement (111) zur Abstimmung der magnetischen Antenne (106),

wobei die Schleife (108) der magnetischen Antenne (106) durch mehrere Kapazitätselemente (110_1-110_n) mehrfach unterbrochen ist,
wobei ein Signal an einem ersten Punkt (116_1) der mehrfach unterbrochenen Schleife (108) in die magnetische Antenne (106) eingekoppelt und/oder aus der magnetischen Antenne (106) ausgekoppelt wird,
wobei das zumindest eine Abstimmelement (111) an die magnetische Antenne (106) an zumindest einem zweiten Punkt (116_2) der mehrfach unterbrochenen Schleife (108) angekoppelt ist,
wobei der erste Punkt (116_1) und der zumindest eine zweite Punkt (116_2) unterschiedlich sind;
wobei die Antennenanordnung so eingerichtet ist, dass das Signal über ein erstes Kapazitätselement (110_1) der mehreren Kapazitätselemente (110_1-110_n) in die magnetische Antenne (106) eingekoppelt und/oder aus der magnetischen Antenne (106) ausgekoppelt wird,
wobei das zumindest eine Abstimmelement (111) über zumindest ein zweites Kapazitätselement (110_2) der mehreren Kapazitätselemente (110_1-110_n) mit der magnetischen Antenne (106) verbunden ist oder wobei zumindest ein zweites Kapazitätselement (110_2) der mehreren Kapazitätselemente (110_1-110_n) das zumindest eine Abstimmelement (111) ist,
wobei, in einer Draufsicht auf die mehrfach unterbrochene Schleife (108), das zweite Kapazitätselement (110_2) unsymmetrisch in Bezug auf eine Achse (202) angeordnet ist, die durch das erste Kapazitätselement (110_1) und einem Zentrum der Schleife (108) verläuft.

**2.** Antennenanordnung (104) nach dem vorangehenden Anspruch,
wobei, in einer Draufsicht auf die mehrfach unterbrochene Schleife (108), das erste Kapazitätselement (110_1) und das zweite Kapazitätselement (110_2) unmittelbar benachbarte Kapazitätselemente sind.

**3.** Antennenanordnung (104) nach einem der Ansprüche 1 bis 2,

wobei die Antennenanordnung so eingerichtet ist, dass das Signal über eine Koppelschleife (128) in die magnetische Antenne (106) eingekoppelt und/oder aus der magnetischen Antenne (106) ausgekoppelt wird,
oder wobei das Signal kapazitiv in die magnetische Antenne (106) eingekoppelt und/oder aus der magnetischen Antenne (106) ausgekoppelt wird.

**4.** Antennenanordnung (104) nach einem der vorangehenden Ansprüche,
wobei ein Antennenanschluss (119) der Antennenanordnung (104) mit der magnetischen Antenne (106) über zumindest einen Anpassungskondensator (117) kapazitiv gekoppelt ist.

**5.** Antennenanordnung (104) nach einem der Ansprüche 1 bis 2,

wobei die Antennenanordnung so eingerichtet ist, dass das Signal über eine Koppelschleife (128) in die magnetische Antenne (106) eingekoppelt und/oder aus der magnetischen Antenne (106) ausgekoppelt wird,
wobei das zumindest eine Abstimmelement (111) über zumindest ein zweites Kapazitätselement (110_2) der mehreren Kapazitätselemente (110_1-110_n) mit der magnetischen Antenne (106) verbunden ist oder wobei zumindest ein zweites Kapazitätselement (110_2) der mehreren Kapazitätselemente (110_1-110_n) das zumindest eine Abstimmelement (111) ist;
wobei die Koppelschleife (128) im Wesentlichen benachbart zu einem Abschnitt der Schleife (108) angeordnet ist, der zumindest um 1/8 eines Umfangs der Schleife (108) von dem zumindest einen zweiten Kapazitätselement (110_2) entfernt ist.

**6.** Antennenanordnung (104) nach einem der vorangehenden Ansprüche,

wobei das zumindest eine Abstimmelement (111) einen einstellbaren Kapazitätswert oder Induktivitätswert aufweist,
oder wobei das zumindest eine Abstimmelement (111) eine variable Kapazität aufweist.

**7.** Antennenanordnung (104) nach einem der vorangehenden Ansprüche,

wobei das zumindest eine Abstimmelement (111) schaltbare Kondensatoren aufweist,
und/oder
wobei das zumindest eine Abstimmelement (111) schaltbare Induktivitäten aufweist.

**8.** Antennenanordnung (104) nach einem der vorangehenden Ansprüche,

wobei die Antennenanordnung (104) eine Abstimmeinrichtung (120) aufweist, die mit dem zumindest einen Abstimmelement (111) verbunden ist,
oder wobei die Antennenanordnung (104) eine Abstimmeinrichtung (120) aufweist, die mit dem zumindest einen Abstimmelement (111) verbunden ist, wobei die Abstimmeinrichtung (120) über die mehrfach unterbrochene Schleife (108) mit dem Abstimmelement verbunden ist.

**9.** Antennenanordnung (104) nach einem der vorangehenden Ansprüche,

wobei das Kapazitätselement oder zumindest eines der Kapazitätselemente zwei seriell geschaltete Kondensatoren aufweist,
wobei das zumindest eine Abstimmelement (111) parallel zu einem der zwei seriell geschalteten Kondensatoren, die einen Spannungsteiler bilden, geschaltet ist.

**10.** Antennenanordnung (104), mit folgenden Merkmalen:

einer magnetischen Antenne (106) mit einer mehrfach unterbrochenen Schleife (108) und zumindest einem Abstimmelement (111) zur Abstimmung der magnetischen Antenne (106),
wobei die Schleife (108) der magnetischen Antenne (106) durch ein oder mehrere Kapazitätselemente (110_1-110_n) unterbrochen ist,
wobei die Antennenanordnung so eingerichtet ist, dass ein Signal an einem ersten Punkt (116_1) der mehrfach unterbrochenen Schleife (108) in die magnetische Antenne (106) eingekoppelt und/oder aus der magnetischen Antenne (106) ausgekoppelt wird,
wobei das zumindest eine Abstimmelement (111) an die magnetische Antenne (106) an zumindest einem zweiten Punkt (116_2) der mehrfach unterbrochenen Schleife (108) angekoppelt ist,
wobei der erste Punkt (116_1) und der zumindest eine zweite Punkt (116_2) unterschiedlich sind,
wobei die Antennenanordnung (104) eine Abstimmeinrichtung (120) aufweist, die mit dem zumindest einen Abstimmelement (111) verbunden ist,
wobei die Abstimmeinrichtung (120) über die mehrfach unterbrochene Schleife (108) mit dem Abstimmelement verbunden ist.

**11.** Antennenanordnung (104), mit folgenden Merkmalen:

einer magnetischen Antenne (106) mit einer mehrfach unterbrochenen Schleife (108) und zumindest einem Abstimmelement (111) zur Abstimmung der magnetischen Antenne (106),
wobei die Schleife (108) der magnetischen Antenne (106) durch mehrere Kapazitätselemente (110_1-110_n) mehrfach unterbrochen ist,
wobei die Antennenanordnung so eingerichtet ist, dass ein Signal an einem ersten Punkt (116_1) der mehrfach unterbrochenen Schleife (108) in die magnetische Antenne (106) eingekoppelt und/oder aus der magnetischen Antenne (106) ausgekoppelt wird,
wobei das zumindest eine Abstimmelement (111) an die magnetische Antenne (106) an zumindest einem zweiten Punkt (116_2) der mehrfach unterbrochenen Schleife (108) angekoppelt ist,
wobei der erste Punkt (116_1) und der zumindest eine zweite Punkt (116_2) unterschiedlich sind,
wobei die Antennenanordnung (104) eine Abstimmeinrichtung (120) aufweist, die mit dem zumindest einen Abstimmelement (111) verbunden ist,
wobei die magnetische Antenne (106) zumindest zwei Abstimmelemente (111_1,111_2) aufweist,
wobei ein erstes Abstimmelement (111_1) der zumindest zwei Abstimmelemente (111_1,111_2) mit einem zweiten Kapazitätselement (110_2) der mehreren Kapazitätselemente (110_1-110_n) verbunden ist oder wobei das erste Abstimmelement (111_1) das zweite Kapazitätselement (110_2) ist,
wobei ein zweites Abstimmelement (111_2) der zumindest zwei Abstimmelemente (111_1,111_2) mit einem dritten Kapazitätselement (110_3) der mehreren Kapazitätselemente (110_1-110_n) verbunden ist oder wobei das zweite Abstimmelement (111_2) das dritte Kapazitätselement (110_3) ist,
wobei die Abstimmeinrichtung (120) über die mehrfach unterbrochene Schleife (108) mit dem ersten Abstimmelement (111_1) und dem zweiten Abstimmelement (111_2) verbunden ist,
wobei zumindest ein Teil der mehreren Kapazitätselemente (110_1-110_n) jeweils durch einen Widerstand (212) überbrückt werden, über den ein jeweiliger Teil des Abstimmsignals zur Abstimmung des jeweiligen Abstimmelements abfällt.

**12.** Antennenanordnung (104), mit folgenden Merkmalen:

einer magnetischen Antenne (106) mit einer mehrfach unterbrochenen Schleife (108) und zumindest einem Abstimmelement (111) zur Abstimmung der magnetischen Antenne (106),
wobei die Schleife (108) der magnetischen Antenne (106) durch ein oder mehrere Kapazitätselemente (110_1-110_n) unterbrochen ist,
wobei die Antennenanordnung so eingerichtet ist, dass ein Signal an einem ersten Punkt (116_1) der mehrfach unterbrochenen Schleife (108) in die magnetische Antenne (106) eingekoppelt und/oder aus der magnetischen Antenne (106) ausgekoppelt wird,
wobei das zumindest eine Abstimmelement (111) an die magnetische Antenne (106) an zumindest einem zweiten Punkt (116_2) der mehrfach unterbrochenen Schleife (108) angekoppelt ist,
wobei der erste Punkt (116_1) und der zumindest eine zweite Punkt (116_2) unterschiedlich sind,
wobei die Antennenanordnung (104) eine Abstimmeinrichtung (120) aufweist, die mit dem zumindest einen Abstimmelement (111) verbunden ist,
wobei die Schleife (108) eine erste Schleife (108_1) ist,
wobei die erste Schleife (108_1) durch mehrere Kapazitätselemente (110_1-110_n) mehrfach unterbrochen ist,
wobei die Antennenanordnung (104) eine zweite Schleife (108_2) aufweist,
wobei die erste Schleife (108_1) und die zweite Schleife (108_2) mehrfach kapazitiv gekoppelt sind,
wobei ein erstes Abstimmelement (111_1) des zumindest einen Abstimmelements mit einem zweiten Kapazitätselement (110_2) der mehreren Kapazitätselemente (110_1-110_n) verbunden ist oder wobei das erste Abstimmelement (111_1) das zweite Kapazitätselement (110_2) ist,
wobei die Abstimmeinrichtung (120) über die zweite Schleife (108_2) mit dem zumindest einen Abstimmelement verbunden ist,
wobei die zweite Schleife (108_2) durch mehrere Widerstandselemente (220_1-220_n) mehrfach unterbrochen ist, über die ein jeweiliger Teil des Abstimmsignals zur Abstimmung des zumindest einen Abstimmelements abfällt;
wobei zumindest ein Teil der mehreren Kapazitätselemente (110_1-110_n) jeweils durch einen Widerstand, eine Drossel, oder eine Ferritperle oder eine Serienschaltung aus einem Widerstand und einer Drossel überbrückt werden.

**13.** Antennenanordnung (104), mit folgenden Merkmalen:

einer magnetischen Antenne (106) mit einer mehrfach unterbrochenen Schleife (108) und zumindest einem Abstimmelement (111) zur Abstimmung der magnetischen Antenne (106),
wobei die Schleife (108) der magnetischen Antenne (106) durch ein oder mehrere Kapazitätselemente (110_1-110_n) unterbrochen ist,
wobei die Antennenanordnung so eingerichtet ist, dass ein Signal an einem ersten Punkt (116_1) der mehrfach unterbrochenen Schleife (108) in die magnetische Antenne (106) eingekoppelt und/oder aus der magnetischen Antenne (106) ausgekoppelt wird,
wobei das zumindest eine Abstimmelement (111) an die magnetische Antenne (106) an zumindest einem zweiten Punkt (116_2) der mehrfach unterbrochenen Schleife (108) angekoppelt ist,
wobei der erste Punkt (116_1) und der zumindest eine zweite Punkt (116_2) unterschiedlich sind,
wobei das Kapazitätselement oder zumindest eines der Kapazitätselemente zwei seriell geschaltete Kondensatoren aufweist,
wobei das zumindest eine Abstimmelement (111) parallel zu einem der zwei seriell geschalteten Kondensatoren, die einen Spannungsteiler bilden, geschaltet ist,
wobei die Antennenanordnung (104) eine Abstimmeinrichtung (120) aufweist, die mit dem zumindest einen Abstimmelement (111) verbunden ist,
wobei die Abstimmeinrichtung (120) über die Schleife (108) mit dem zumindest einen Abstimmelement (111) verbunden ist.

**14.** Teilnehmer (100) eines drahtlosen Kommunikationssystems,

wobei der Teilnehmer (100) eine Antennenanordnung (104) nach einem der vorangehenden Ansprüche aufweist, und
wobei der Teilnehmer (100) eine Sende- und/oder Empfangseinrichtung (102) aufweist, die mit dem Antennenanschluss der magnetischen Antenne (106) verbunden ist.

**15.** Teilnehmer (100) nach dem vorangehenden Anspruch,

wobei der Teilnehmer (100) ausgebildet ist, um Daten basierend auf einem Zeit- und/oder Frequenzsprungverfahren zu senden und/oder zu empfangen,
und/oder
wobei der Teilnehmer (100) ausgebildet ist, um im ISM Band zu kommunizieren.

## Claims

1. An antenna arrangement (104), comprising:

   a magnetic antenna (106) comprising a loop (108) interrupted several times and at least one tuning element (111) for tuning the magnetic antenna (106),
   wherein the loop (108) of the magnetic antenna (106) is interrupted several times by several capacitance elements (110_1-110_n),
   wherein a signal is coupled into the magnetic antenna (106) and/or coupled out of the magnetic antenna (106) at a first point (116_1) of the loop (108) interrupted several times,
   wherein the at least one tuning element (111) is coupled to the magnetic antenna (106) at at least a second point (116_2) of the loop (108) interrupted several times,
   wherein the first point (116_1) and the at least one second point (116_2) are different;
   wherein the antenna arrangement is adapted such that the signal is coupled into the magnetic antenna (106) and/or coupled out of the magnetic antenna (106) via a first capacitance element (110_1) of the several capacitance elements (110_1-110_n),
   wherein the at least one tuning element (111) is connected to the magnetic antenna (106) via at least a second capacitance element (110_2) of the several capacitance elements (110_1-110_n), or wherein at least a second capacitance element (110_2) of the several capacitance elements (110_1-110_n) is the at least one tuning element (111),
   wherein, in a top view of the loop (108) interrupted several times, the second capacitance element (110_2) is arranged asymmetrically with respect to an axis (202) running through the first capacitance element (110_1) and a center of the loop (108).

2. The antenna arrangement (104) according to the preceding claim,
   wherein, in a top view of the loop (108) interrupted several times, the first capacitance element (110_1) and the second capacitance element (110_2) are immediately adjacent capacitance elements.

3. The antenna arrangement (104) according to claim 1 or 2,

   wherein the antenna arrangement is adapted such that the signal is coupled into the magnetic antenna (106) and/or coupled out of the magnetic antenna (106) via a coupling loop (128),
   or wherein the signal is capacitively coupled into the magnetic antenna (106) and/or coupled out of the magnetic antenna (106).

4. The antenna arrangement (104) according to any of the preceding claims,
   wherein an antenna terminal (119) of the antenna arrangement (104) is capacitively coupled to the magnetic antenna (106) via at least one matching capacitor (117).

5. The antenna arrangement (104) according to any one of claims 1 to 2,

   wherein the antenna arrangement is adapted such that the signal is coupled into the magnetic antenna (106) and/or coupled out of the magnetic antenna (106) via a coupling loop (128), wherein the at least one tuning element (111) is connected to the magnetic antenna (106) via at least a second capacitance element (110_2) of the several capacitance elements (110_1-110_n), or wherein at least a second capacitance element (110_2) of the several capacitance elements (110_1-110_n) is the at least one tuning element (111);
   wherein the coupling loop (128) is arranged essentially adjacent to a portion of the loop (108) that is at least 1/8 of a circumference of the loop (108) apart from the at least one second capacitance element (110_2).

6. The antenna arrangement (104) according to any of the preceding claims,

   wherein the at least one tuning element (111) comprises an adjustable capacitance value or inductance value,

or wherein the at least one tuning element (111) comprises a variable capacitance.

**7.** The antenna arrangement (104) according to any of the preceding claims,

wherein the at least one tuning element (111) comprises switchable capacitors,
and/or
wherein the at least one tuning element (111) comprises switchable inductances.

**8.** The antenna arrangement (104) according to any of the preceding claims,

wherein the antenna arrangement (104) comprises a tuning means (120) connected to the at least one tuning element (111),
or wherein the antenna arrangement (104) comprises a tuning means (120) connected to the at least one tuning element (111), wherein the tuning means (120) is connected to the tuning element via the loop (108) interrupted several times.

**9.** The antenna arrangement (104) according to any of the preceding claims,

wherein the capacitance element or at least one of the capacitance elements comprises two capacitors connected in series,
wherein the at least one tuning element (111) is connected in parallel to one of the two capacitors connected in series forming a voltage divider.

**10.** An antenna arrangement (104), comprising:

a magnetic antenna (106) comprising a loop (108) interrupted several times and at least one tuning element (111) for tuning the magnetic antenna (106),
wherein the loop (108) of the magnetic antenna (106) is interrupted by one or more capacitance elements (110_1-110_n),
wherein the antenna arrangement is adapted such that a signal is coupled into the magnetic antenna (106) and/or coupled out of the magnetic antenna (106) at a first point (116_1) of the loop (108) interrupted several times,
wherein the at least one tuning element (111) is coupled to the magnetic antenna (106) at at least a second point (116_2) of the loop (108) interrupted several times,
wherein the first point (116_1) and the at least one second point (116_2) are different,
wherein the antenna arrangement (104) comprises a tuning means (120) connected to the at least one tuning element (111),
wherein the tuning means (120) is connected to the tuning element via the loop (108) interrupted several times.

**11.** An antenna arrangement (104), comprising:

a magnetic antenna (106) comprising a loop (108) interrupted several times and at least one tuning element (111) for tuning the magnetic antenna (106),
wherein the loop (108) of the magnetic antenna (106) is interrupted several times by several capacitance elements (110_1-110_n),
wherein the antenna arrangement is adapted such that a signal is coupled into the magnetic antenna (106) and/or coupled out of the magnetic antenna (106) at a first point (116_1) of the loop (108) interrupted several times,
wherein the at least one tuning element (111) is coupled to the magnetic antenna (106) at at least a second point (116_2) of the loop (108) interrupted several times,
wherein the first point (116_1) and the at least one second point (116_2) are different,
wherein the antenna arrangement (104) comprises a tuning means (120) connected to the at least one tuning element (111),
wherein the magnetic antenna (106) comprises at least two tuning elements (111_1,111_2),
wherein a first tuning element (111_1) of the at least two tuning elements (111_1,111_2) is connected to a second capacitance element (110_2) of the several capacitance elements (110_1-110_n) or wherein the first tuning element (111_1) is the second capacitance element (110_2),
wherein a second tuning element (111_2) of the at least two tuning elements (111_1,111_2) is connected to a third capacitance element (110_3) of the several capacitance elements (110_1-110_n) or wherein the second tuning element (111_2) is the third capacitance element (110_3),
wherein the tuning means (120) is connected to the first tuning element (111_1) and the second tuning element (111_2) via the loop (108) interrupted several times,
wherein at least part of the several capacitance elements (110_1-110_n) are each bridged by a resistor (212) across which a respective portion of the tuning signal for tuning the respective tuning element drops.

**12.** An antenna arrangement (104), comprising:

a magnetic antenna (106) comprising a loop (108) interrupted several times and at least one tuning element (111) for tuning the magnetic antenna (106),
wherein the loop (108) of the magnetic antenna is interrupted by one or several capacitance elements (110_1-110_n),
wherein the antenna arrangement is adapted such that a signal is coupled into the magnetic antenna (106) and/or coupled out of the magnetic antenna (106) at a first point (116_1) of the loop (108) interrupted several times,
wherein the at least one tuning element (111) is coupled to the magnetic antenna (106) at at least a second point (116_2) of the loop (108) interrupted several times,
wherein the first point (116_1) and the at least one second point (116_2) are different,
wherein the antenna arrangement (104) comprises a tuning means (120) connected to the at least one tuning element (111),
wherein the loop (108) is a first loop (108_1),
wherein the first loop (108_1) is interrupted several times by several capacitance elements (110_1-110_n),
wherein the antenna arrangement (104) comprises a second loop (108_2),
wherein the first loop (108_1) and the second loop (108_2) are capacitively coupled several times,
wherein a first tuning element (111_1) of the at least one tuning element is connected to a second capacitance element (110_2) of the several capacitance elements (110_1-110_n) or wherein the first tuning element (111_1) is the second capacitance element (110_2),
wherein the tuning means (120) is connected to the at least one tuning element via the second loop (108_2),
wherein the second loop (108_2) is interrupted several times by several resistive elements (220_1-220_n) across which a respective portion of the tuning signal for tuning the at least one tuning element drops;
wherein at least part of the several capacitance elements (110_1 -110_n) are each bridged by a resistor, an inductor or a ferrite bead or a series connection of a resistor and an inductor.

**13.** An antenna arrangement (104), comprising:

a magnetic antenna (106) comprising a loop (108) interrupted several times and at least one tuning element (111) for tuning the magnetic antenna (106),
wherein the loop (108) of the magnetic antenna (106) is interrupted by one or more capacitance elements (110_1-110_n),
wherein the antenna arrangement is adapted such that a signal is coupled into the magnetic antenna (106) and/or coupled out of the magnetic antenna (106) at a first point (116_1) of the loop (108) interrupted several times,
wherein the at least one tuning element (111) is coupled to the magnetic antenna (106) at at least a second point (116_2) of the loop (108) interrupted several times,
wherein the first point (116_1) and the at least one second point (116_2) are different;
wherein the capacitance element or at least one of the capacitance elements comprises two capacitors connected in series,
wherein the at least one tuning element (111) is connected in parallel to one of the two capacitors connected in series forming a voltage divider,
wherein the antenna arrangement (104) comprises a tuning means (120) connected to the at least one tuning element (111),
wherein the tuning means (120) is connected to the at least one tuning element (111) via the loop (108).

**14.** A participant (100) of a wireless communication system,

wherein the participant (100) comprises an antenna arrangement (104) according to any of the preceding claims, and

wherein the participant (100) comprises transmitting and/or receiving means (102) connected to the antenna terminal of the magnetic antenna (106).

**15.** The participant (100) according to the preceding claim,

wherein the participant (100) is configured to transmit and/or receive data based on a time and/or frequency hopping method,
and/or
wherein the participant (100) is configured to communicate in the ISM band.

## Revendications

**1.** Aménagement d'antenne (104), aux caractéristiques suivantes:

une antenne magnétique (106) avec une boucle à interruptions multiples (108) et au moins un élément d'accord (111) destiné à accorder l'antenne magnétique (106),
dans lequel la boucle (108) de l'antenne magnétique (106) est interrompue à plusieurs endroits par plusieurs éléments de capacité (110_1 à 110_n),
dans lequel un signal à un premier point (116_1) de la boucle à interruptions multiples (108) est couplé dans l'antenne magnétique (106) et/ou découplé de l'antenne magnétique (106),
dans lequel l'au moins un élément d'accord (111) est couplé à l'antenne magnétique (106) à au moins un deuxième point (116_2) de la boucle à interruptions multiples (108),
dans lequel le premier point (116_1) et l'au moins un deuxième point (116_2) sont différents;
dans lequel l'aménagement d'antenne est aménagé de sorte que le signal soit, par l'intermédiaire d'un premier élément de capacité (110_1) des plusieurs éléments de capacité (110_1 à 110_n), couplé dans l'antenne magnétique (106) et/ou découplé de l'antenne magnétique (106),
dans lequel l'au moins un élément d'accord (111) est connecté par au moins un deuxième élément de capacité (110_2) des plusieurs éléments de capacité (110_1 à 110_n) à l'antenne magnétique (106) ou dans lequel au moins un deuxième élément de capacité (110_2) des plusieurs éléments de capacité (110_1 à 110_n) est l'au moins un élément d'accord (111),
dans lequel, dans une vue de dessus de la boucle à interruptions multiples (108), le deuxième élément de capacité (110_2) est disposé de manière asymétrique par rapport à un axe (202) qui s'étend à travers le premier élément de capacité (110_1) et un centre de la boucle (108).

**2.** Aménagement d'antenne (104) selon la revendication précédente,
dans lequel, dans une vue de dessus de la boucle à interruptions multiples (108), le premier élément de capacité (110_1) et le deuxième élément de capacité (110_2) sont des éléments de capacité immédiatement adjacents.

**3.** Aménagement d'antenne (104) selon l'une des revendications 1 à 2,

dans lequel l'aménagement d'antenne est aménagé de sorte que le signal soit, par l'intermédiaire d'une boucle de couplage (128), couplé dans l'antenne magnétique (106) et/ou découplé de l'antenne magnétique (106),
ou dans lequel le signal est couplé de manière capacitive dans l'antenne magnétique (106) et/ou découplé de l'antenne magnétique (106).

**4.** Aménagement d'antenne (104) selon l'une des revendications précédentes,
dans lequel un raccord d'antenne (119) de l'aménagement d'antenne (104) est couplé de manière capacitive à l'antenne magnétique (106) par l'intermédiaire d'au moins un condensateur d'adaptation (117).

**5.** Aménagement d'antenne (104) selon l'une des revendications 1 à 2,

dans lequel l'aménagement d'antenne est aménagé de sorte que le signal soit, par l'intermédiaire d'une boucle de couplage (128), couplé dans l'antenne magnétique (106) et/ou découplé de l'antenne magnétique (106),
dans lequel l'au moins un élément d'accord (111) est connecté par l'intermédiaire d'au moins un deuxième élément de capacité (110_2) des plusieurs éléments de capacité (110_1 à 110_n) à l'antenne magnétique (106) ou dans lequel au moins un deuxième élément de capacité (110_2) des plusieurs éléments de capacité (110_1 à 110_n) est l'au moins un élément d'accord (111);

dans lequel la boucle de couplage (128) est disposée sensiblement adjacente à un segment de la boucle (108) qui est distant d'au moins 1/8 d'une circonférence de la boucle (108) de l'au moins un deuxième élément de capacité (110_2).

**6.** Aménagement d'antenne (104) selon l'une des revendications précédentes,

dans lequel l'au moins un élément d'accord (111) présente une valeur de capacité ou valeur d'inductance réglable,
ou dans lequel l'au moins un élément d'accord (111) présente une capacité variable.

**7.** Aménagement d'antenne (104) selon l'une des revendications précédentes,

dans lequel l'au moins un élément d'accord (111) présente des condensateurs commutables,
et/ou
dans lequel l'au moins un élément d'accord (111) présente des inductances commutables.

**8.** Aménagement d'antenne (104) selon l'une des revendications précédentes,

dans lequel l'aménagement d'antenne (104) présente un moyen d'accord (120) qui est connecté à l'au moins un élément d'accord (111),
ou dans lequel l'aménagement d'antenne (104) présente un moyen d'accord (120) qui est connecté à l'au moins un élément d'accord (111), dans lequel le dispositif d'accord (120) est connecté à l'élément d'accord par l'intermédiaire de la boucle à interruptions multiples (108).

**9.** Aménagement d'antenne (104) selon l'une des revendications précédentes,

dans lequel l'élément de capacité ou au moins un des éléments de capacité présente deux condensateurs connectés en série,
dans lequel l'au moins un élément d'accord (111) est connecté en parallèle avec l'un des deux condensateurs connectés en série qui forment un diviseur de tension.

**10.** Aménagement d'antenne (104), aux caractéristiques suivantes:

une antenne magnétique (106) avec une boucle à interruptions multiples (108) et au moins un élément d'accord (111) destiné à accorder l'antenne magnétique (106),
dans lequel la boucle (108) de l'antenne magnétique (106) est interrompue par un ou plusieurs éléments de capacité (110_1 à 110_n),
dans lequel l'aménagement d'antenne est aménagé de sorte qu'un signal soit, à un premier point (116_1) de la boucle à interruptions multiples (108), couplé dans l'antenne magnétique (106) et/ou découplé de l'antenne magnétique (106),
dans lequel l'au moins un élément d'accord (111) est couplé à l'antenne magnétique (106) à au moins un deuxième point (116_2) de la boucle à interruptions multiples (108),
dans lequel le premier point (116_1) et l'au moins un deuxième point (116_2) sont différents,
dans lequel l'aménagement d'antenne (104) présente un moyen d'accord (120) qui est connecté à au moins un élément d'accord (111),
dans lequel le moyen d'accord (120) est connecté à l'élément d'accord par l'intermédiaire de la boucle à interruptions multiples (108).

**11.** Aménagement d'antenne (104), aux caractéristiques suivantes:

une antenne magnétique (106) avec une boucle à interruptions multiples (108) et au moins un élément d'accord (111) destiné à accorder l'antenne magnétique (106),
dans lequel la boucle (108) de l'antenne magnétique (106) est interrompue à plusieurs endroits par plusieurs éléments de capacité (110_1 à 110_n),
dans lequel l'aménagement d'antenne est aménagé de sorte qu'un signal soit, à un premier point (116_1) de la boucle à interruptions multiples (108), couplé dans l'antenne magnétique (106) et/ou découplé de l'antenne magnétique (106),
dans lequel l'au moins un élément d'accord (111) est couplé à l'antenne magnétique (106) à au moins un deuxième point (116_2) de la boucle à interruptions multiples (108),
dans lequel le premier point (116_1) et l'au moins un deuxième point (116_2) sont différents,
dans lequel l'aménagement d'antenne (104) présente un moyen d'accord (120) qui est connecté à l'au moins un élément d'accord (111),
dans lequel l'antenne magnétique (106) présente au moins deux éléments d'accord (111_1, 111_2),
dans lequel un premier élément d'accord (111_1) des au moins deux éléments d'accord (111_1, 111_2) est connecté à un deuxième élément de capacité (110_2) des plusieurs éléments de capacité (110_1 à 110_n) ou dans lequel le premier élément d'accord (111_1) est le deuxième élément de capacité (110_2),
dans lequel un deuxième élément d'accord (111_2) des au moins deux éléments d'accord (111_1, 111_2) est connecté à un troisième élément de capacité (110_3) des plusieurs éléments de capacité (110_1 à 110_n) ou dans lequel le deuxième élément d'accord (111_2) est le troisième élément de capacité (110_3),
dans lequel le moyen d'accord (120) est connecté par l'intermédiaire de la boucle à interruptions multiples (108) au premier élément d'accord (111_1) et au deuxième élément d'accord (111_2),
dans lequel au moins une partie des plusieurs éléments de capacité (110_1 à 110_n) sont pontés, chacun, par une résistance (212) à travers laquelle une partie respective du signal d'accord tombe pour accorder l'élément d'accord respectif.

**12.** Aménagement d'antenne (104), aux caractéristiques suivantes:

une antenne magnétique (106) avec une boucle à interruptions multiples (108) et au moins un élément d'accord (111) destiné à accorder l'antenne magnétique (106),
dans lequel la boucle (108) de l'antenne magnétique (106) est interrompue par un ou plusieurs éléments de capacité (110_1 à 110_n),
dans lequel l'aménagement d'antenne est aménagé de sorte qu'un signal soit couplé à un premier point (116_1) de la boucle à interruptions multiples (108) dans l'antenne magnétique (106) et/ou découplé de l'antenne magnétique (106),
dans lequel l'au moins un élément d'accord (111) est couplé à l'antenne magnétique (106) à au moins un deuxième point (116_2) de la boucle à interruptions multiples (108),
dans lequel le premier point (116_1) et l'au moins un deuxième point (116_2) sont différents,
dans lequel l'aménagement d'antenne (104) présente un moyen d'accord (120) qui est connecté à l'au moins un élément d'accord (111),
dans lequel la boucle (108) est une première boucle (108_1),
dans lequel la première boucle (108_1) est interrompue à plusieurs endroits par plusieurs éléments de capacité (110_1 à 110_n),
dans lequel l'aménagement d'antenne (104) présente une deuxième boucle (108_2),
dans lequel la première boucle (108_1) et la deuxième boucle (108_2) sont couplées plusieurs fois de manière capacitive,
dans lequel un premier élément d'accord (111_1) de l'au moins un élément d'accord est connecté à un deuxième élément de capacité (110_2) des plusieurs éléments de capacité (110_1 à 110_n) ou dans lequel le premier élément d'accord (111_1) est le deuxième élément de capacité (110_2),
dans lequel le moyen d'accord (120) est connecté à l'au moins un élément d'accord par l'intermédiaire de la deuxième boucle (108_2),
dans lequel la deuxième boucle (108_2) est interrompue à plusieurs endroits par plusieurs éléments de résistance (220_1 à 220_n) à travers lesquels une partie respective du signal d'accord tombe pour accorder l'au moins un élément d'accord;
dans lequel au moins une partie des plusieurs éléments de capacité (110_1 à 110_n) sont pontés, chacun, par une résistance, un étrangleur ou une perle de ferrite ou un circuit série composé d'une résistance et d'un étrangleur.

**13.** Aménagement d'antenne (104), aux caractéristiques suivantes:

une antenne magnétique (106) avec une boucle à interruptions multiples (108) et au moins un élément d'accord (111) destiné à accorder l'antenne magnétique (106),
dans lequel la boucle (108) de l'antenne magnétique (106) est interrompue par un ou plusieurs éléments de capacité (110_1 à 110_n),
dans lequel l'aménagement d'antenne est aménagé de sorte qu'un signal soit, à un premier point (116_1) de la boucle à interruptions multiples (108), couplé dans l'antenne magnétique (106) et/ou découplé de l'antenne magnétique (106),

dans lequel l'au moins un élément d'accord (111) est couplé à l'antenne magnétique (106) à au moins un deuxième point (116_2) de la boucle à interruptions multiples (108),
dans lequel le premier point (116_1) et l'au moins un deuxième point (116_2) sont différents,
dans lequel l'élément de capacité ou au moins un des éléments de capacité présente deux condensateurs connectés en série,
dans lequel l'au moins un élément d'accord (111) est connecté en parallèle à l'un des deux condensateurs connectés en série qui forment un diviseur de tension,
dans lequel l'aménagement d'antenne (104) présente un moyen d'accord (120) qui est connecté à l'au moins un élément d'accord (111),
dans lequel le moyen d'accord (120) est connecté par l'intermédiaire de la boucle (108) à l'au moins un élément d'accord (111).

**14.** Abonné (100) d'un système de communication sans fil,

dans lequel l'abonné (100) présente un aménagement d'antenne (104) selon l'une des revendications précédentes, et
dans lequel l'abonné (100) présente un moyen d'émission et/ou de réception (102) qui est connecté au raccord d'antenne de l'antenne magnétique (106).

**15.** Abonné (100) selon la revendication précédente,

dans lequel l'abonné (100) est conçu pour envoyer et/ou recevoir des données sur base d'un procédé de saut dans le temps et/ou en fréquence,
et/ou
dans lequel l'abonné (100) est conçu pour communiquer dans la bande ISM.

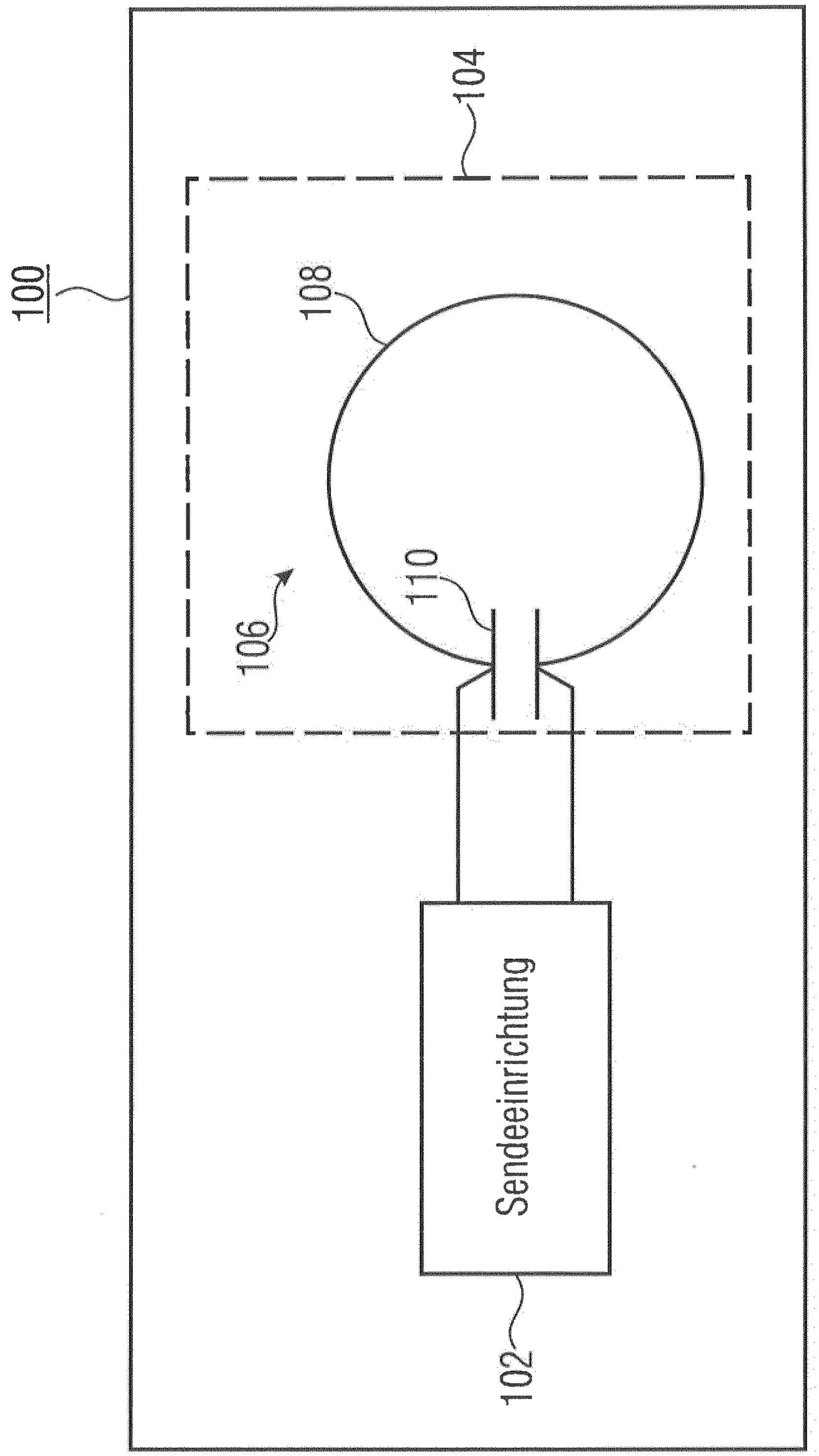


Fig. 1a

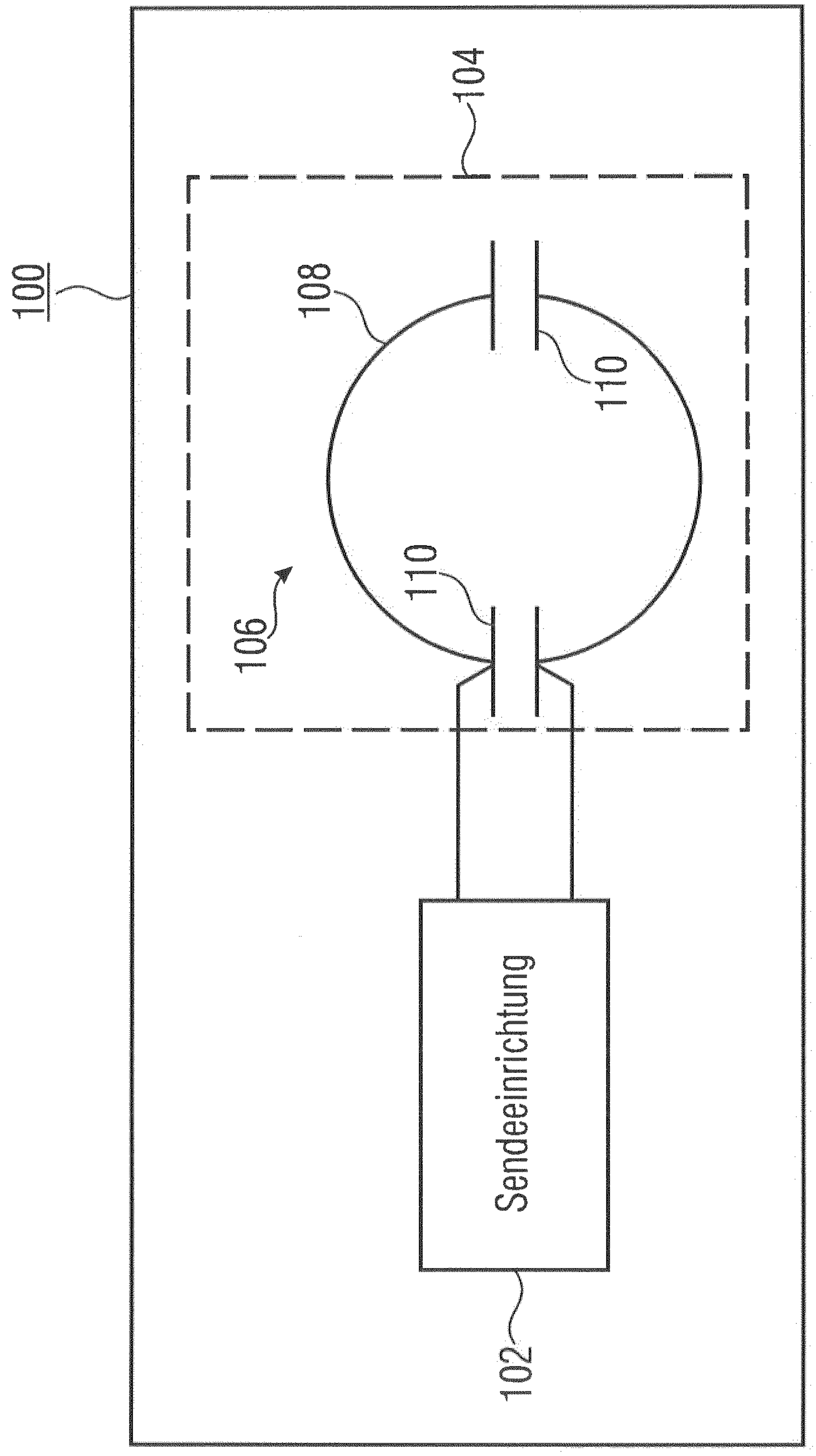


Fig. 1b

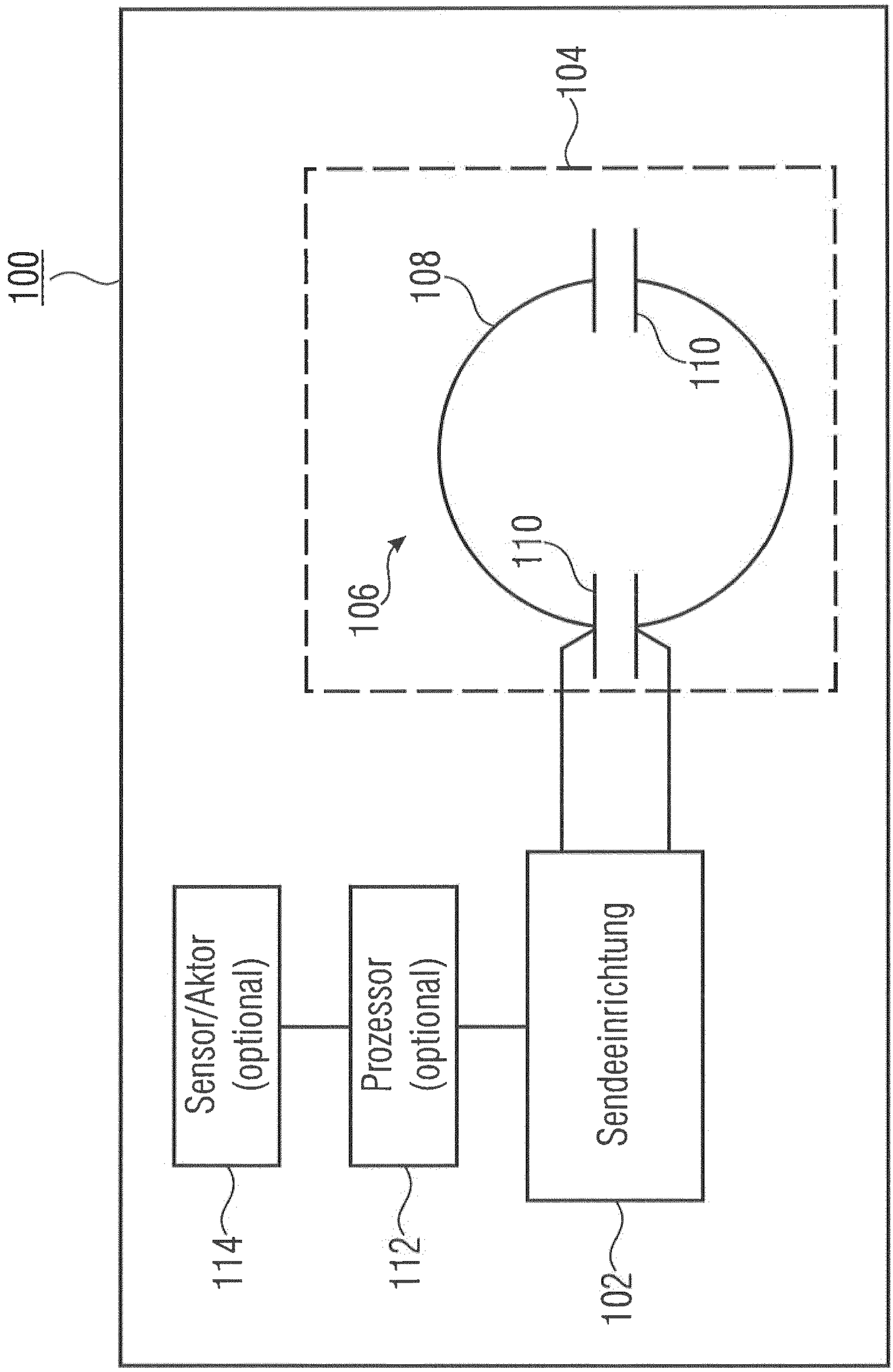
100
104
108
110
110
106
Sensor/Aktor (optional)
Prozessor (optional)
Sendeeinrichtung
114
112
102

Fig. 1c

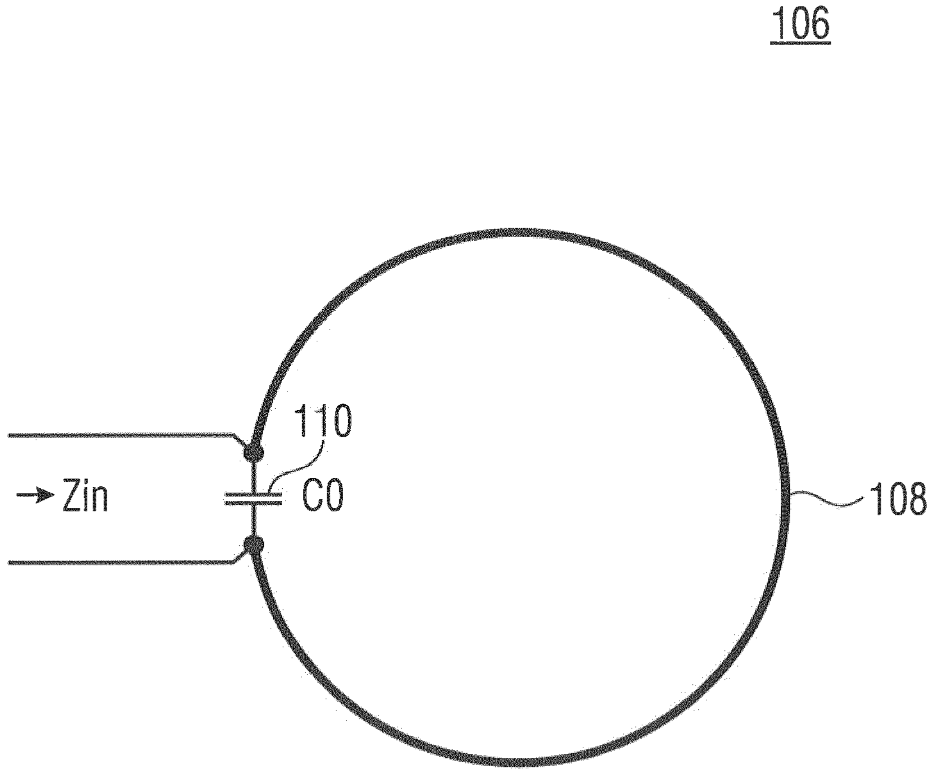


Fig. 2

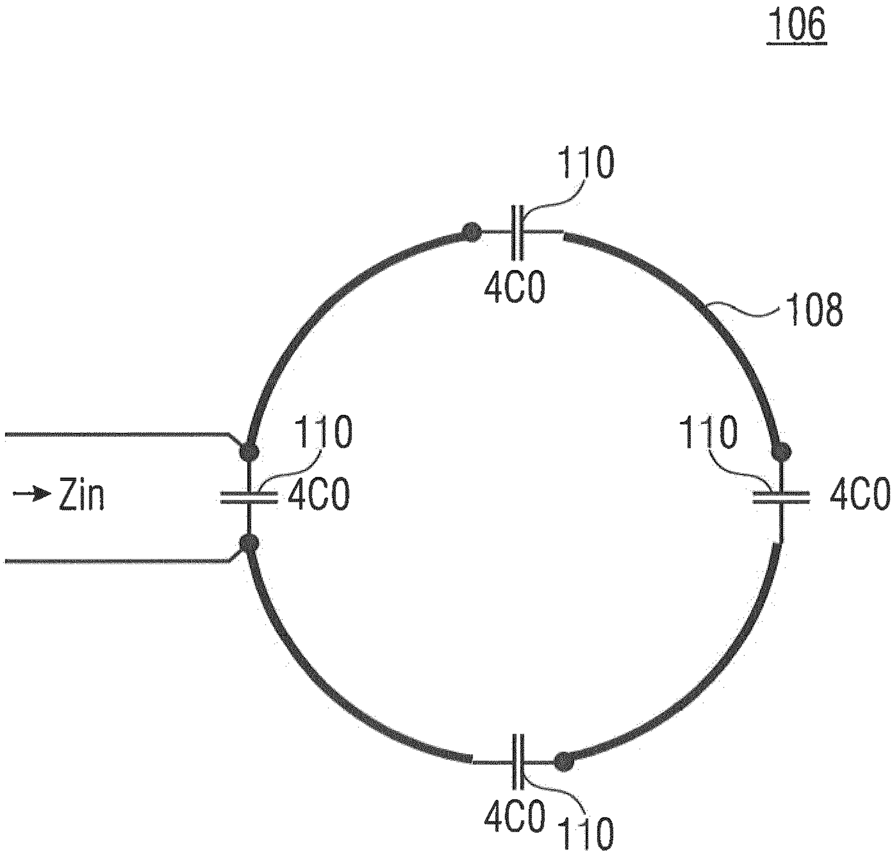


Fig. 3

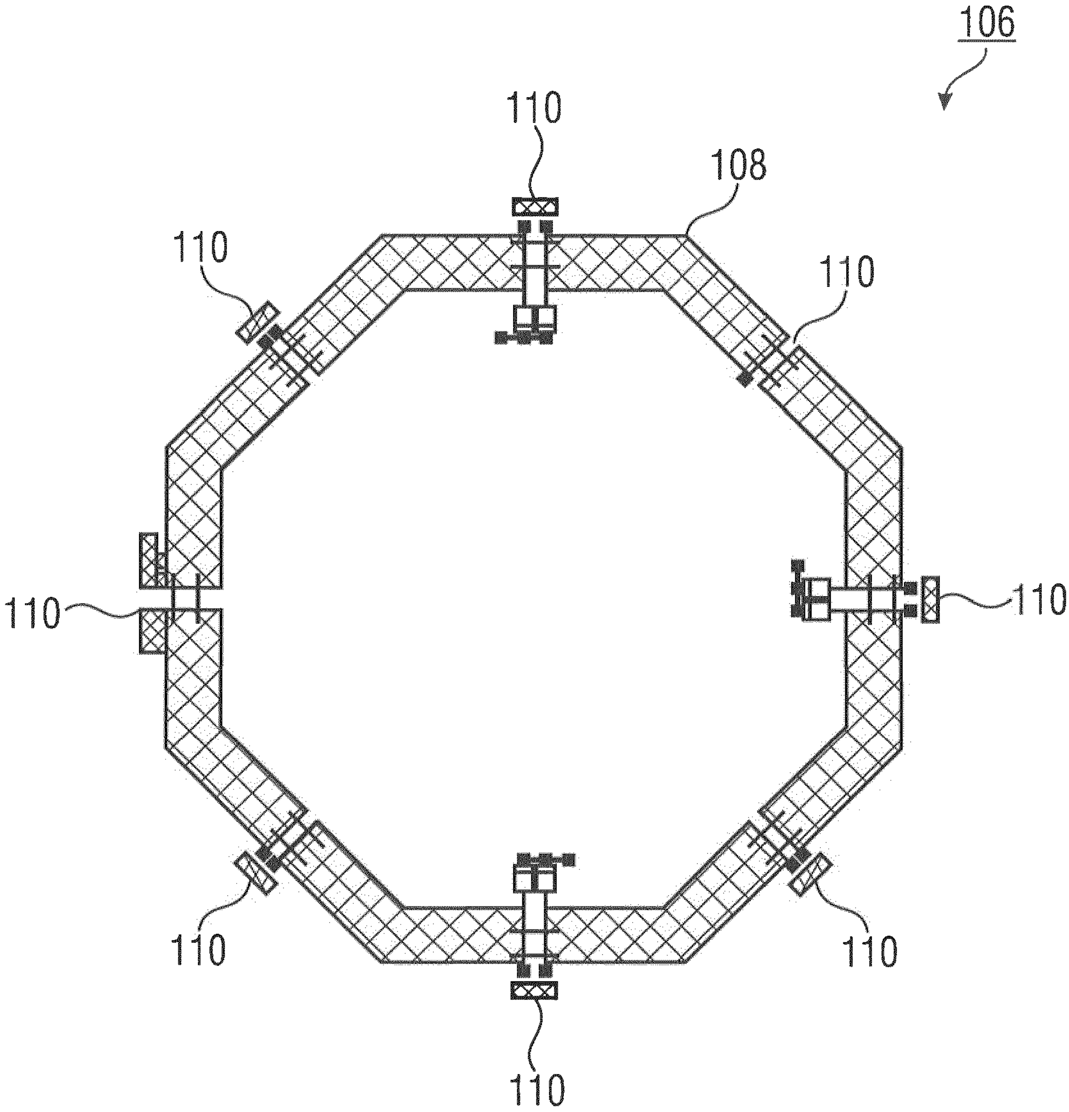


Fig. 4

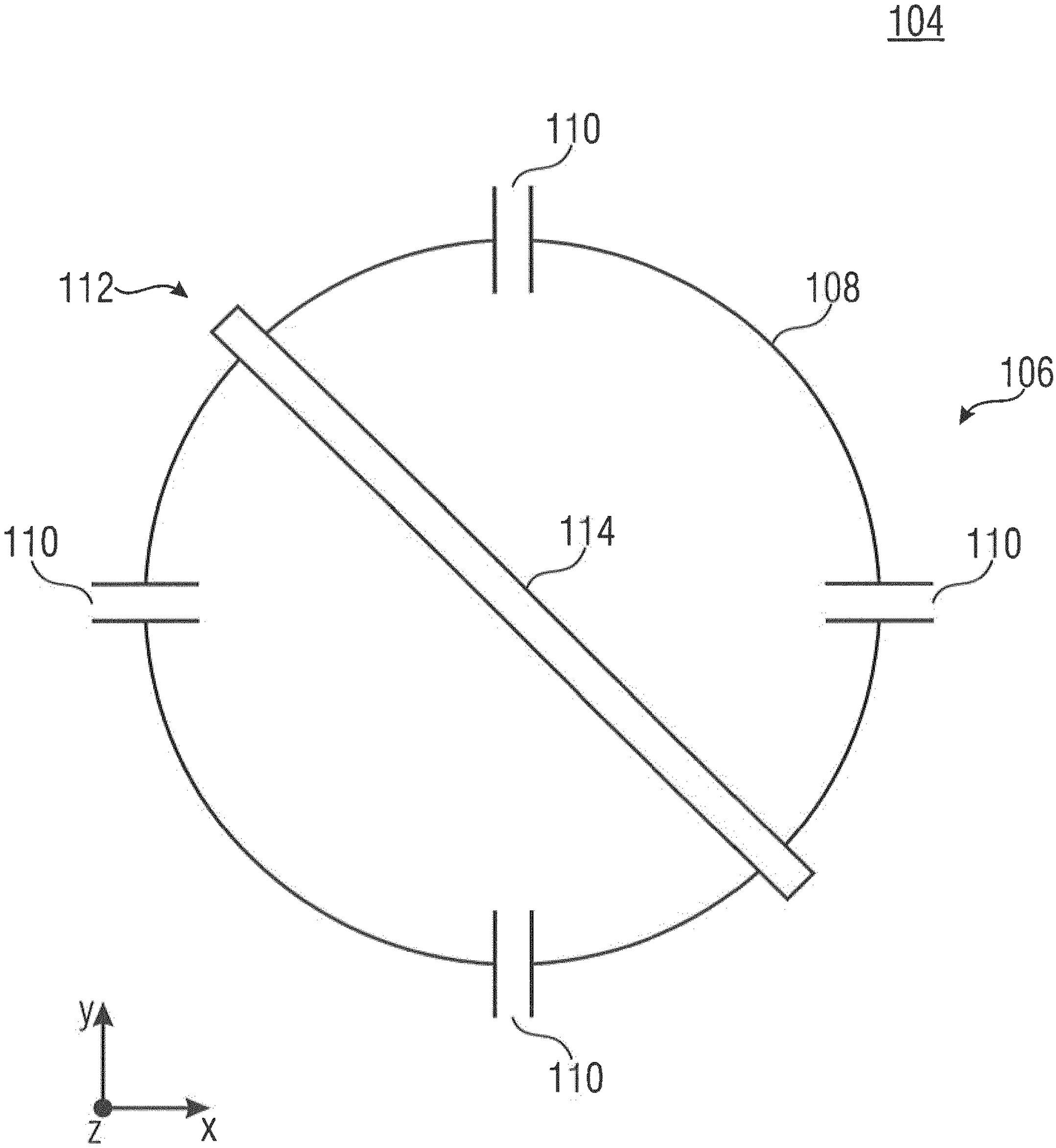


Fig. 5

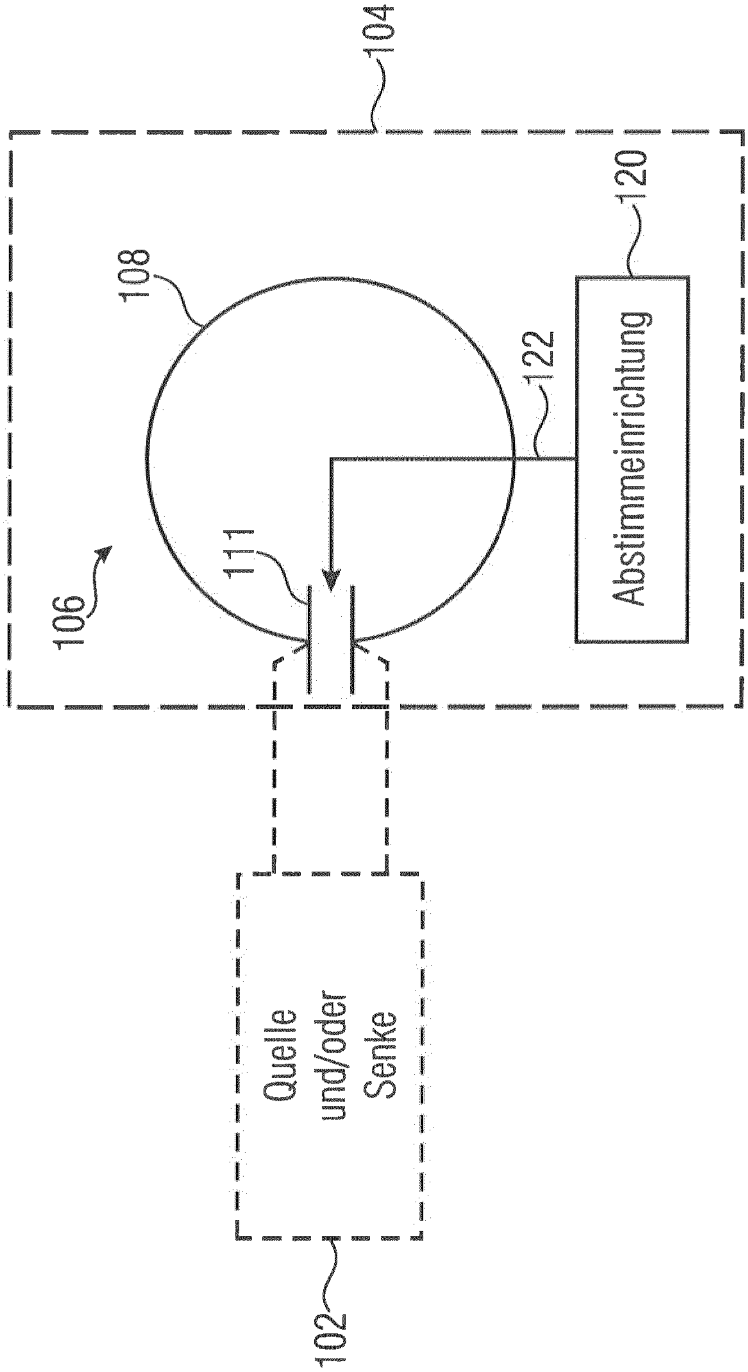
104
120
108
122
Abstimmeinrichtung
111
106
Quelle
und/oder
Senke
102

Fig. 6a

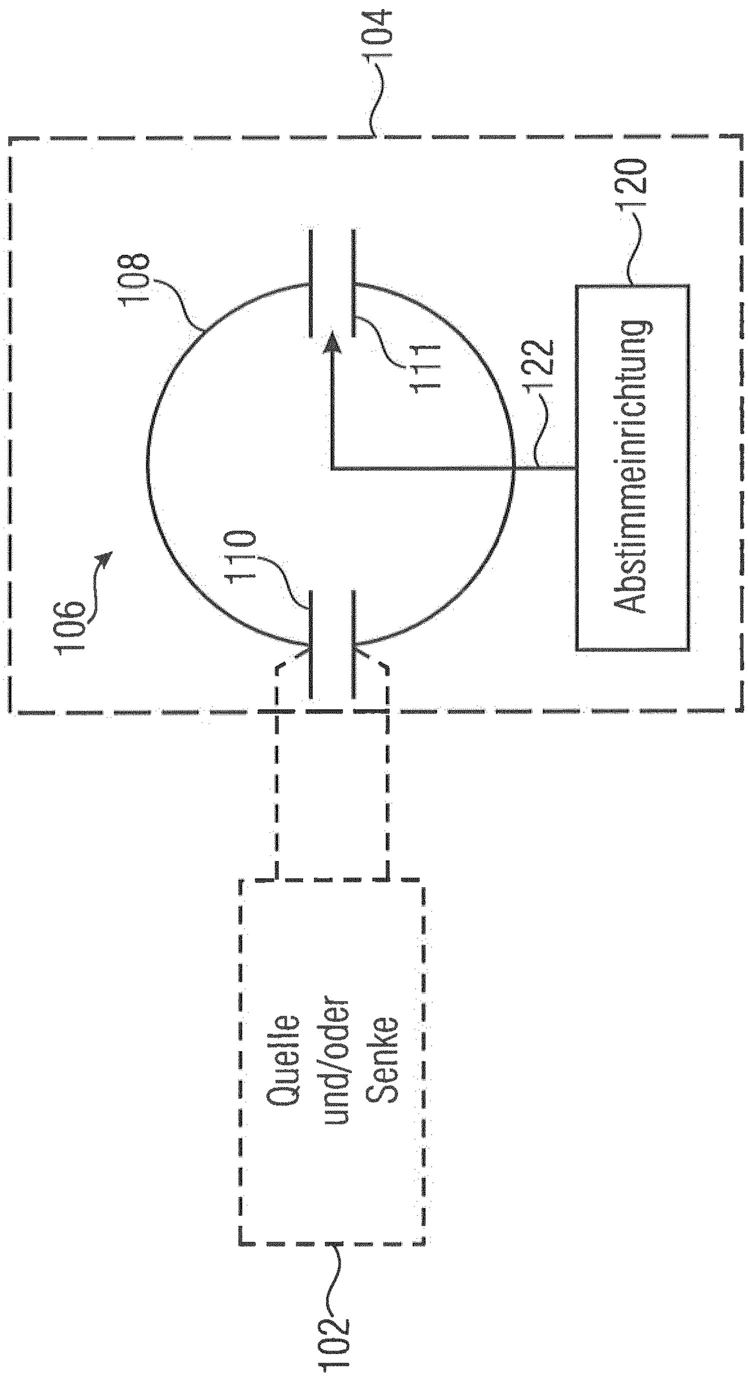
104
108
111
120
122
106
110
Abstimmeinrichtung
Quelle
und/oder
Senke
102

Fig. 6b

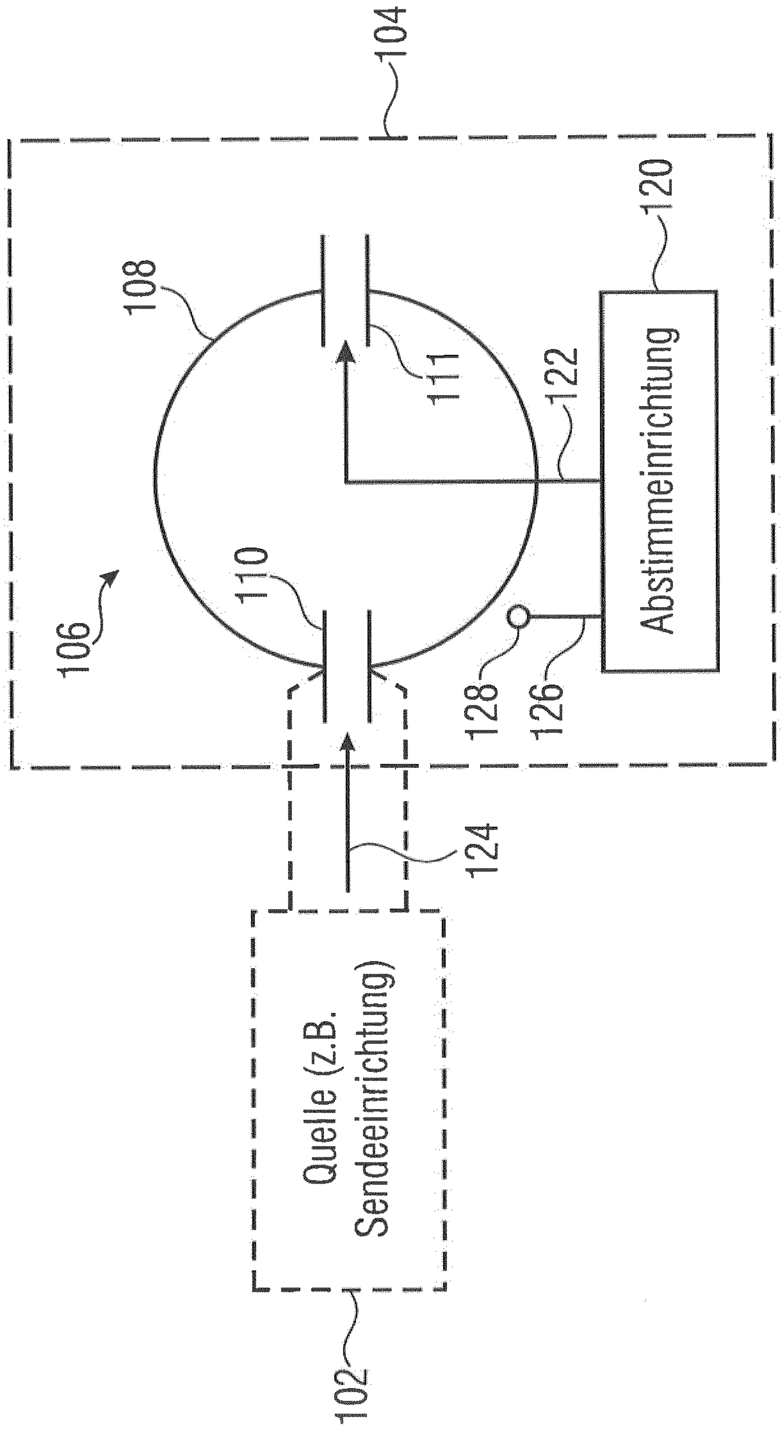
104
120
108
111
122
Abstimmeinrichtung
110
106
128
126
124
Quelle (z.B. Sendeeinrichtung)
102

Fig. 7

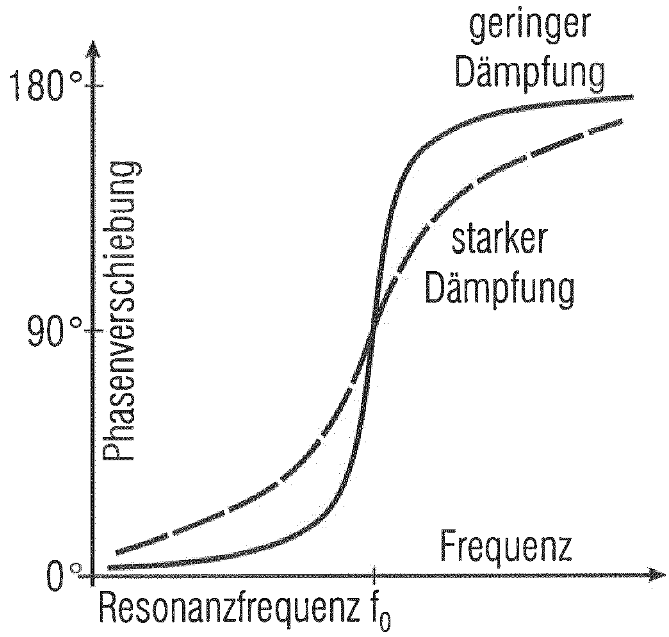


Phasenveschiebung am Schwingkreis
bei geringer und starker Dämpfung

Fig. 8

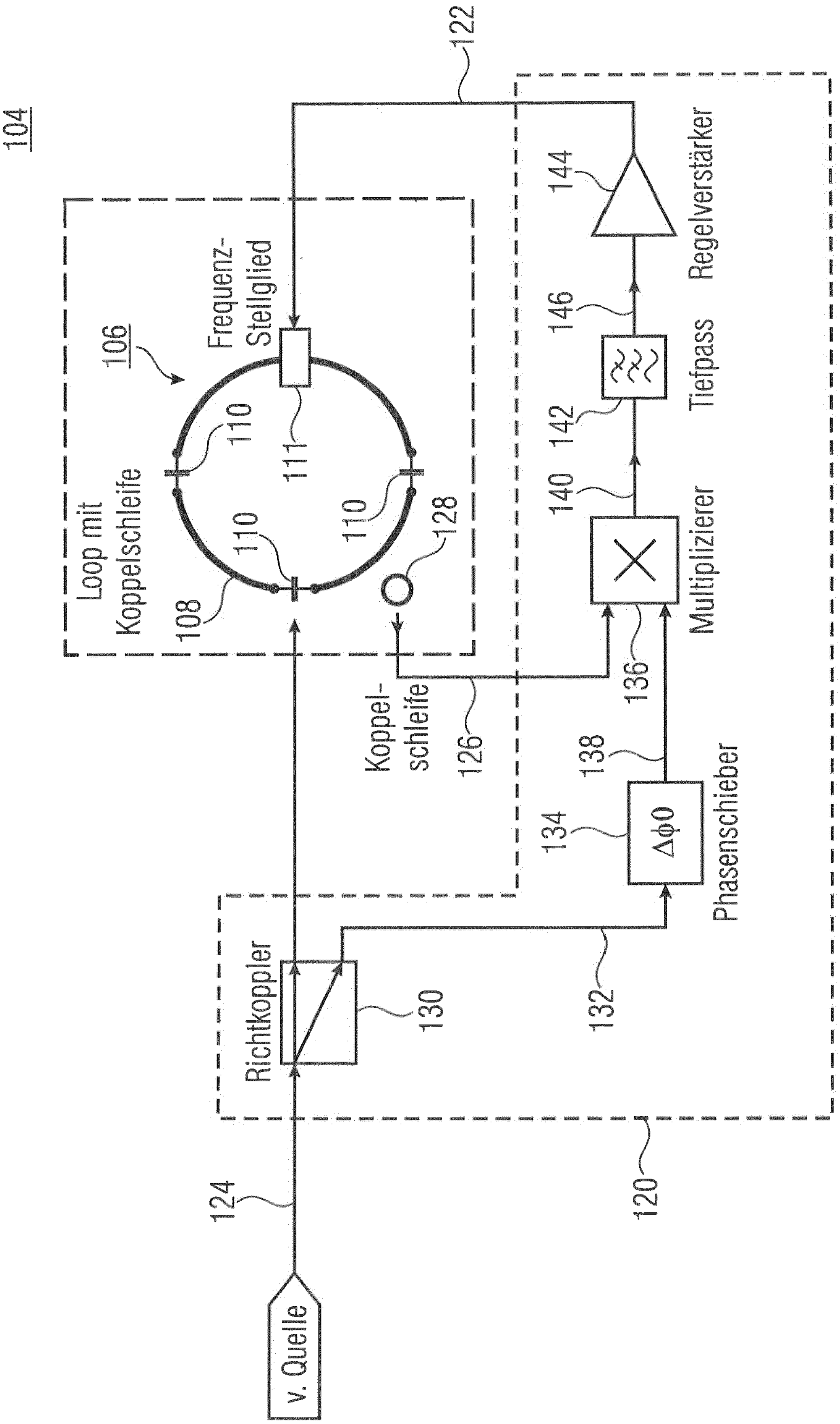
104
106
Loop mit Koppelschleife
Frequenz-Stellglied
108
110
110
110
110
111
128
122
144
Regelverstärker
146
Tiefpass
142
140
Multiplizierer
136
Koppel-schleife
126
138
Phasenschieber
134
Δϕ0
Richtkoppler
130
132
124
120
v. Quelle

Fig. 9

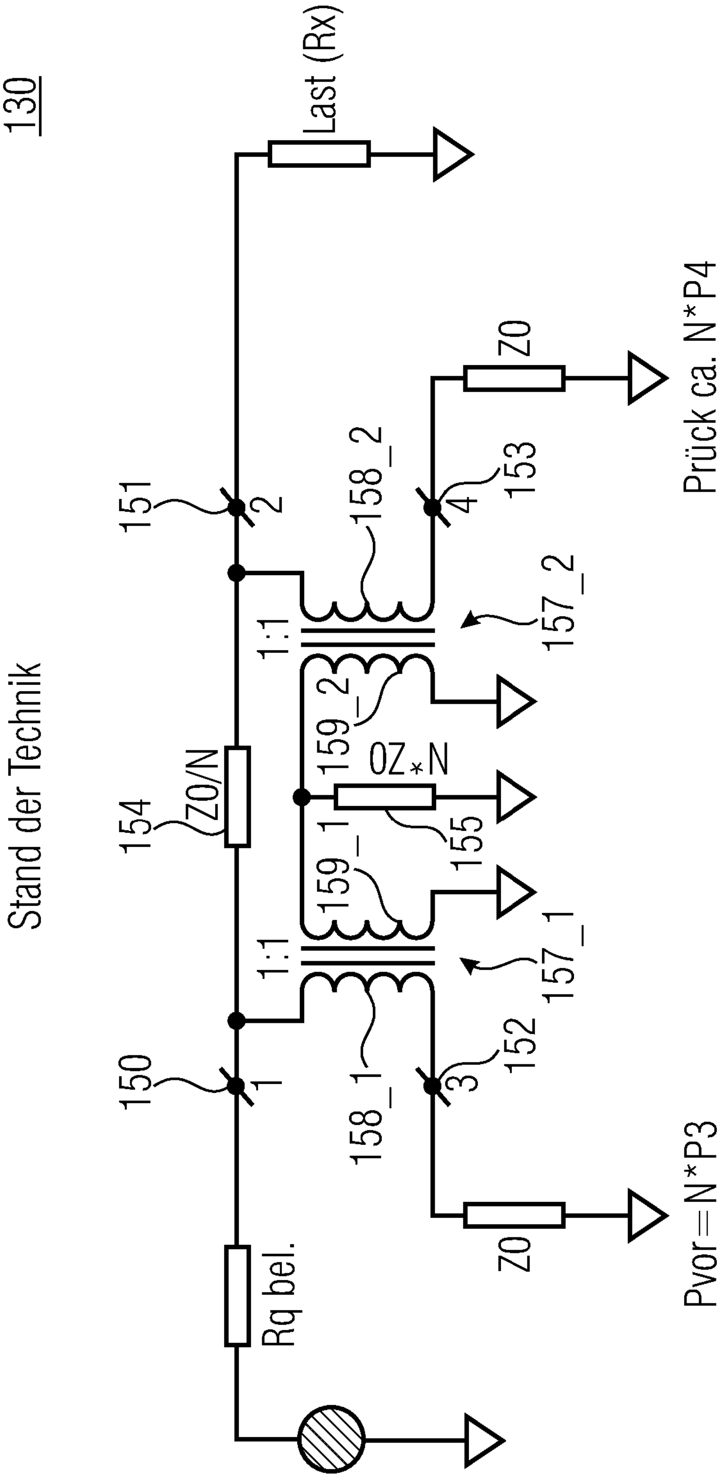
130
Stand der Technik
Last (Rx)
151
2
154
Z0/N
150
1
1:1
1:1
158_1
158_2
159_1
159_2
N∗Z0
155
157_1
157_2
152
3
153
4
Z0
Z0
Rq bel.
Pvor=N*P3
Prück ca. N*P4

Fig. 10a

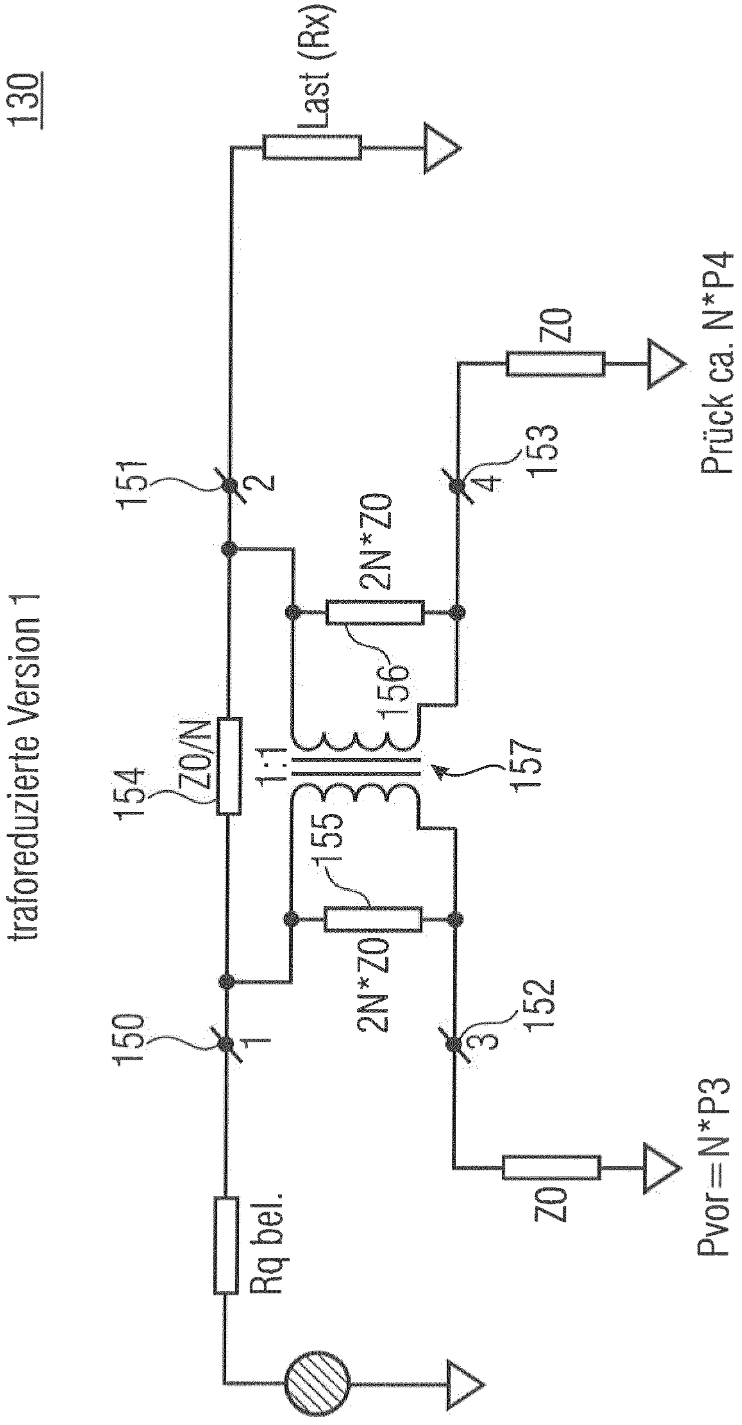
130
traforeduzierte Version 1
Last (Rx)
151
2
154
Z0/N
1:1
150
1
155
156
2N*Z0
2N*Z0
157
152
3
153
4
Z0
Z0
Rq bel.
Pvor=N*P3
Prück ca. N*P4

Fig. 10b

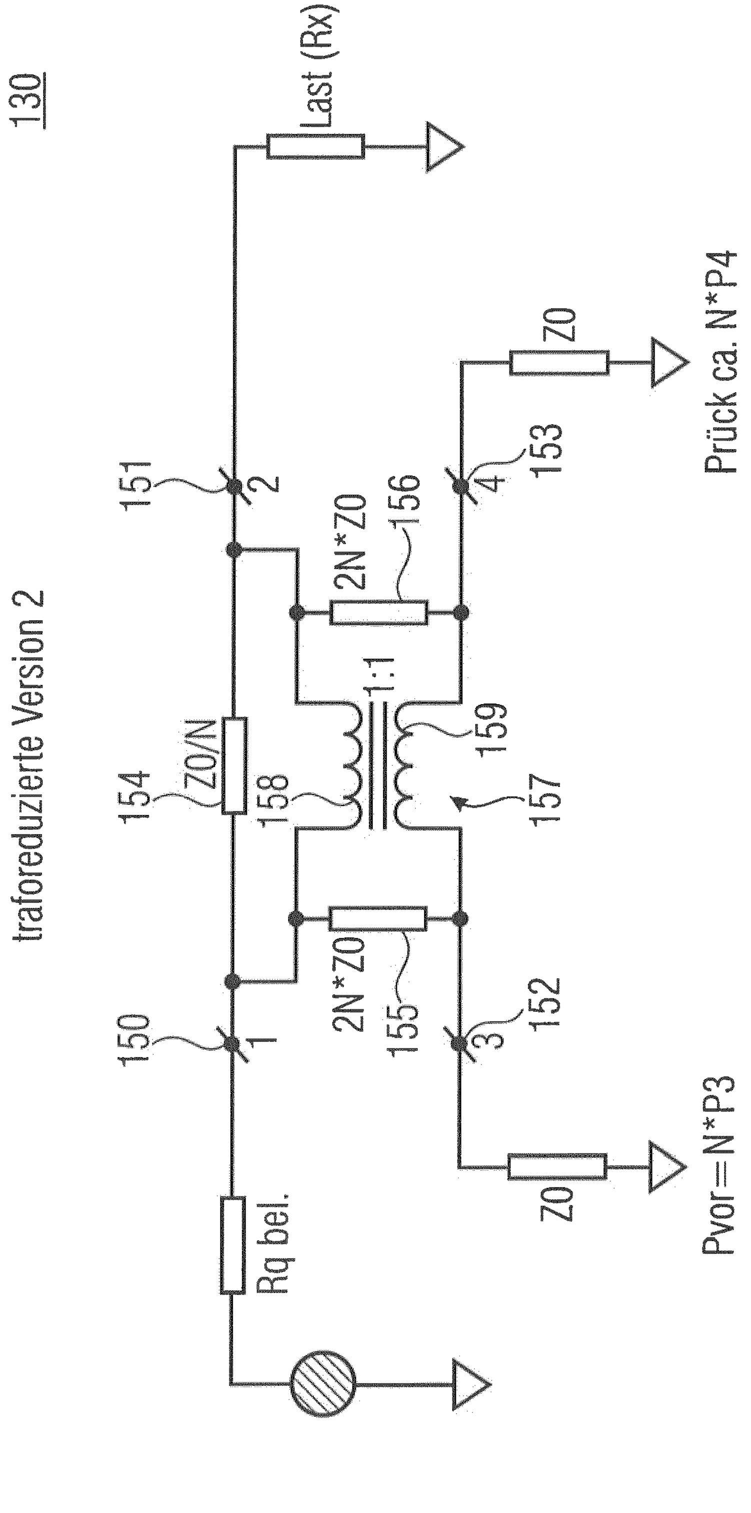
130
traforeduzierte Version 2
Last (Rx)
Rq bel.
150
1
151
2
154
Z0/N
158
1:1
159
157
2N*Z0
155
156
3
152
4
153
Z0
Z0
Pvor=N*P3
Prück ca. N*P4

Fig. 10c

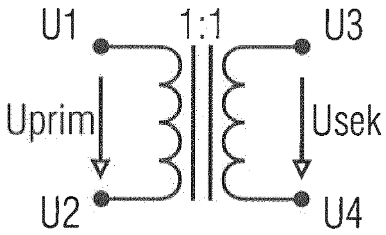


Fig. 11a

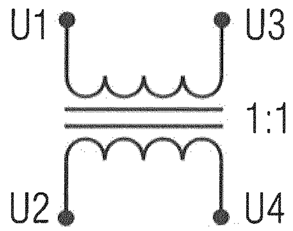


Fig. 11b

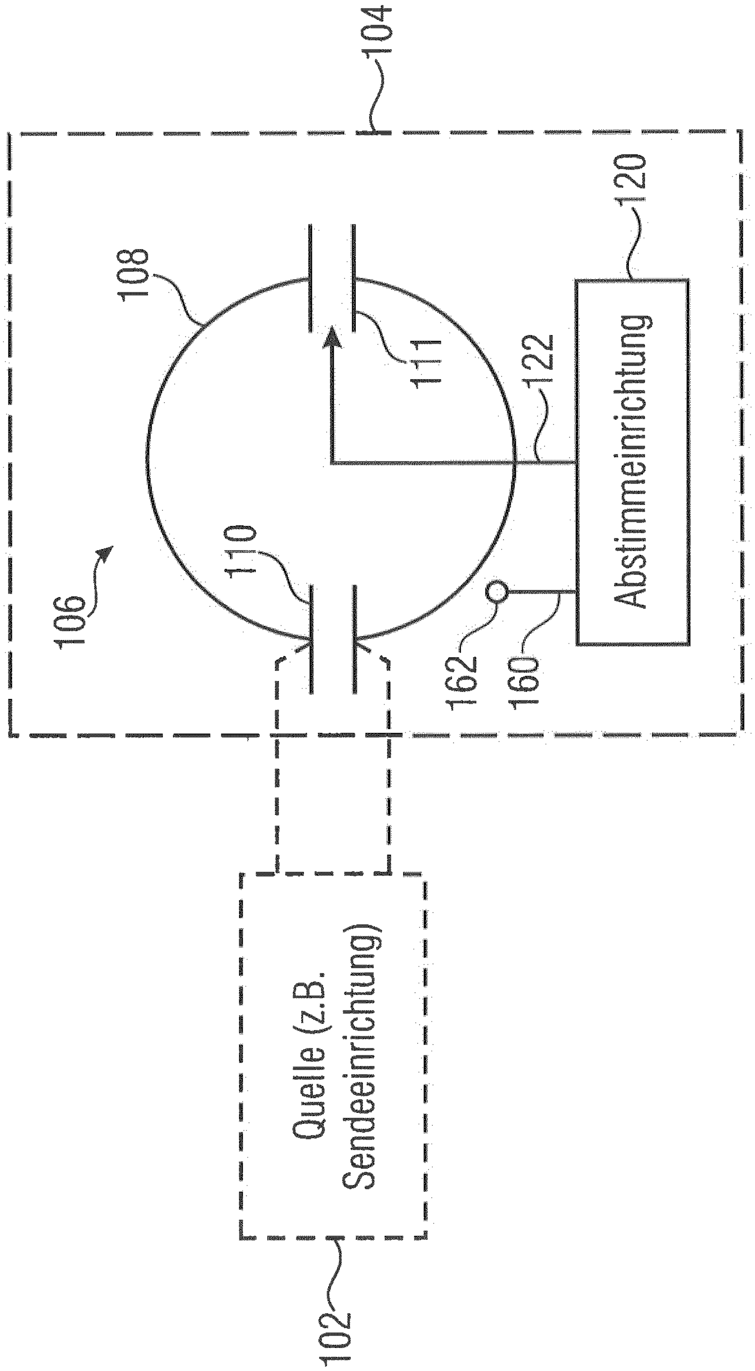
104
108
120
111
122
Abstimmeinrichtung
110
106
162
160
Quelle (z.B. Sendeeinrichtung)
102

Fig. 12

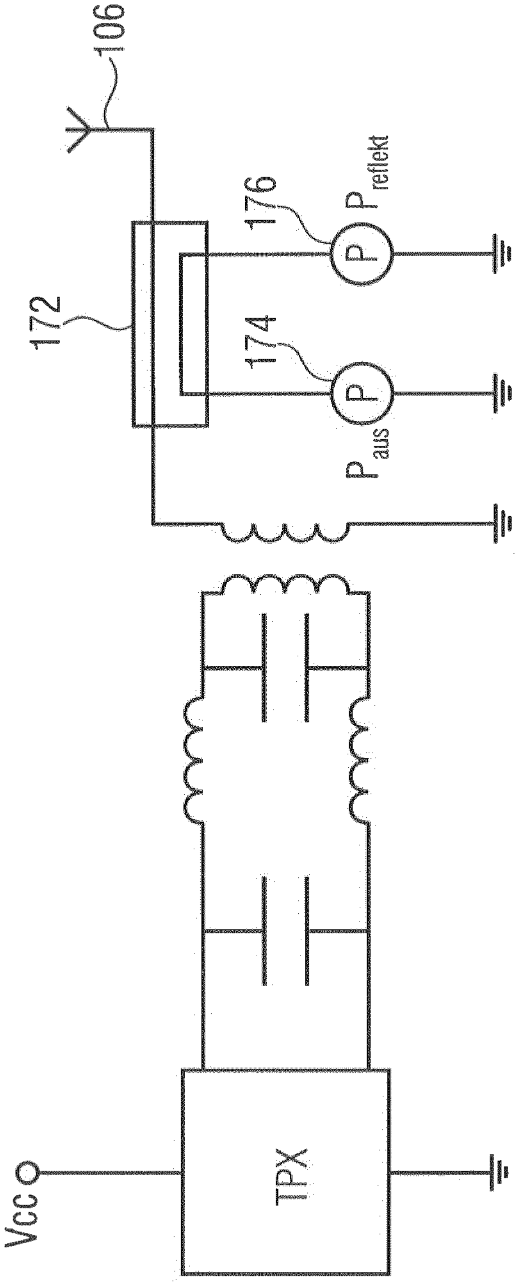


Fig. 13

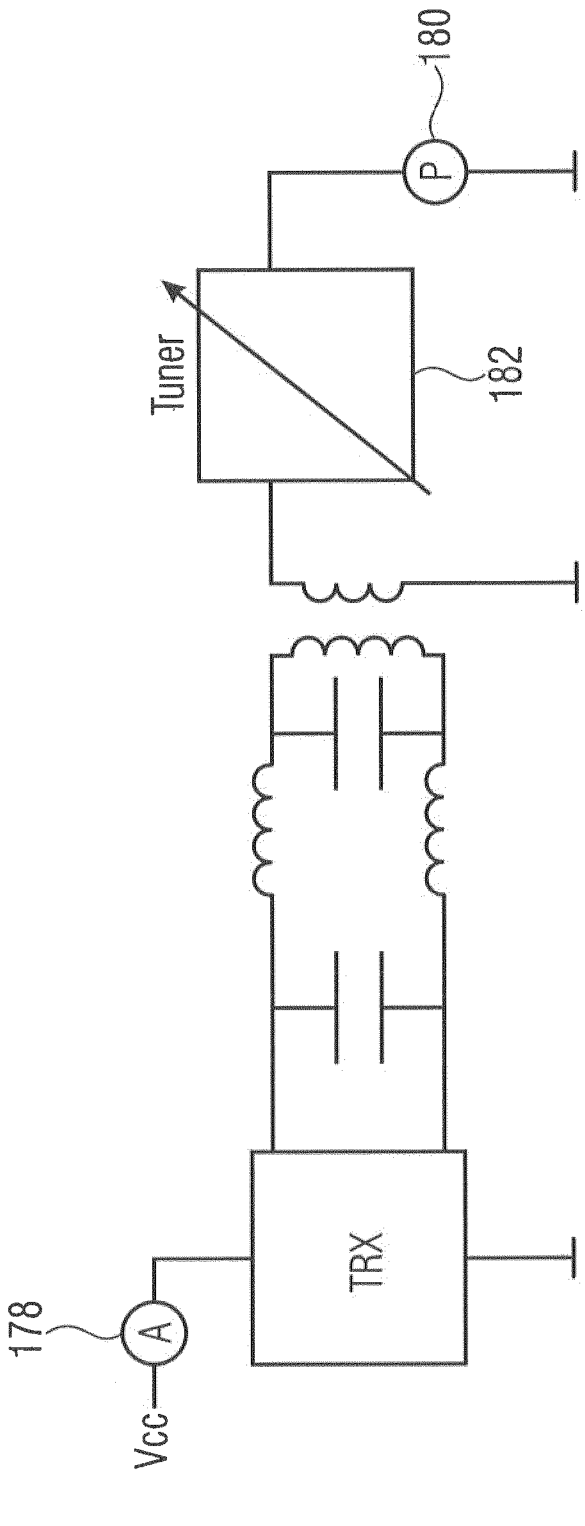


Fig. 14

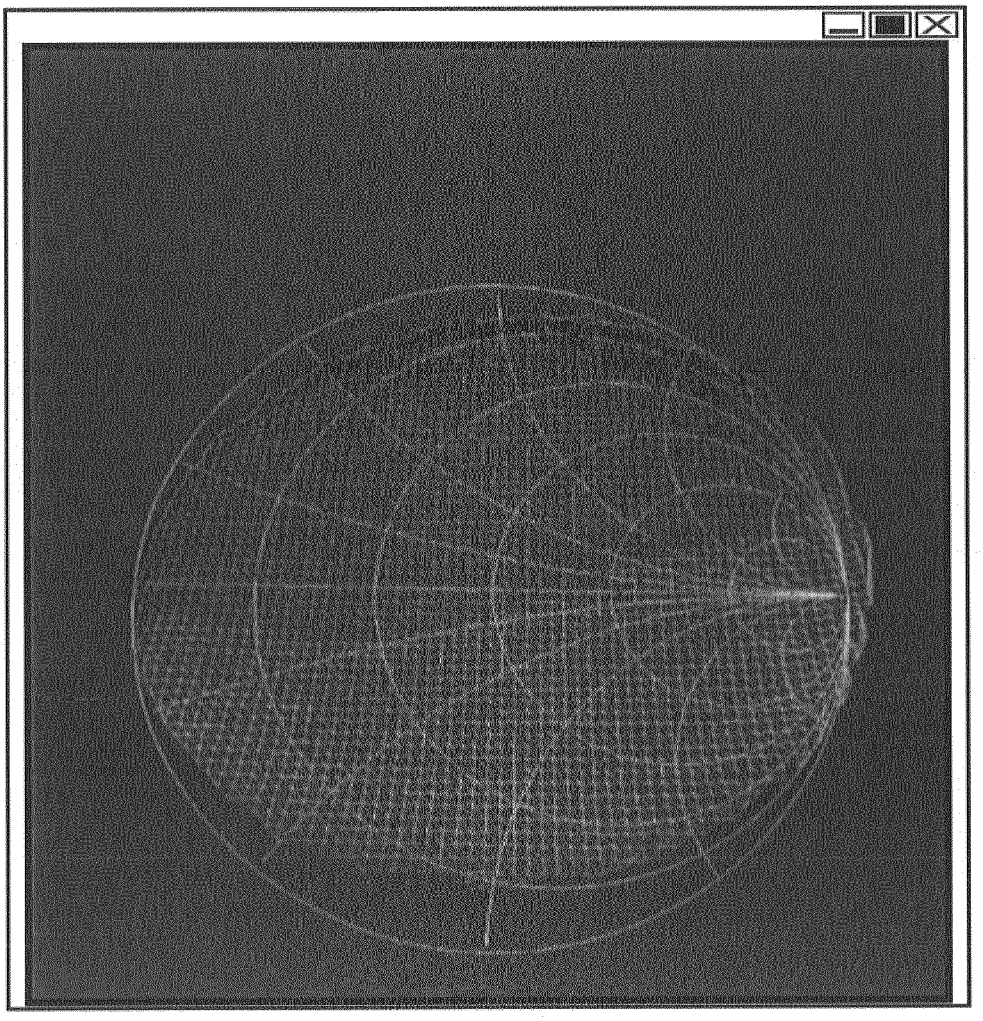

Fig. 15

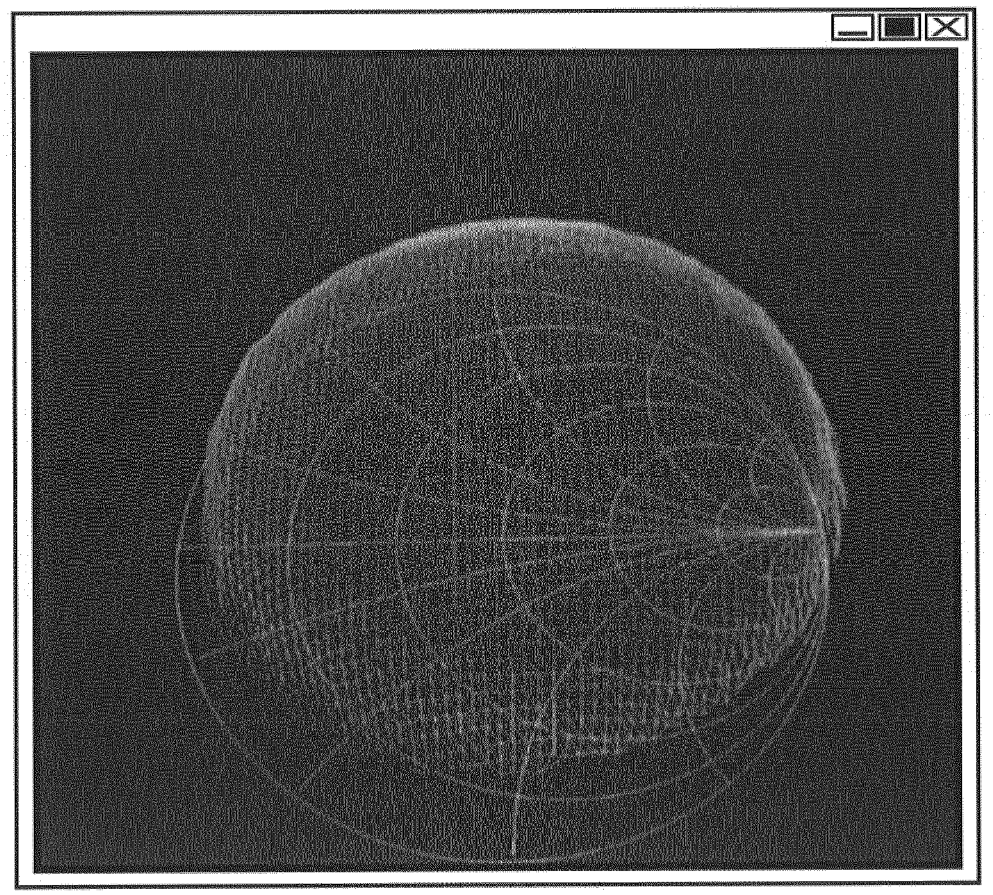

Fig. 16

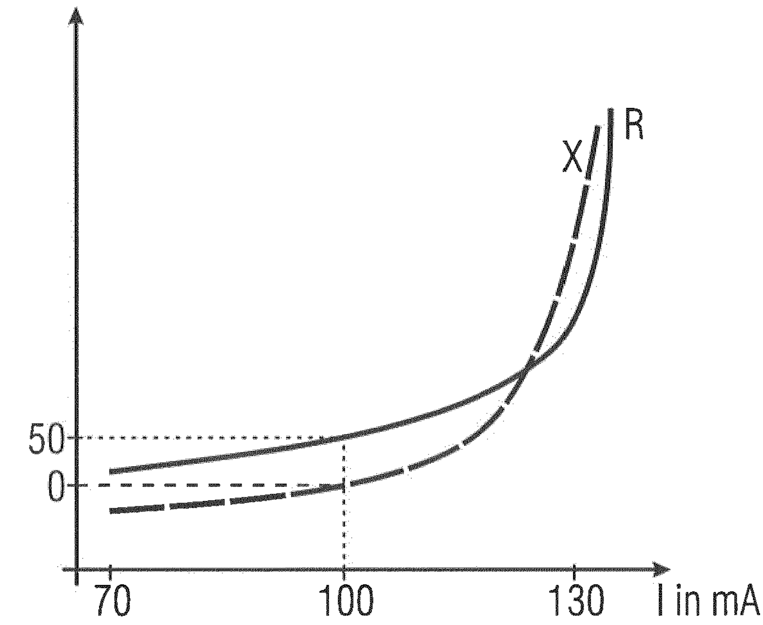


Fig. 17a

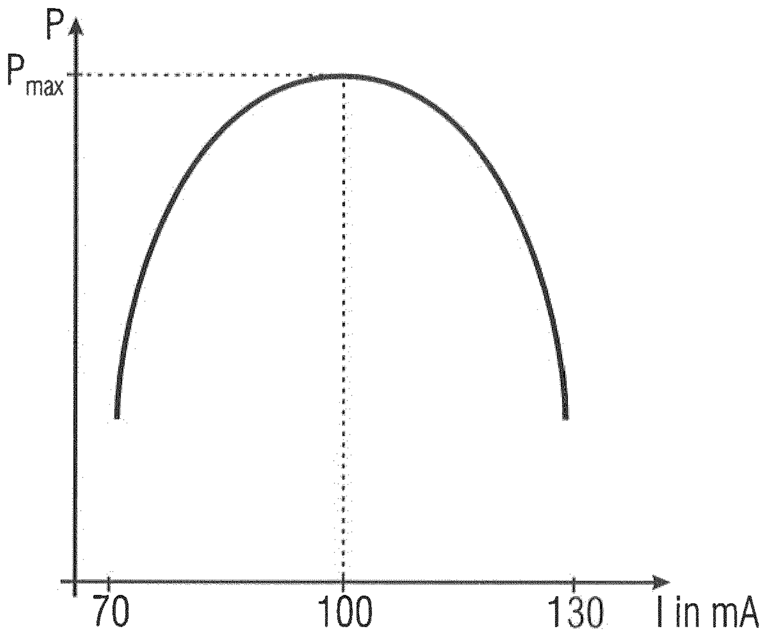


Fig. 17b

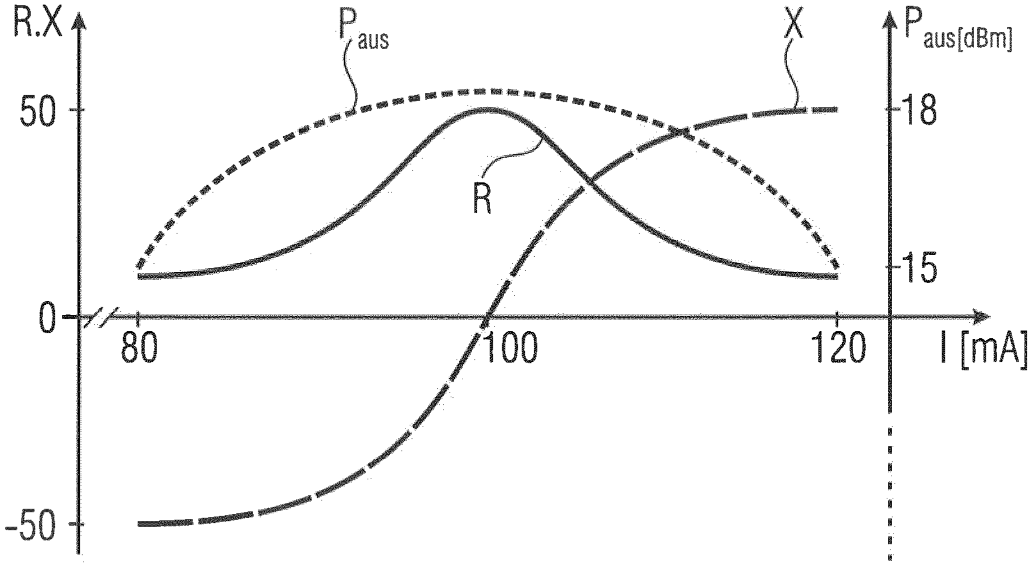


Fig. 18

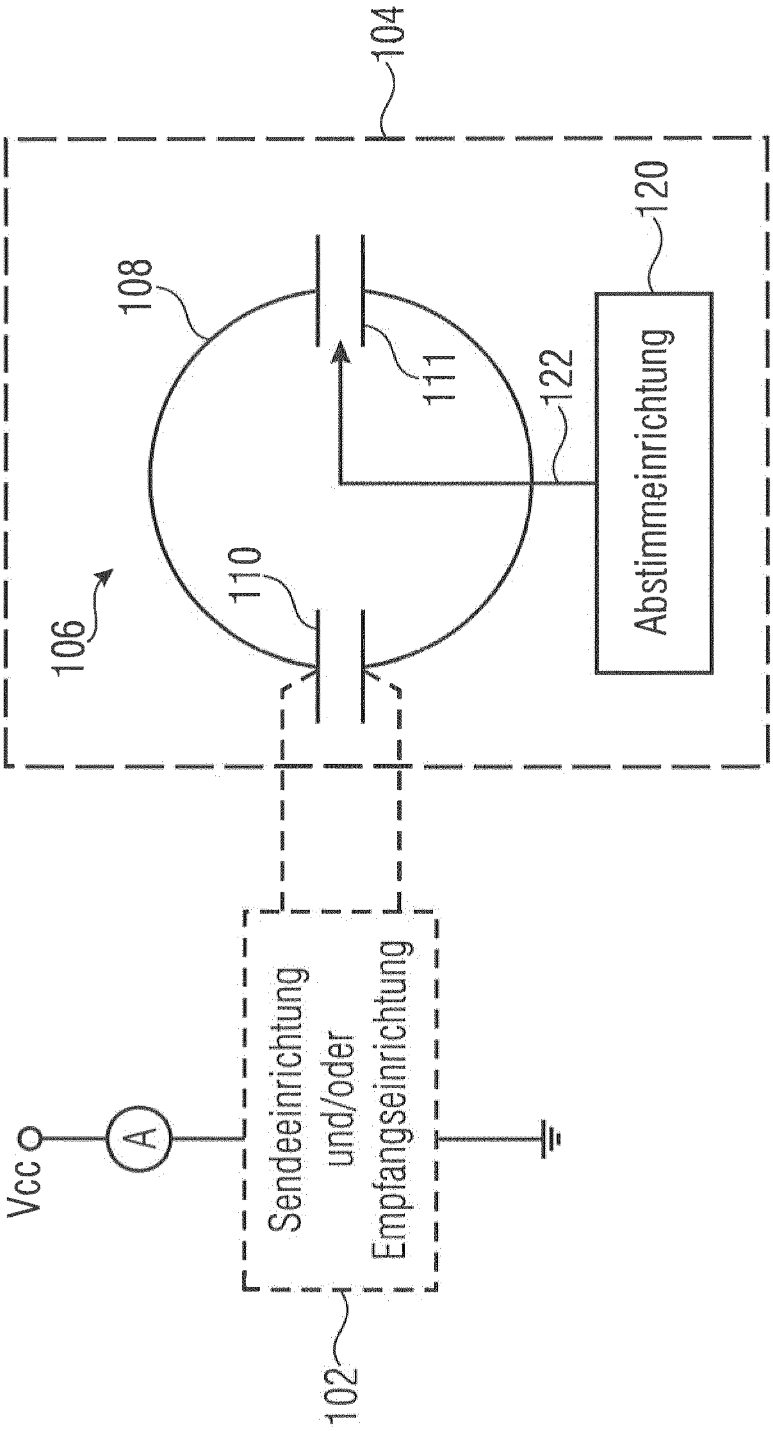
104
108
111
122
120
106
110
Abstimmeinrichtung
Vcc
A
Sendeeinrichtung
und/oder
Empfangseinrichtung
102

Fig. 19

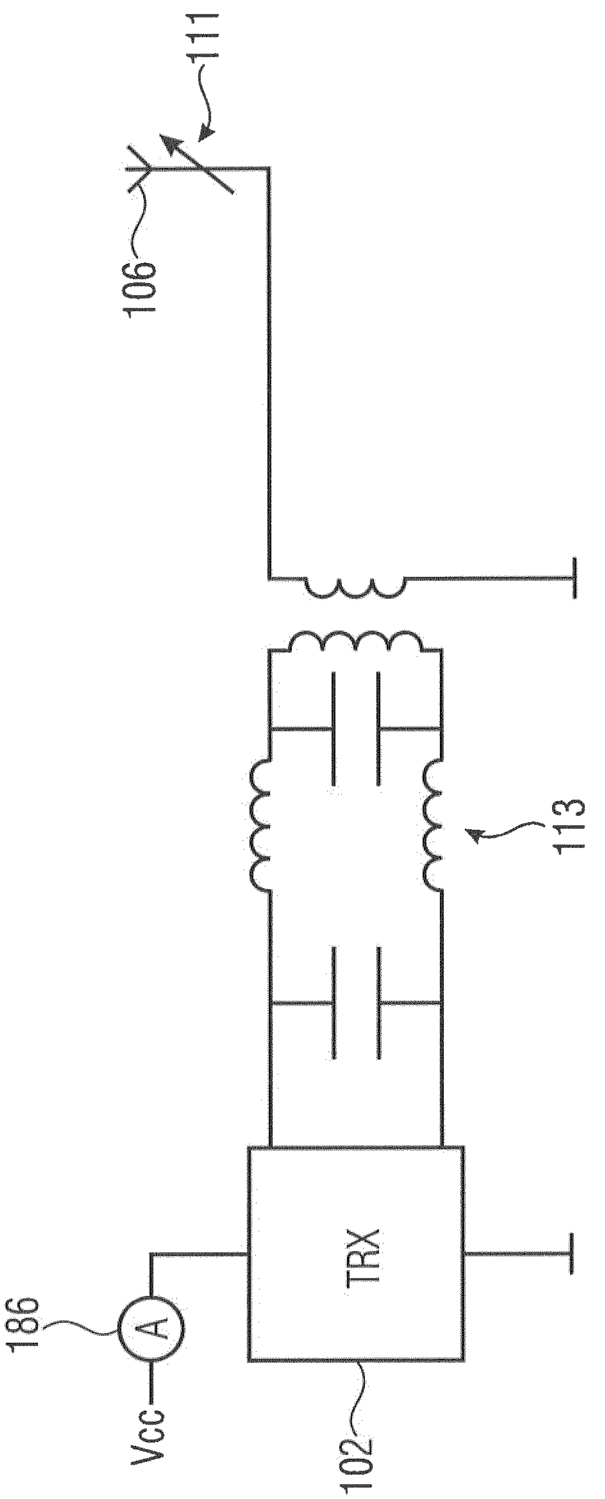


Fig. 20

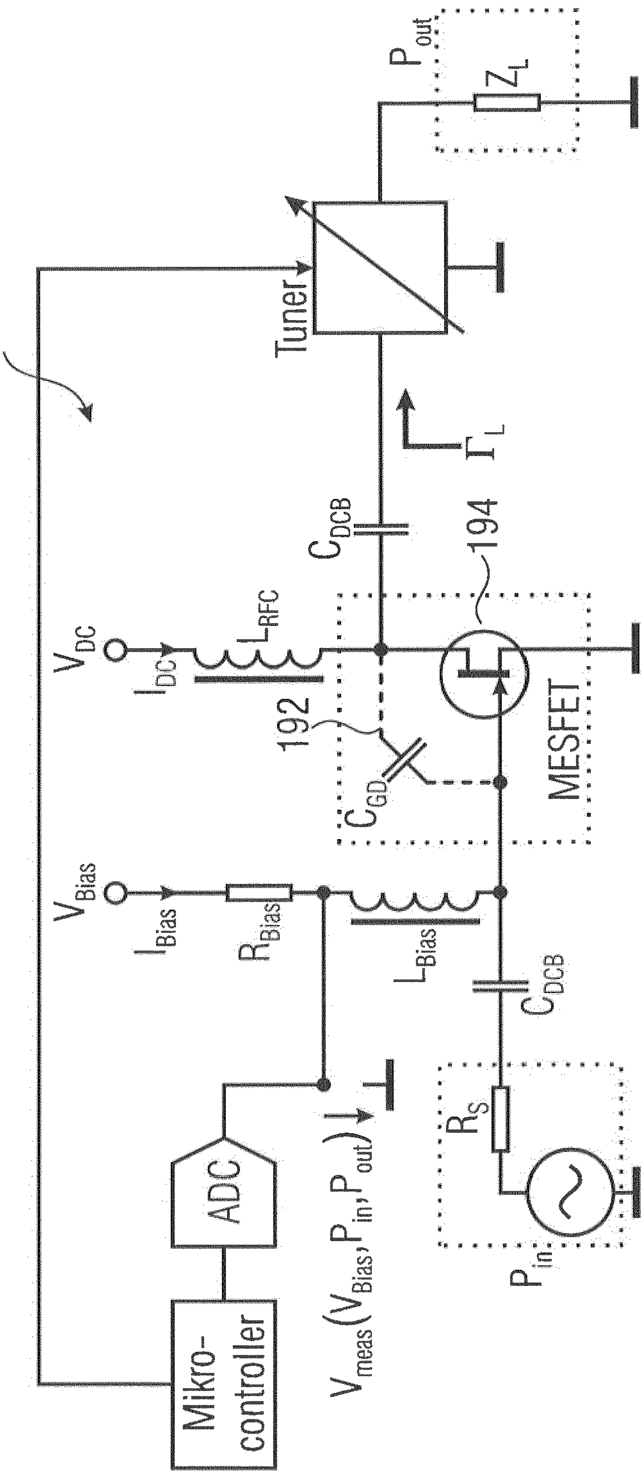
190
Tuner
$P_{out}$
$Z_L$
$\Gamma_L$
$C_{DCB}$
194
$V_{DC}$
$I_{DC}$
$L_{RFC}$
192
$C_{GD}$
MESFET
$V_{Bias}$
$I_{Bias}$
$R_{Bias}$
$L_{Bias}$
$C_{DCB}$
$R_S$
$P_{in}$
ADC
Mikro-
controller
$V_{meas}(V_{Bias}, P_{in}, P_{out})$

Fig. 21

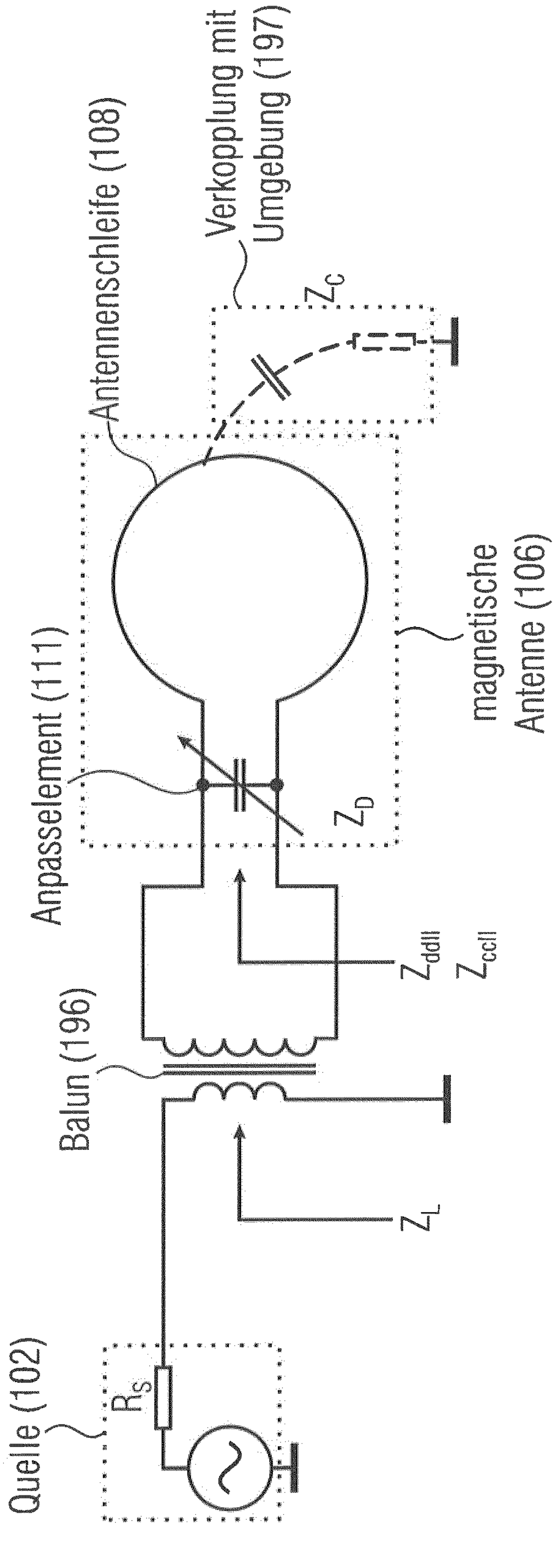
Quelle (102)
$R_S$
Balun (196)
$Z_L$
Anpasselement (111)
$Z_{ddll}$
$Z_{ccll}$
$Z_D$
Antennenschleife (108)
magnetische Antenne (106)
Verkopplung mit Umgebung (197)
$Z_C$

Fig. 22

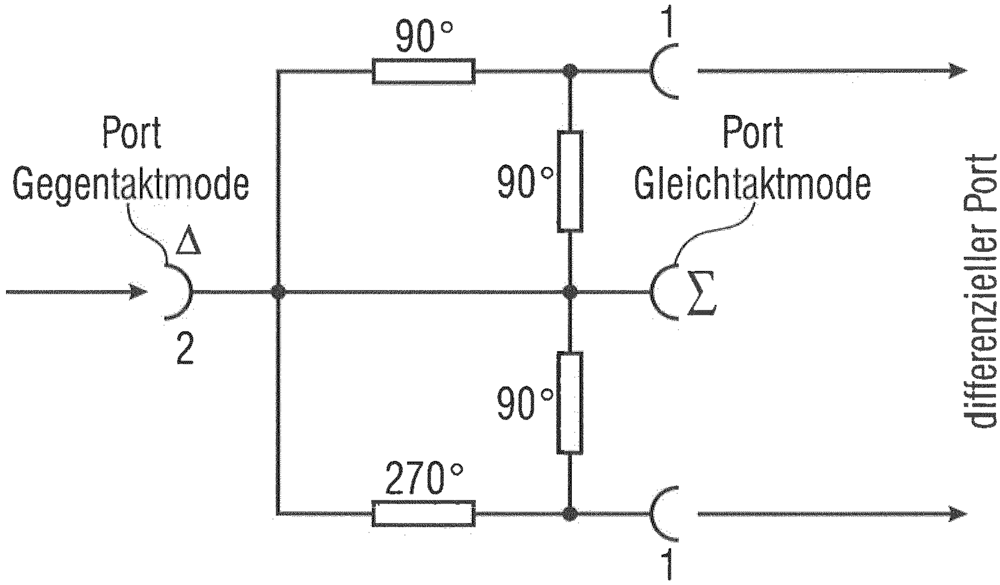
90°
1
Port
Gegentaktmode
Δ
2
90°
Port
Gleichtaktmode
Σ
90°
270°
1
differenzieller Port

Fig. 23

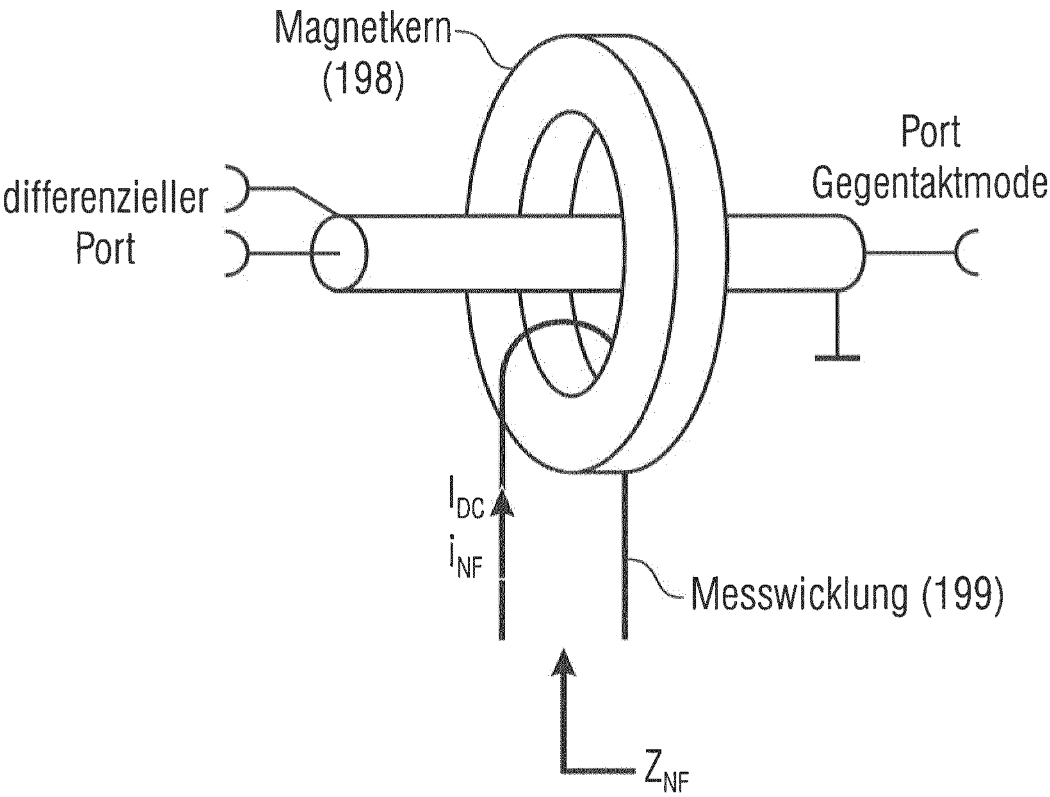
Magnetkern (198)
Port Gegentaktmode
differenzieller Port
$I_{DC}$
$i_{NF}$
Messwicklung (199)
$Z_{NF}$

Fig. 24

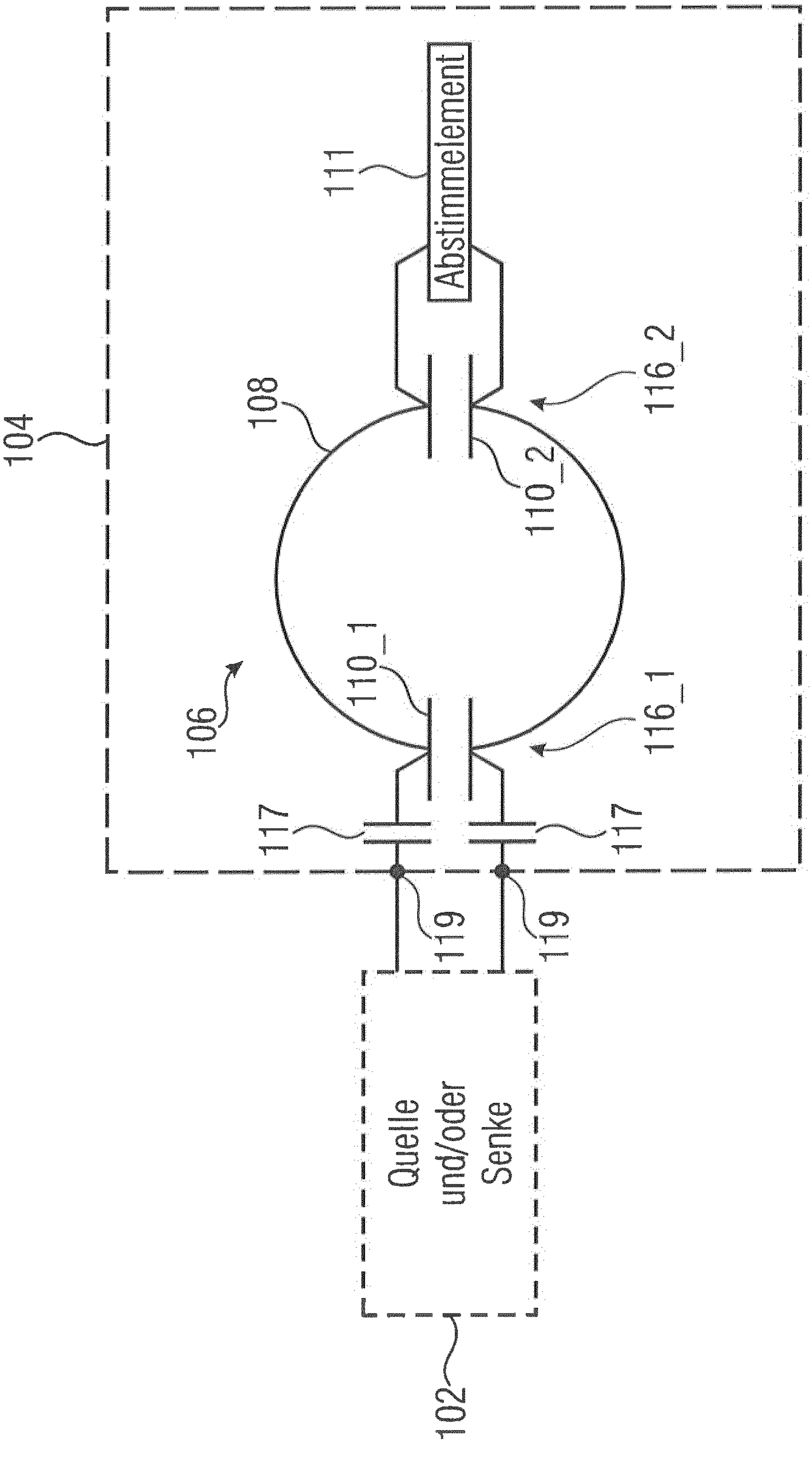
104
111
Abstimmelement
108
116_2
110_2
106
110_1
116_1
117
117
119
119
Quelle
und/oder
Senke
102

Fig. 25a

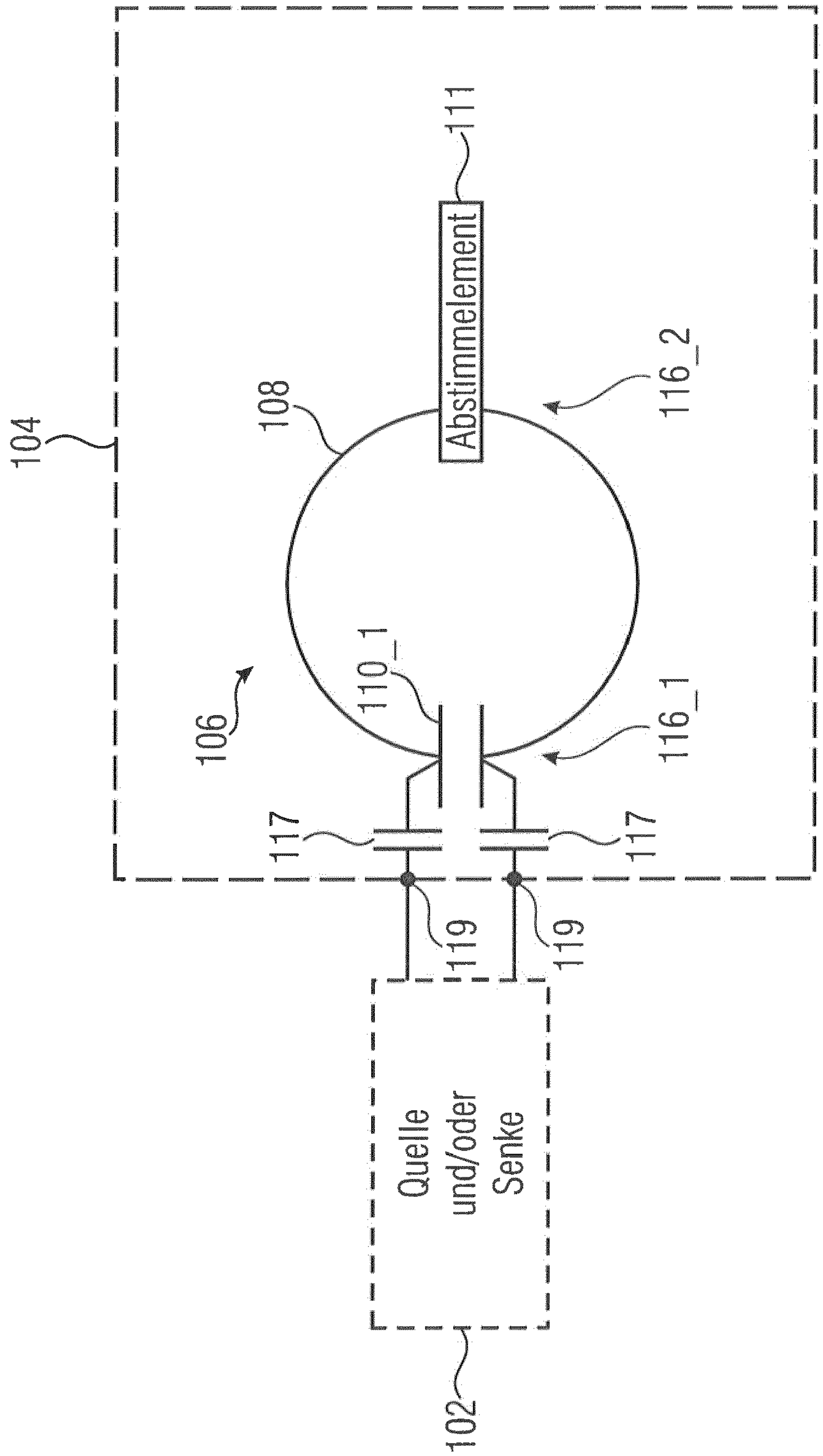
104
108
111
Abstimmelement
116_2
106
110_1
116_1
117
117
119
119
Quelle
und/oder
Senke
102

Fig. 25b

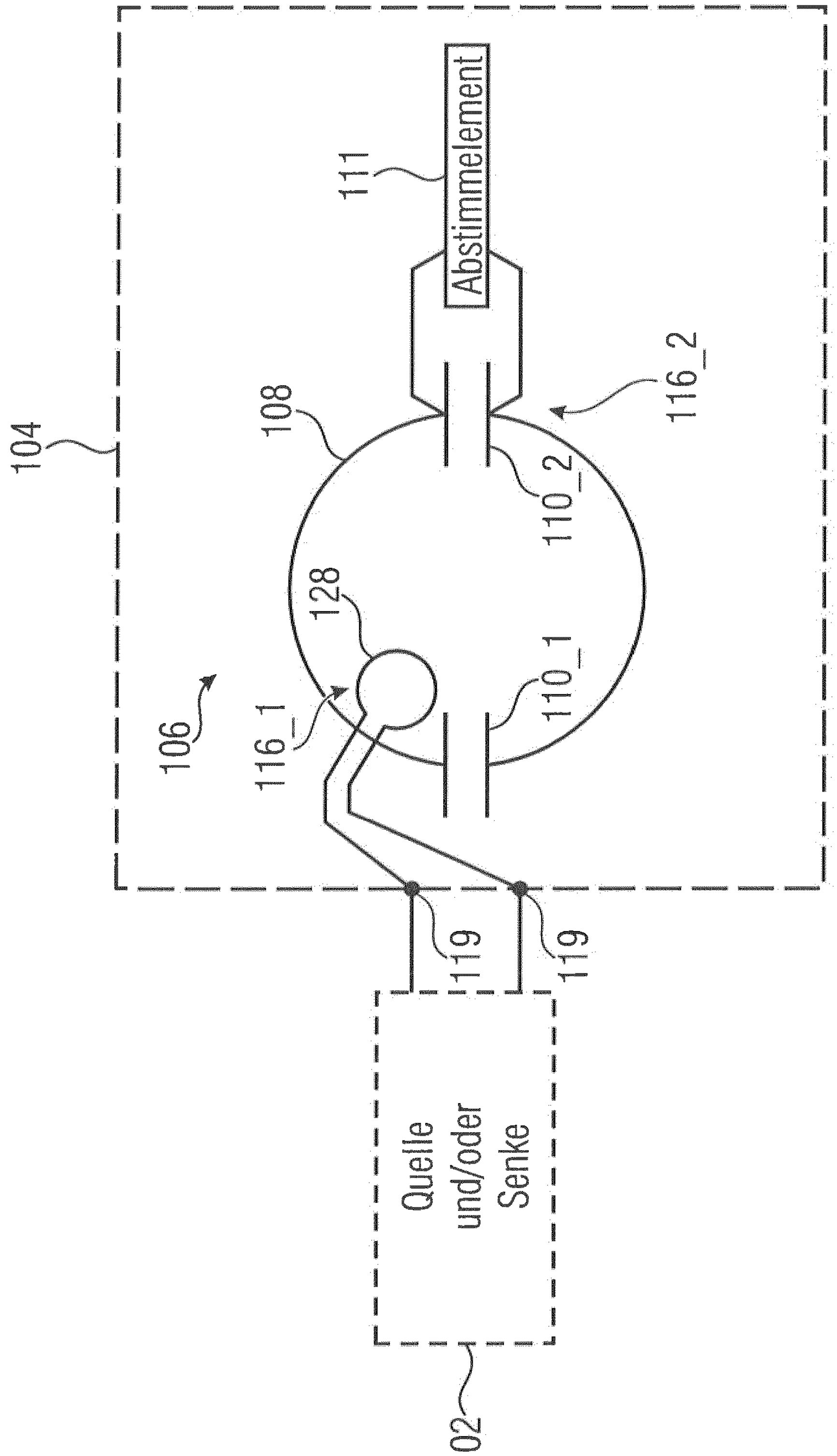
104
108
111
Abstimmelement
116_2
110_2
128
106
116_1
110_1
119
119
Quelle
und/oder
Senke
102

Fig. 25c

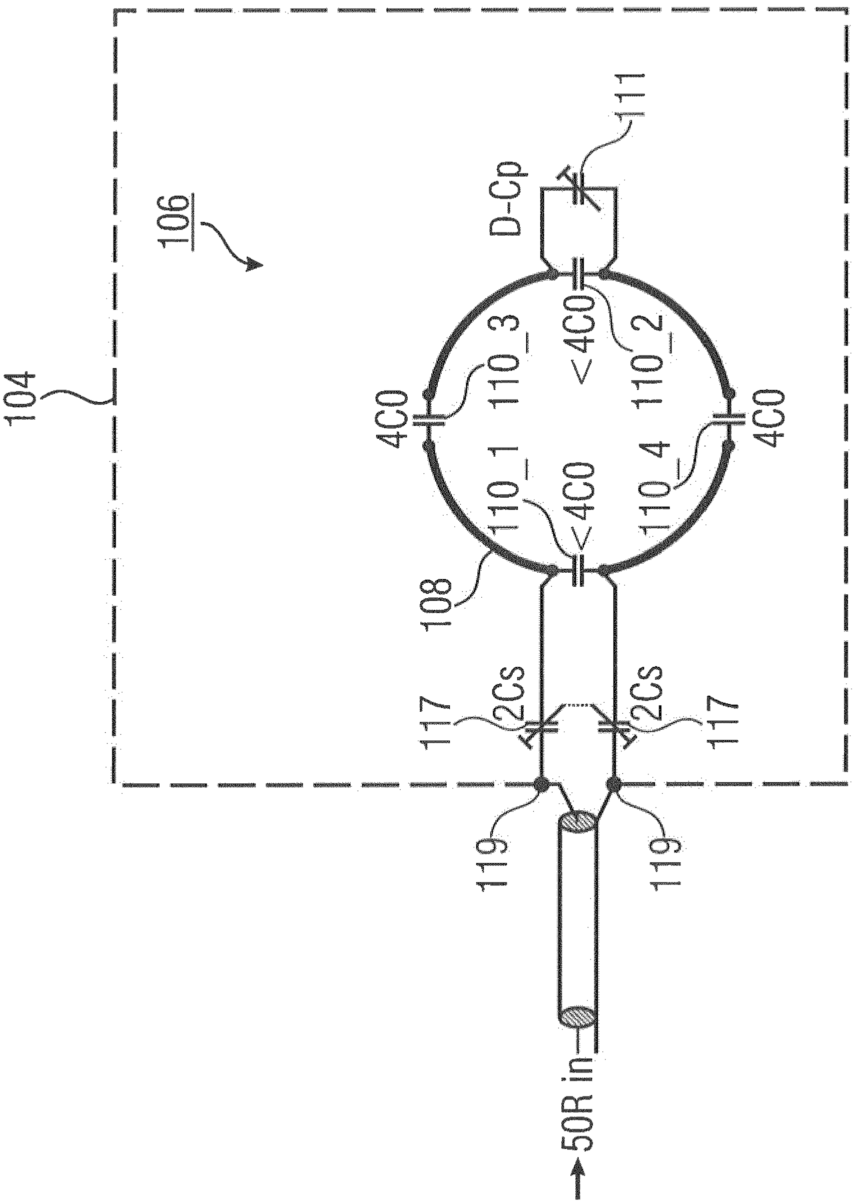
104
106
111
D-Cp
4C0
110_3
<4C0
110_2
110_1
110_4
108
117
2Cs
119
50R in

Fig. 26

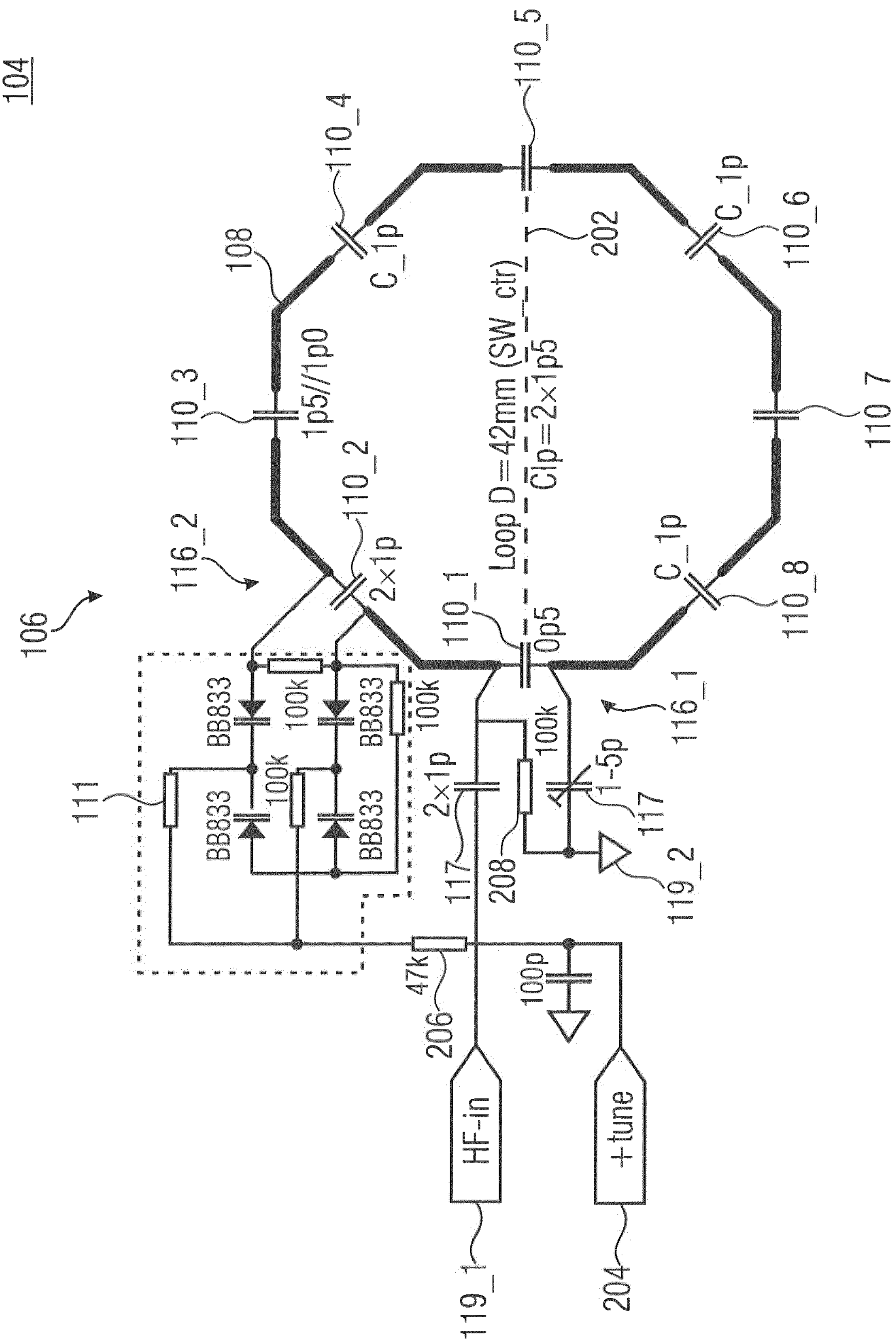
104
106
108
110_1
110_2
110_3
110_4
110_5
110_6
110_7
110_8
111
116_1
116_2
117
117
119_1
119_2
202
204
206
208
C_1p
C_1p
C_1p
1p5//1p0
2×1p
2×1p
0p5
Loop D=42mm (SW_ctr)
Clp=2×1p5
BB833
BB833
BB833
BB833
100k
100k
100k
100k
1-5p
47k
100p
HF-in
+tune

Fig. 27

111

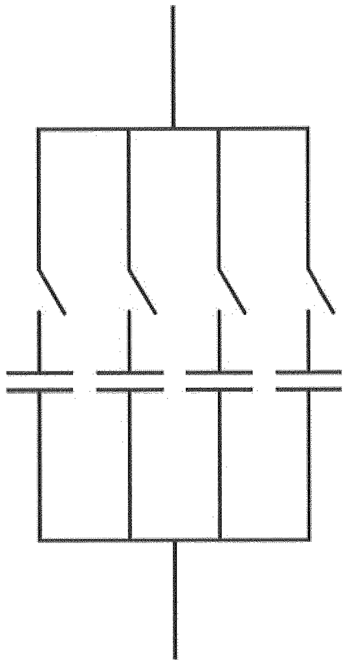

Fig. 28

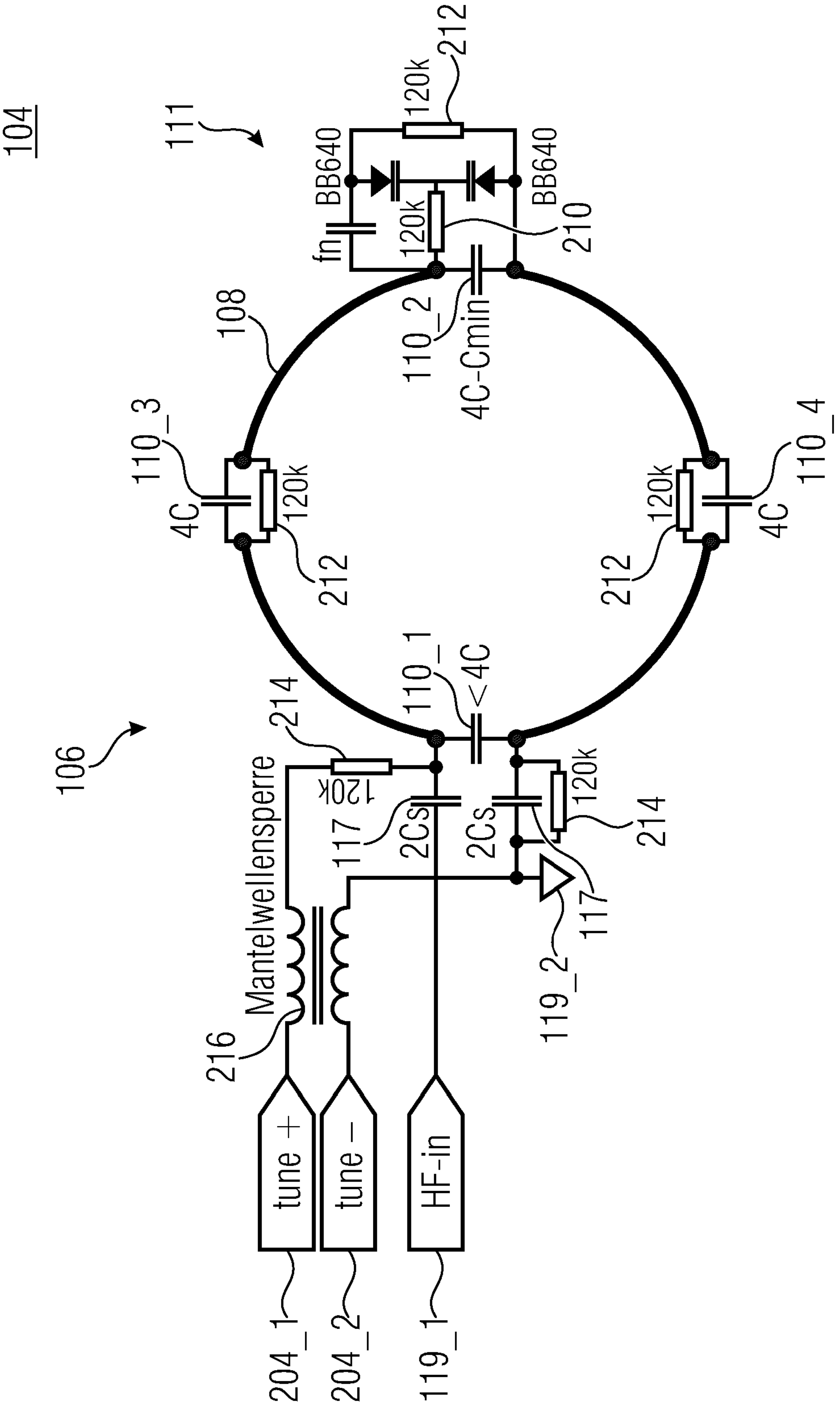
104
111
106
108
212
120k
BB640
BB640
fn
120k
210
110_2
4C-Cmin
110_3
4C
120k
212
110_4
4C
120k
212
110_1
<4C
214
120k
117
2Cs
2Cs
120k
214
117
119_2
Mantelwellensperre
216
tune +
tune −
HF-in
204_1
204_2
119_1

Fig. 29

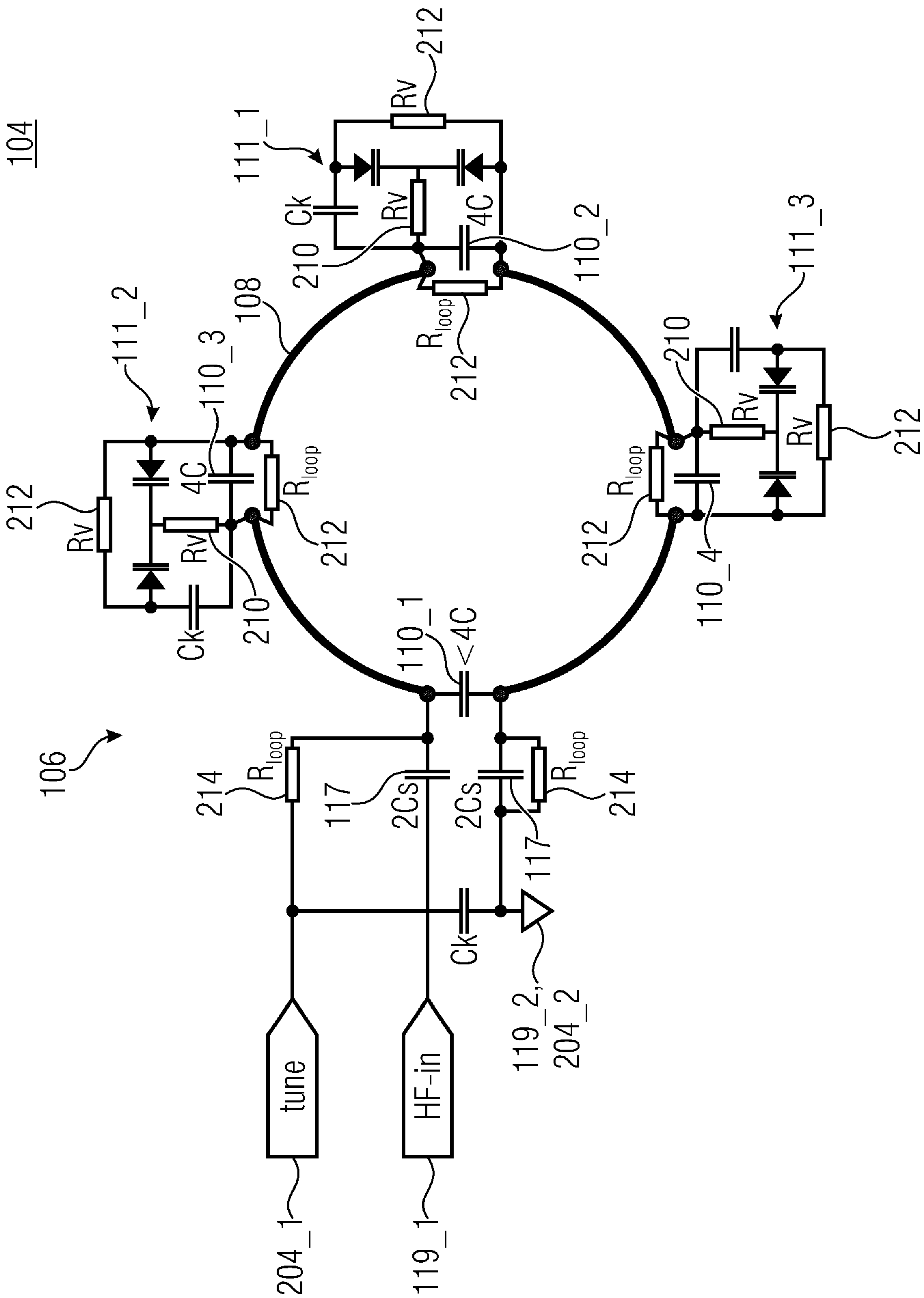
104
106
108
111_1
111_2
111_3
110_1
110_2
110_3
110_4
210
212
214
117
Rv
Ck
4C
<4C
2Cs
Rloop
tune
HF-in
204_1
119_1
119_2,
204_2

Fig. 30

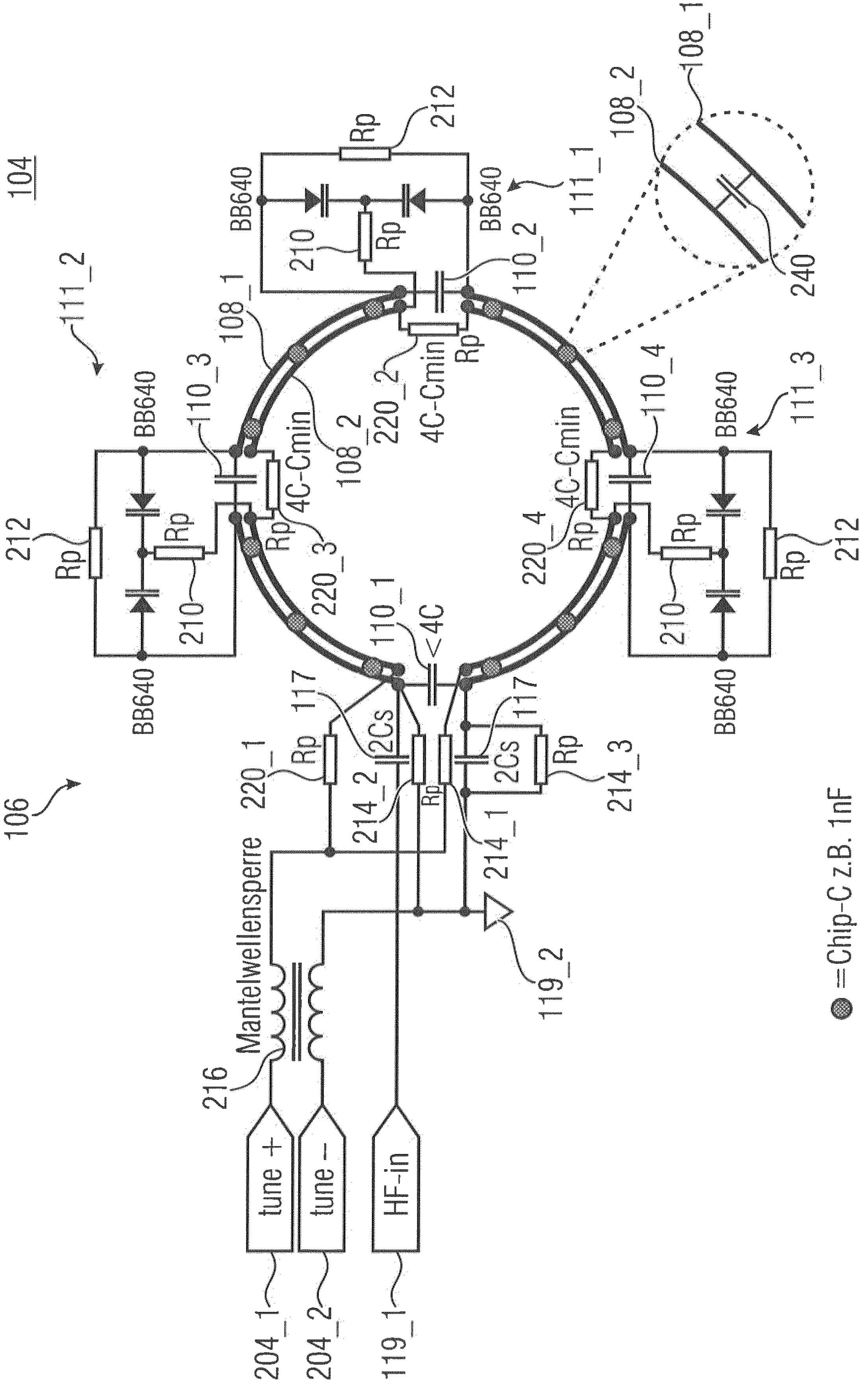
104
106
111_1
111_2
111_3
212
Rp
210
BB640
110_1
110_2
110_3
110_4
<4C
4C-Cmin
108_1
108_2
220_1
220_2
220_3
220_4
240
117
2Cs
214_1
214_2
214_3
216
Mantelwellensperre
119_1
119_2
204_1
204_2
tune +
tune –
HF-in
=Chip-C z.B. 1nF

Fig. 31

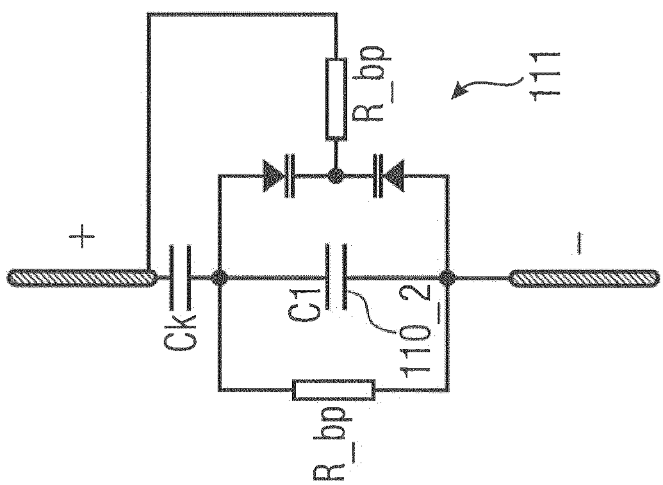


Fig. 32a

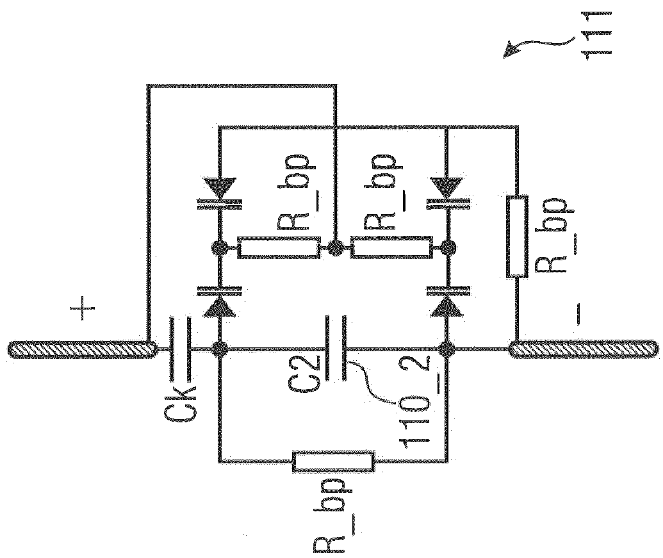


Fig. 32b

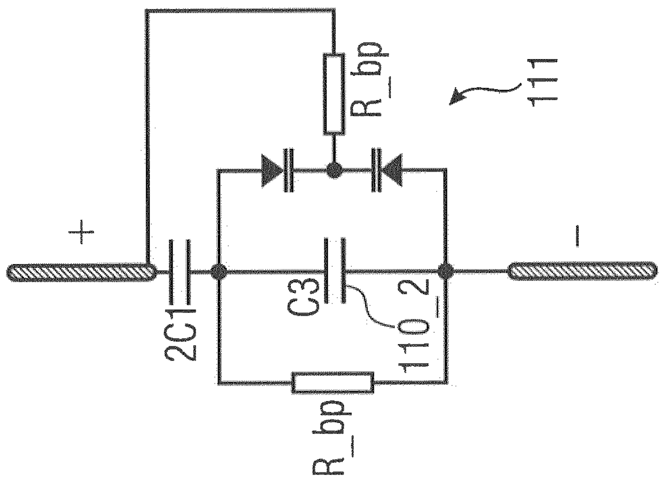


Fig. 32c

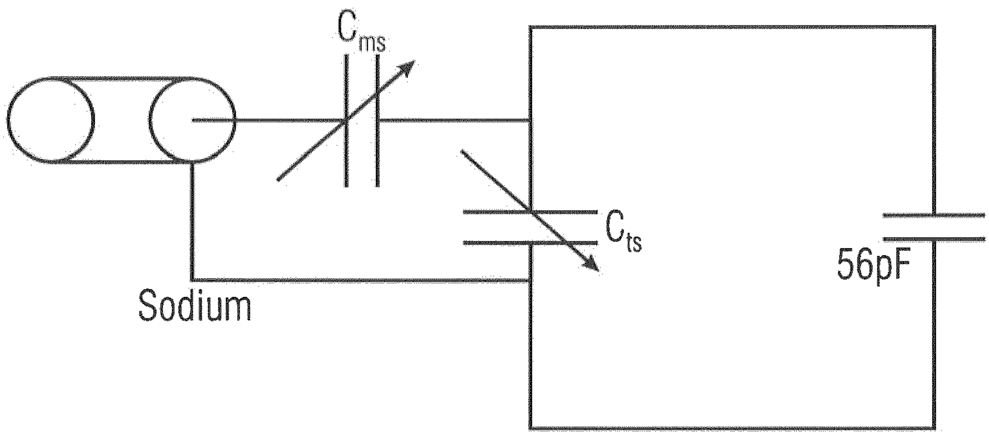


Fig. 33

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 9115878 A1
- DE 4327917 A1
- US 2013016018 A1
- US 5225847 A
- US 7890070 B
- DE 102011082098 B4


### In der Beschreibung aufgeführte Nicht-Patentliteratur


- **J. BOLLENBECK ; R. OPPELT.** Ein neuartiges Tracking-Filter für hochwertige LO-Signale. *UKW-Berichte,* Marz 2013, 157-176, https://de.wikipedia.org/wiki/Schwingkreis
- **J. V. PARPART.** Breitbandige Ferrit-Hochfrequenztransformatoren. Hüthig GmbH, 1997
- B760 Schaltplansammlung. *Fa. Studer-Revox*
- **XINQIANG YAN et al.** *A monople/loop dual-tunded RF coil for ultrahigh field MRI, http://qims.amegroups.com/article/view/4219/5131*
- **HANS WÜRTZ.** *DX-Antennen mit spiegelnden Flächen,* 583
- **HANS NUSSBAUM.** Magnetantennen: Selbstbau-Loops für Sende- und Empfangsbetrieb. Verlag für Technik und Handwerk, 25. Februar 2008